# EUROPEAN PATENT APPLICATION

(11) **EP 4 553 907 A1**
(43) Date of publication of application: **14.05.2025**
(21) Application number: 23834948.4
(22) Date of filing: 07.07.2023
(51) Int. Cl.: H01L 31/18, H01L 31/0224, H01L 31/048, H01L 31/0747, H01L 31/20

(54) **SOLAR CELL PREPARATION METHOD, SOLAR CELL, AND BATTERY ASSEMBLY**

(30) Priority: 07.07.2022 CN 202210796261; 07.07.2022 CN 202210795204; 07.07.2022 CN 202210795205; 07.07.2022 CN 202210795202
(71) Applicant: Longi Green Energy Technology Co., Ltd., Xi'an, Shaanxi 710100 (CN)
(72) Inventor: XUE, Chaowei, Shaanxi 710100 (CN); WEI, Chaofeng, Shaanxi 710100 (CN); LI, Jie, Shaanxi 710100 (CN); SUN, Shiyang, Shaanxi 710100 (CN); FANG, Liang, Shaanxi 710100 (CN); WEI, Junzhe, Shaanxi 710100 (CN); QU, Minghao, Shaanxi 710100 (CN); XU, Xixiang, Shaanxi 710100 (CN)
(74) Representative: Pfenning, Meinig & Partner mbB
(86) International application number: PCT/CN2023/106350
(87) International publication number: WO 2024/008183

(57) **Abstract**

The present invention provides a method for preparing a solar cell, a solar cell, and a solar cell module, and relates to the field of photovoltaic technologies. The method includes: forming a first conductive pattern or a first conductive film layer on a solar cell body; forming a second conductive pattern on an imprint template; aligning the second conductive pattern with a first conductive part, and electrically connecting the second conductive pattern to the first conductive part, where the first conductive part is the first conductive pattern or a region on which an electrode is to be formed in the first conductive film layer; and removing the imprint template; and after the forming a first conductive film layer on a solar cell body and the removing the imprint template, the method further including: removing the first conductive film layer outside the region on which the electrode is to be formed, to form the first conductive pattern. In the present invention, there is little effect on the solar cell body. Four electrical connection manners feature a low bonding temperature and high bonding strength, thereby having little effect on photoelectric conversion efficiency of the solar cell, and having good reliability. **In** this way, costs are reduced, and production efficiency is improved.

## Description

### CROSS-REFERENCE TO RELATED APPLICATIONS

This application claims priority to Chinese Patent Application No. 202210796261.3, filed with the China National Intellectual Property Administration on July 7, 2022 and entitled "METHOD FOR PREPARING SOLAR CELL, SOLAR CELL, AND SOLAR CELL MODULE"; claims priority to Chinese Patent Application No. 202210795204.3, filed with the China National Intellectual Property Administration on July 7, 2022 and entitled "METHOD FOR PREPARING SOLAR CELL, SOLAR CELL, AND SOLAR CELL MODULE"; claims priority to Chinese Patent Application No. 202210795205.8, filed with the China National Intellectual Property Administration on July 7, 2022 and entitled "METHOD FOR PREPARING SOLAR CELL, SOLAR CELL, AND SOLAR CELL MODULE"; and claims priority to Chinese Patent Application No. 202210795202.4, filed with the China National Intellectual Property Administration on July 7, 2022 and entitled "METHOD FOR PREPARING SOLAR CELL, SOLAR CELL, AND SOLAR CELL MODULE", which are incorporated herein by reference in their entireties.

### TECHNICAL FIELD

The present invention relates to the field of photovoltaic technologies, and in particular, to a method for preparing a solar cell, a solar cell, and a solar cell module.

### BACKGROUND

Generally, electrodes of solar cells need to meet three requirements: high carrier collection efficiency, low preparation costs, and good reliability.

In the related art, there are mainly two methods for preparing an electrode of a solar cell: screen printing and laser transfer printing. The screen printing process is mature, but requires the use of precious metal silver in the electrode material, resulting in high costs. The laser transfer printing is a technology of irradiating a local region of a light-transmitting film layer with laser after a silver paste is formed on the light-transmitting film layer and dried, so that an irradiated part of the silver paste is separated from the light-transmitting film layer and falls on a region on which an electrode is to be formed in a solar cell body, to form the electrode. In the laser transfer printing, the light-transmitting film layer cannot be reused, and there are silver paste residues on the light-transmitting film layer, resulting in high costs. In addition, it is difficult to match the light-transmitting film layer with the laser process. For example, during matching of the light-transmitting film layer with the laser process, because the solvent evaporation capability, adhesion between the paste and a carrier plate, and the like vary with the composition of the silver paste, laser parameters need to be adjusted a plurality of times to adapt to the silver paste, to achieve good matching between the silver paste and laser power. This leads to high difficulty and low production efficiency of the laser transfer printing process.

### SUMMARY

The present invention provides a method for preparing a solar cell, a solar cell, and a solar cell module, to resolve a problem that an electrode of the solar cell has high preparation costs.

According to a first aspect of the present invention, a method for preparing a solar cell is provided, including:
forming a first conductive pattern or a first conductive film layer on a solar cell body;
forming a second conductive pattern on an imprint template;
aligning the second conductive pattern with a first conductive part, and electrically connecting the second conductive pattern to the first conductive part, where the first conductive part is the first conductive pattern or a region on which an electrode is to be formed in the first conductive film layer; and the electrical connection includes any one of the following four manners: in a first manner, the second conductive pattern and the first conductive part are bonded together through a bonding part, where a material of the bonding part includes a conductive material and an adhesive; in a second manner, the second conductive pattern and the first conductive part are welded together; in a third manner, a third conductive pattern is formed between the second conductive pattern and the first conductive part through electroplating or chemical plating, and the second conductive pattern and the first conductive part are connected together through the third conductive pattern; or in a fourth manner, the second conductive pattern and the first conductive part are eutectically bonded together; and
removing the imprint template; and
after the forming a first conductive film layer on a solar cell body and the removing the imprint template, the method further including: removing the first conductive film layer outside the region on which the electrode is to be formed, to form the first conductive pattern.

In the present invention, the second conductive pattern is prepared on the imprint template, instead of being prepared on the solar cell body, and a process of preparing the second conductive pattern has little or substantially no effect on the solar cell body. In addition, the foregoing four electrical connection manners feature a low bonding temperature and high bonding strength. The low bonding temperature can reduce a heat effect on the solar cell body, thereby having little effect on photoelectric conversion efficiency of the solar cell. The high bonding strength can make the electrode of the solar cell have good reliability. Compared with screen printing, in the present invention, materials of the second conductive pattern and the first conductive film layer or the first conductive pattern can be welded, bonded, electroplated or chemically plated, or eutectically bonded, and are not limited to a silver paste. Therefore, costs can be appropriately reduced. Compared with laser transfer printing, in the present invention, the second conductive pattern and the first conductive part are electrically connected together, the process is mature, and there is no need to adjust parameters of laser a plurality of times. Therefore, process difficulty is relatively low, so that production efficiency can be appropriately improved.

Optionally, before the electrical connection, the method further includes:
annealing the imprint template on which the second conductive pattern has been formed, to cause the second conductive pattern to recrystallize.

Optionally, the bonding part includes a conductive adhesive film layer or a conductive adhesive pattern; and after the first conductive part and the second conductive pattern are bonded together through the conductive adhesive film layer, and after the removing the imprint template, the method further includes: removing the conductive adhesive film layer outside a region on which the electrode is to be formed, to form the conductive adhesive pattern.

Optionally, before the bonding, the method further includes:
forming the bonding part on the second conductive pattern; and
the aligning the second conductive pattern with a first conductive part includes:
   aligning the first conductive part with the conductive adhesive pattern or the region on which the electrode is to be formed in the conductive adhesive film layer.

Optionally, before the bonding, the method further includes:
forming the bonding part on one of the first conductive pattern, the region on which the electrode is to be formed in the first conductive film layer, or the first conductive film layer; and
the aligning the second conductive pattern with a first conductive part includes:
   aligning the second conductive pattern with the conductive adhesive pattern or the region on which the electrode is to be formed in the conductive adhesive film layer.

Optionally, before the welding, the method further includes:
forming a flux pattern on the second conductive pattern; and/or
forming a flux pattern on the first conductive part.

Optionally, before the welding or the eutectic bonding, the method further includes:
forming a diffusion control pattern on the first conductive part; and/or forming a diffusion control pattern on the second conductive pattern, where
the diffusion control pattern is used for controlling a thickness of an alloy formed in the welding or the eutectic bonding of a material of the first conductive part and a material of the second conductive pattern.

Optionally, before the forming a first conductive pattern or a first conductive film layer on a solar cell body, the method further includes:
forming a bonding pattern or a bonding film layer on the solar cell body, where the bonding pattern or the bonding film layer is used for improving bonding force between the first conductive pattern or the first conductive film layer and the solar cell body;
the forming a first conductive pattern or a first conductive film layer on a solar cell body includes:
   forming the first conductive pattern or the first conductive film layer on the bonding pattern or the bonding film layer; and
   after the forming a bonding film layer on the solar cell body and the removing the imprint template, the method further includes: removing the bonding film layer outside a region on which the electrode is to be formed, to form the bonding pattern.

Optionally, the imprint template includes a first groove; and the forming a second conductive pattern on an imprint template includes:
forming the second conductive pattern in the first groove of the imprint template, where
the second conductive pattern is flush with a surface of a side of the imprint template provided with the first groove, or protrudes from the surface of the side of the imprint template provided with the first groove.

Optionally, the imprint template includes a substrate, the first groove is arranged on the substrate, and the imprint template further includes a first boss arranged on the substrate and located at an edge of the first groove; and the forming the second conductive pattern in the first groove of the imprint template includes:
forming the second conductive pattern in the first groove and in a region defined by the first boss, where
the second conductive pattern is flush with a surface of the first boss away from the substrate, or protrudes from the surface of the first boss away from the substrate.

Optionally, in a direction from a notch of the first groove to a groove bottom of the first groove, an area of a cross section of the first groove gradually decreases, where the cross section is perpendicular to a lamination direction of the first conductive part and the second conductive pattern.

Optionally, the imprint template includes a substrate and a second boss arranged on the substrate; and
the forming a second conductive pattern on an imprint template includes:
forming a second conductive film layer on a side of the imprint template on which the second boss is formed, where the second conductive pattern is a part of the second conductive film layer located on the second boss.

Optionally, a surface of the second boss away from the substrate is a plane; or
a side of the second boss away from the substrate includes a second groove, where the second conductive pattern is flush with a notch of the second groove, or protrudes from the second groove.

Optionally, the bonding part includes a conductive adhesive pattern; the imprint template includes a third groove; the forming a second conductive pattern on an imprint template includes:
forming the second conductive pattern in the third groove of the imprint template, and forming the conductive adhesive pattern on the second conductive pattern, where the conductive adhesive pattern is flush with a surface of a side of the imprint template provided with the third groove, or protrudes from the surface of the side of the imprint template provided with the third groove; and
the aligning the second conductive pattern with a first conductive part, and electrically connecting the second conductive pattern to the first conductive part includes:
   aligning the conductive adhesive pattern with the first conductive part, where the second conductive pattern and the first conductive part are bonded together through the conductive adhesive pattern.

Optionally, the forming a second conductive pattern on an imprint template includes:
forming a seed pattern on the imprint template; and
forming a plating pattern on the seed pattern through electroplating or chemical plating, where the plating pattern and the seed pattern together form the second conductive pattern.

Optionally, the imprint template includes a substrate, and the forming a second conductive pattern on an imprint template includes:
laying a metal foil on the substrate, and patterning the metal foil, to form the second conductive pattern.

Optionally, before the forming a second conductive pattern on an imprint template, the method further includes:
providing a plurality of metal foil patterns;
the imprint template includes a plurality of adsorption regions; and the forming a second conductive pattern on an imprint template includes: at least aligning one of the adsorption regions with one of the metal foil patterns, and adsorbing the metal foil pattern on the adsorption region, to form the second conductive pattern.

According to a second aspect of the present invention, a solar cell is provided, including:
a solar cell body; and
a first conductive pattern and a second conductive pattern sequentially laminated on the solar cell body, where the first conductive pattern and the second conductive pattern are electrically connected together through one of welding, eutectic bonding, a conductive adhesive pattern located between the first conductive pattern and the second conductive pattern, or a third conductive pattern located between the first conductive pattern and the second conductive pattern, where
a material of the conductive adhesive pattern includes a conductive material and an adhesive; and a grain size of the third conductive pattern increases from a part close to the first conductive pattern to a middle region, and increases from a part close to the second conductive pattern to the middle region.

Optionally, the first conductive pattern is closer to the solar cell body than the second conductive pattern is; and
in a direction away from the solar cell body, an area of a cross section of the second conductive pattern or a partial region of the second conductive pattern away from the solar cell body gradually decreases, where the cross section is perpendicular to a lamination direction of the solar cell body and the first conductive pattern.

Optionally, a shape of a longitudinal section of the second conductive pattern or a partial region of the second conductive pattern away from the solar cell body is a triangle, a trapezoid, or a shape formed by an arc and a line segment connecting two endpoints of the arc, where a length of the line segment is less than or equal to a diameter of a circle corresponding to the arc; and the longitudinal section is parallel to a lamination direction of the solar cell body and the first conductive pattern.

Optionally, the solar cell further includes a bonding pattern arranged between the first conductive pattern and the solar cell body, where the bonding pattern is used for improving bonding force between the first conductive pattern and the solar cell body.

Optionally, in the lamination direction of the solar cell body and the first conductive pattern, the second conductive pattern includes a seed layer pattern and a plating pattern that are laminated, where the plating pattern is closer to the solar cell body than the seed layer pattern is, and the plating pattern wraps the seed layer pattern.

Optionally, in the lamination direction of the solar cell body and the first conductive pattern, the second conductive pattern is formed by at least two second conductive sub-patterns that are laminated.

Optionally, the second conductive pattern and the first conductive pattern are eutectically bonded or welded together; and
the solar cell further includes a diffusion control pattern arranged between the first conductive pattern and the second conductive pattern, where the diffusion control pattern is used for controlling a thickness of an alloy formed in the welding or the eutectic bonding of the second conductive pattern and the first conductive pattern.

Optionally, the second conductive pattern and the first conductive pattern are welded together; and
the solar cell further includes a flux pattern arranged between the first conductive pattern and the second conductive pattern.

According to a third aspect of the present invention, a method for preparing a solar cell is provided, including:
forming a second conductive pattern on an imprint template;
aligning the second conductive pattern with a region on which an electrode is to be formed in a solar cell body, and electrically connecting the second conductive pattern to the region on which the electrode is to be formed in the solar cell body, where the electrical connection between the second conductive pattern and the region on which the electrode is to be formed in the solar cell body includes any one of the following four manners: in a first manner, the second conductive pattern is bonded to the region on which the electrode is to be formed in the solar cell body through a bonding part, where a material of the bonding part includes a conductive material and an adhesive; in a second manner, the second conductive pattern is welded to the region on which the electrode is to be formed in the solar cell body; in a third manner, a third conductive pattern is formed between the second conductive pattern and the region on which the electrode is to be formed in the solar cell body through electroplating or chemical plating, and the second conductive pattern and the region on which the electrode is to be formed in the solar cell body are connected together through the third conductive pattern; or in a fourth manner, the second conductive pattern is eutectically bonded to the region on which the electrode is to be formed in the solar cell body; and
removing the imprint template.

Optionally, before the aligning the second conductive pattern with a region on which an electrode is to be formed in a solar cell body, and electrically connecting the second conductive pattern to the region on which the electrode is to be formed in the solar cell body, the method further includes:
annealing the imprint template on which the second conductive pattern has been formed, to cause the second conductive pattern to recrystallize.

Optionally, the bonding part includes a conductive adhesive film layer or a conductive adhesive pattern; and after the second conductive pattern is bonded to the region on which the electrode is to be formed in the solar cell body through the conductive adhesive film layer, and after the removing the imprint template, the method further includes: removing the conductive adhesive film layer outside a region on which the electrode is to be formed, to form the conductive adhesive pattern.

Optionally, before the bonding, the method further includes:
forming the bonding part on the second conductive pattern; and the aligning the second conductive pattern with a region on which an electrode is to be formed in a solar cell body includes: aligning the region on which the electrode is to be formed in the solar cell body with the conductive adhesive pattern or the region on which the electrode is to be formed in the conductive adhesive film layer; or
forming the bonding part on one of the region on which the electrode is to be formed in the solar cell body or the solar cell body; and the aligning the second conductive pattern with a region on which an electrode is to be formed in a solar cell body includes: aligning the second conductive pattern with the conductive adhesive pattern or the region on which the electrode is to be formed in the conductive adhesive film layer.

Optionally, a material of the conductive adhesive pattern is an aluminum paste, and the conductive adhesive pattern is in contact with a silicon substrate of the solar cell body; and
that the second conductive pattern is bonded to the region on which the electrode is to be formed in the solar cell body through a bonding part includes that
the second conductive pattern is bonded to a region on which the electrode is to be formed in the silicon substrate of the solar cell body through the conductive adhesive pattern, and sintering is performed, where during the sintering, a part of the aluminum paste in the conductive adhesive pattern diffuses into the region on which the electrode is to be formed in the silicon substrate, to dope the region on which the electrode is to be formed in the silicon substrate to form a P-type doped region.

Optionally, a material of the second conductive pattern is aluminum, and the second conductive pattern is in contact with a silicon substrate of the solar cell body; and
the aligning the second conductive pattern with a region on which an electrode is to be formed in a solar cell body, and electrically connecting the second conductive pattern to the region on which the electrode is to be formed in the solar cell body includes that
in a process of welding or eutectically bonding the second conductive pattern to the region on which the electrode is to be formed in the solar cell body, a part of aluminum in the second conductive pattern diffuses into a region on which the electrode is to be formed in the silicon substrate, to dope the region on which the electrode is to be formed in the silicon substrate to form a P-type doped region, and use a remaining part of the second conductive pattern as the electrode.

Optionally, before the welding or the eutectic bonding, the method further includes:
forming a diffusion control pattern on the second conductive pattern; and/or forming a diffusion control pattern on the region on which the electrode is to be formed in the solar cell body, where the diffusion control pattern is used for controlling a thickness of an alloy formed in the welding or the eutectic bonding of the second conductive pattern and the region on which the electrode is to be formed in the solar cell body.

Optionally, the imprint template includes a first groove; and the forming a second conductive pattern on an imprint template includes:
forming the second conductive pattern in the first groove of the imprint template, where
the second conductive pattern is flush with a surface of a side of the imprint template provided with the first groove, or protrudes from the surface of the side of the imprint template provided with the first groove.

Optionally, the imprint template includes a substrate, the first groove is arranged on the substrate, and the imprint template further includes a first boss arranged on the substrate and located at an edge of the first groove; and the forming the second conductive pattern in the first groove of the imprint template includes:
forming the second conductive pattern in the first groove and in a region defined by the first boss, where
the second conductive pattern is flush with a surface of the first boss away from the substrate, or protrudes from the surface of the first boss away from the substrate.

Optionally, in a direction from a notch of the first groove to a groove bottom of the first groove, an area of a cross section of the first groove gradually decreases, where the cross section is perpendicular to a lamination direction of the second conductive pattern and the solar cell body.

Optionally, the imprint template includes a substrate and a second boss located on the substrate; and
the forming a second conductive pattern on an imprint template includes:
forming a second conductive film layer on a side of the imprint template on which the second boss is formed, where the second conductive pattern is a part of the second conductive film layer located on the second boss.

Optionally, a surface of the second boss away from the substrate is a plane; or a side of the second boss away from the substrate includes a second groove, where the second conductive pattern is flush with a notch of the second groove, or protrudes from the second groove.

Optionally, the bonding part includes a conductive adhesive pattern; the imprint template includes a third groove; the forming a second conductive pattern on an imprint template includes:
forming the second conductive pattern in the third groove of the imprint template, and forming the conductive adhesive pattern on the second conductive pattern, where the conductive adhesive pattern is flush with a surface of a side of the imprint template provided with the third groove, or protrudes from the surface of the side of the imprint template provided with the third groove; and
the aligning the second conductive pattern with a region on which an electrode is to be formed in a solar cell body, and electrically connecting the second conductive pattern to the region on which the electrode is to be formed in the solar cell body includes:
   aligning the conductive adhesive pattern with the region on which the electrode is to be formed in the solar cell body, and bonding the second conductive pattern to the region on which the electrode is to be formed in the solar cell body through the conductive adhesive pattern.

Optionally, the forming a second conductive pattern on an imprint template includes:
forming a seed pattern on the imprint template; and
forming a plating pattern on the seed pattern through electroplating or chemical plating, where the plating pattern and the seed pattern together form the second conductive pattern.

Optionally, the imprint template includes a substrate, and the forming a second conductive pattern on an imprint template includes:
laying a metal foil on the substrate, and patterning the metal foil, to form the second conductive pattern.

Optionally, before the forming a second conductive pattern on an imprint template, the method further includes:
providing a plurality of metal foil patterns;
the imprint template includes a plurality of adsorption regions; and the forming a second conductive pattern on an imprint template includes: at least aligning one of the adsorption regions with one of the metal foil patterns, and adsorbing the metal foil pattern on the adsorption region, to form the second conductive pattern.

According to a fourth aspect of the present invention, a solar cell is provided, including:
a solar cell body; and
a second conductive pattern arranged on the solar cell body, where the second conductive pattern and the solar cell body are electrically connected together through one of welding, eutectic bonding, a conductive adhesive pattern located between the second conductive pattern and the solar cell body, or a third conductive pattern located between the second conductive pattern and the solar cell body, where
a material of the conductive adhesive pattern includes a conductive material and an adhesive; and a grain size of the third conductive pattern increases from a part close to the solar cell body to a middle region, and increases from a part close to the second conductive pattern to the middle region.

Optionally, in a direction away from the solar cell body, an area of a cross section of the second conductive pattern or a partial region of the second conductive pattern away from the solar cell body gradually decreases, where the cross section is perpendicular to a lamination direction of the solar cell body and the second conductive pattern.

Optionally, a shape of a longitudinal section of the second conductive pattern or a partial region of the second conductive pattern away from the solar cell body is a triangle, a trapezoid, or a shape formed by an arc and a line segment connecting two endpoints of the arc, where a length of the line segment is less than or equal to a diameter of a circle corresponding to the arc; and the longitudinal section is parallel to a lamination direction of the solar cell body and the second conductive pattern.

Optionally, the second conductive pattern is welded or eutectically bonded to the solar cell body; and
the solar cell further includes a diffusion control pattern arranged between the second conductive pattern and the solar cell body, where the diffusion control pattern is used for controlling a thickness of an alloy formed in the welding or the eutectic bonding of the second conductive pattern and the solar cell body.

Optionally, in the lamination direction of the solar cell body and the second conductive pattern, the second conductive pattern includes a seed layer pattern and a plating pattern that are laminated, where the plating pattern is closer to the solar cell body than the seed layer pattern is, and the plating pattern wraps the seed layer pattern.

Optionally, in the lamination direction of the solar cell body and the second conductive pattern, the second conductive pattern is formed by at least two second conductive sub-patterns that are laminated.

According to a fifth aspect of the present invention, a solar cell module is provided, including a first encapsulation adhesive film, a solar cell string, and a second encapsulation adhesive film that are sequentially laminated, where the solar cell string is formed by a plurality of solar cells sequentially connected in series; and
each of the solar cells is a solar cell according to any one of the foregoing descriptions.

The foregoing descriptions are merely an overview of the technical solutions in this application. In order that technical means of this application can be understood more clearly so that the technical solutions can be implemented according to content of the descriptions, and in order that the foregoing and other objectives, features, and advantages of this application can be understood more clearly, specific implementations of this application are described below.

### BRIEF DESCRIPTION OF THE DRAWINGS

To describe technical solutions in embodiments of this application or the related art more clearly, the following briefly introduces accompanying drawings required for describing the embodiments or the related art. Apparently, the accompanying drawings in the following descriptions show some of the embodiments of this application, and a person of ordinary skill in the art still derives other drawings from these accompanying drawings without creative efforts.
FIG. 1 is a schematic diagram of a structure of a solar cell module according to an exemplary embodiment of the present invention;
FIG. 2 is a schematic diagram of a structure of a first HJT solar cell according to an exemplary embodiment of the present invention;
FIG. 3 is a schematic diagram of a structure of a first HBC solar cell according to an exemplary embodiment of the present invention;
FIG. 4 is a schematic diagram of a structure of a second HJT solar cell according to an exemplary embodiment of the present invention;
FIG. 5 is a schematic diagram of a structure of a third HJT solar cell according to an exemplary embodiment of the present invention;
FIG. 6 is a flowchart of steps of a first method for preparing a solar cell according to an exemplary embodiment of the present invention;
FIG. 7 is a schematic diagram of a local structure of a first HJT solar cell according to an exemplary embodiment of the present invention;
FIG. 8 is a schematic diagram of a local structure of a second HJT solar cell according to an exemplary embodiment of the present invention;
FIG. 9 is a schematic diagram of a local structure of a first HBC solar cell according to an exemplary embodiment of the present invention;
FIG. 10 is a schematic diagram of a local structure of a second HBC solar cell according to an exemplary embodiment of the present invention;
FIG. 11 is a schematic diagram of a first local structure forming a second conductive pattern according to an exemplary embodiment of the present invention;
FIG. 12 is a schematic diagram of a second local structure forming a second conductive pattern according to an exemplary embodiment of the present invention;
FIG. 13 is a schematic diagram of a third local structure forming a second conductive pattern according to an exemplary embodiment of the present invention;
FIG. 14 is a schematic diagram of a fourth local structure forming a second conductive pattern according to an exemplary embodiment of the present invention;
FIG. 15 is a schematic diagram of a fifth local structure forming a second conductive pattern according to an exemplary embodiment of the present invention;
FIG. 16 is a schematic diagram of a first structure in which a second conductive pattern is aligned with a region on which an electrode is to be formed in a first conductive film layer according to an exemplary embodiment of the present invention;
FIG. 17 is a schematic diagram of a second structure in which a second conductive pattern is aligned with a region on which an electrode is to be formed in a first conductive film layer according to an exemplary embodiment of the present invention;
FIG. 18 is a schematic diagram of a third structure in which a second conductive pattern is aligned with a region on which an electrode is to be formed in a first conductive film layer according to an exemplary embodiment of the present invention;
FIG. 19 is a schematic diagram of a local structure of a third HJT solar cell according to an exemplary embodiment of the present invention;
FIG. 20 is a schematic diagram of a local structure of a third HBC solar cell according to an exemplary embodiment of the present invention;
FIG. 21 is a schematic diagram of a structure of a first imprint template according to an exemplary embodiment of the present invention;
FIG. 22 is a schematic diagram of a structure of a second imprint template according to an exemplary embodiment of the present invention;
FIG. 23 is a schematic diagram of a structure of a third imprint template according to an exemplary embodiment of the present invention;
FIG. 24 is a schematic diagram of a structure of a fourth imprint template according to an exemplary embodiment of the present invention;
FIG. 25 is a schematic diagram of a structure of a fourth HJT solar cell according to an exemplary embodiment of the present invention;
FIG. 26 is a schematic diagram of a structure of a fifth imprint template according to an exemplary embodiment of the present invention;
FIG. 27 is a schematic diagram of a sixth local structure forming a second conductive pattern according to an exemplary embodiment of the present invention;
FIG. 28 is a schematic diagram of a seventh local structure forming a second conductive pattern according to an exemplary embodiment of the present invention;
FIG. 29 is a flowchart of steps of a second method for preparing a solar cell according to an exemplary embodiment of the present invention;
FIG. 30 is a schematic diagram of a local structure of a first solar cell according to an exemplary embodiment of the present invention;
FIG. 31 is a schematic diagram of a structure of a fifth HJT solar cell according to an exemplary embodiment of the present invention;
FIG. 32 is a schematic diagram of a structure of a second HBC solar cell according to an exemplary embodiment of the present invention;
FIG. 33 is a schematic diagram of a structure of a sixth HJT solar cell according to an exemplary embodiment of the present invention;
FIG. 34 is a flowchart of steps of a third method for preparing a solar cell according to an exemplary embodiment of the present invention;
FIG. 35 is a schematic diagram of a local structure of a fourth HJT solar cell according to an exemplary embodiment of the present invention;
FIG. 36 is a schematic diagram of a local structure of a fifth HJT solar cell according to an exemplary embodiment of the present invention;
FIG. 37 is a schematic diagram of a local structure of a fourth HBC solar cell according to an exemplary embodiment of the present invention;
FIG. 38 is a schematic diagram of a local structure of a fifth HBC solar cell according to an exemplary embodiment of the present invention;
FIG. 39 is a schematic diagram of a fourth structure in which a second conductive pattern is aligned with a region on which an electrode is to be formed in a first conductive film layer according to an exemplary embodiment of the present invention;
FIG. 40 is a schematic diagram of a fifth structure in which a second conductive pattern is aligned with a region on which an electrode is to be formed in a first conductive film layer according to an exemplary embodiment of the present invention;
FIG. 41 is a schematic diagram of a sixth structure in which a second conductive pattern is aligned with a region on which an electrode is to be formed in a first conductive film layer according to an exemplary embodiment of the present invention;
FIG. 42 is a schematic diagram of a local structure of a sixth HJT solar cell according to an exemplary embodiment of the present invention;
FIG. 43 is a schematic diagram of a local structure of a sixth HBC solar cell according to an exemplary embodiment of the present invention;
FIG. 44 is a schematic diagram of a structure of a sixth imprint template according to an exemplary embodiment of the present invention;
FIG. 45 is a schematic diagram of an eighth local structure forming a second conductive pattern according to an exemplary embodiment of the present invention;
FIG. 46 is a schematic diagram of a ninth local structure forming a second conductive pattern according to an exemplary embodiment of the present invention;
FIG. 47 is a schematic diagram of a structure of a seventh HJT solar cell according to an exemplary embodiment of the present invention;
FIG. 48 is a schematic diagram of a structure of an eighth HJT solar cell according to an exemplary embodiment of the present invention;
FIG. 49 is a schematic diagram of a local structure of a second solar cell according to an exemplary embodiment of the present invention;
FIG. 50 is a flowchart of steps of a fourth method for preparing a solar cell according to an exemplary embodiment of the present invention;
FIG. 51 is a schematic diagram of a structure of a ninth HJT solar cell according to an exemplary embodiment of the present invention;
FIG. 52 is a flowchart of steps of a fifth method for preparing a solar cell according to an exemplary embodiment of the present invention;
FIG. 53 is a schematic diagram of a seventh structure in which a second conductive pattern is aligned with a region on which an electrode is to be formed in a first conductive film layer according to an exemplary embodiment of the present invention;
FIG. 54 is a schematic diagram of a locally enlarged structure in which a second conductive pattern is aligned with a region on which an electrode is to be formed in a first conductive film layer according to an exemplary embodiment of the present invention;
FIG. 55 is a schematic diagram of a structure in which a third conductive film layer is formed between a second conductive pattern and a region on which an electrode is to be formed in a first conductive film layer through electroplating or chemical plating according to an exemplary embodiment of the present invention;
FIG. 56 is a schematic diagram of a locally enlarged structure in which a third conductive film layer is formed between a second conductive pattern and a region on which an electrode is to be formed in a first conductive film layer through electroplating or chemical plating according to an exemplary embodiment of the present invention;
FIG. 57 is a schematic diagram of a structure in which an imprint template is removed according to an exemplary embodiment of the present invention;
FIG. 58 is a schematic diagram of a locally enlarged structure in which an imprint template is removed according to an exemplary embodiment of the present invention;
FIG. 59 is a flowchart of steps of a sixth method for preparing a solar cell according to an exemplary embodiment of the present invention;
FIG. 60 is a flowchart of steps of a seventh method for preparing a solar cell according to an exemplary embodiment of the present invention; and
FIG. 61 is a flowchart of steps of an eighth method for preparing a solar cell according to an exemplary embodiment of the present invention.

### Reference numerals:

1-solar cell string, 2-first encapsulation adhesive film, 3-second encapsulation adhesive film, 4-transparent cover, 5-back sheet, 101-substrate, 102-first boss, 103-first groove, 104-second conductive film layer and second conductive pattern, 1041, 1042, and 1043-second conductive sub-pattern, 1044-metal wire, 1045-coating, 1046-aluminum paste sub-pattern, 1047-seed pattern, 1048-plating pattern, 105-third groove, 202-second boss, 2021-second groove, 311-bonding film layer and bonding pattern, 321-first conductive film layer and first conductive pattern, 313-conductive adhesive film layer, conductive adhesive pattern, and third conductive pattern, 301-front-side TCO film, 302-N-type hydrogen-doped amorphous silicon/micro-crystalline silicon oxide passivation layer, 303-front-side intrinsic amorphous silicon passivation layer, 304-front-side intrinsic amorphous silicon buffer layer, 305-silicon substrate, 306-back-side intrinsic amorphous silicon buffer layer, 307-back-side intrinsic amorphous silicon passivation layer, 308-P-type amorphous silicon emitter, 309-back-side TCO film, 401-front-side silicon nitride layer, 402-front-side n layer, 403-front-side i layer, 405-back-side i layer, 406-n-type layer, 408-p-type layer, 409-isolation layer, and 3051-P-type doped region.

### DETAILED DESCRIPTION

To make the objectives, technical solutions, and advantages of the embodiments of this application clearer, the following clearly and completely describes the technical solutions in the embodiments of this application with reference to the accompanying drawings in the embodiments of this application. Apparently, the described embodiments are some rather than all of the embodiments of this application. All other embodiments obtained by a person of ordinary skill in the art based on the embodiments of this application without creative efforts shall fall within the protection scope of this application.

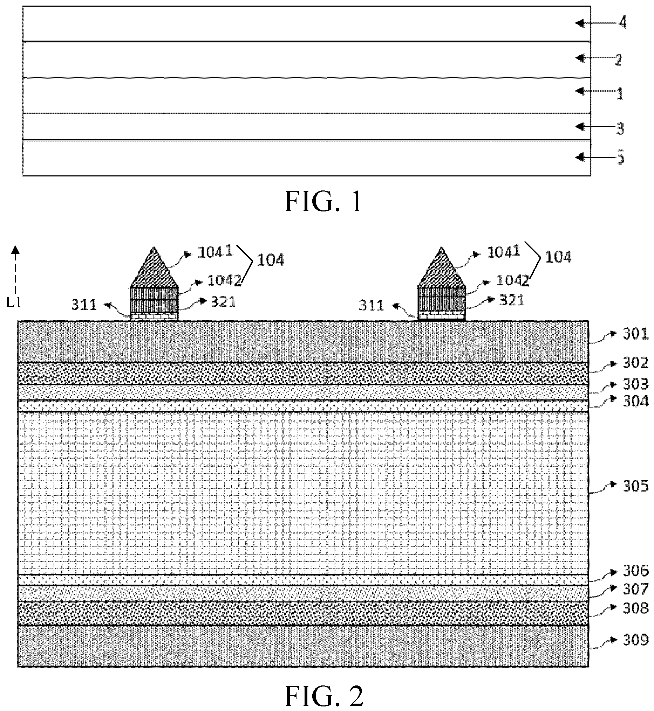

FIG. 1 is a schematic diagram of a structure of a solar cell module according to an exemplary embodiment of the present invention. An embodiment of the present invention provides a solar cell module. As shown in FIG. 1, the solar cell module includes a first encapsulation adhesive film 2, a solar cell string 1, and a second encapsulation adhesive film 3 that are sequentially laminated, where the solar cell string 1 includes a plurality of solar cells sequentially connected in series. In some examples, the first encapsulation adhesive film 1 and the second encapsulation adhesive film 3 may be ethylene-vinyl acetate copolymer (EVA) films.

Referring to FIG. 1, in some examples, the solar cell module may further include: a transparent cover 4 arranged on a side of the first encapsulation adhesive film 2 away from the solar cell string 1; and/or a back sheet 5 arranged on a side of the second encapsulation adhesive film 3 away from the solar cell string 1.

An embodiment of the present invention further provides a solar cell. The solar cell may be applied to the foregoing solar cell module, and specifically, the solar cell is applied to the foregoing solar cell string. A type of the solar cell is not limited in the present invention. The solar cell may be, for example, a heterojunction with intrinsic thin-layer (HJT) solar cell, a silicon heterjunction (SHJ) solar cell, an interdigital back contact (IBC) solar cell, a tunnel oxide passivated contact (TOPcon) solar cell, or a passivated emitter and rear cell (PERC).

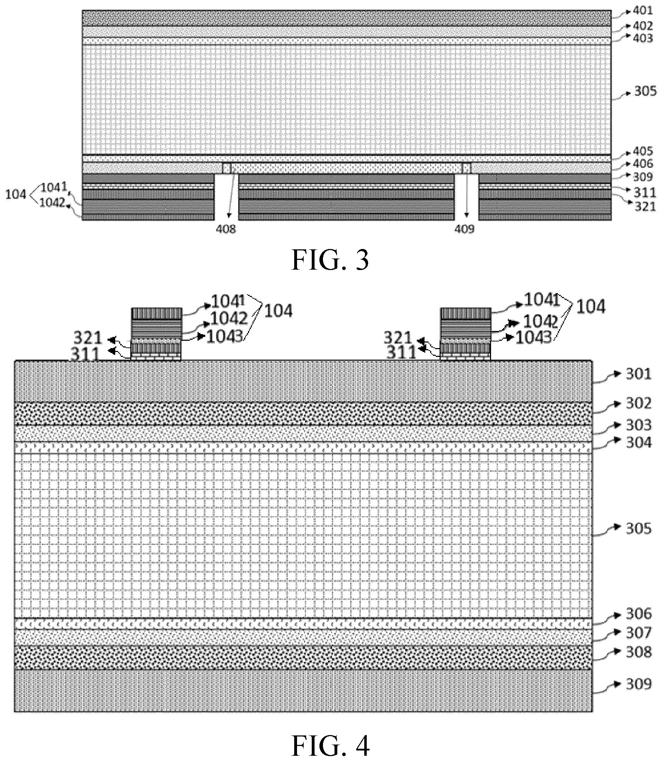

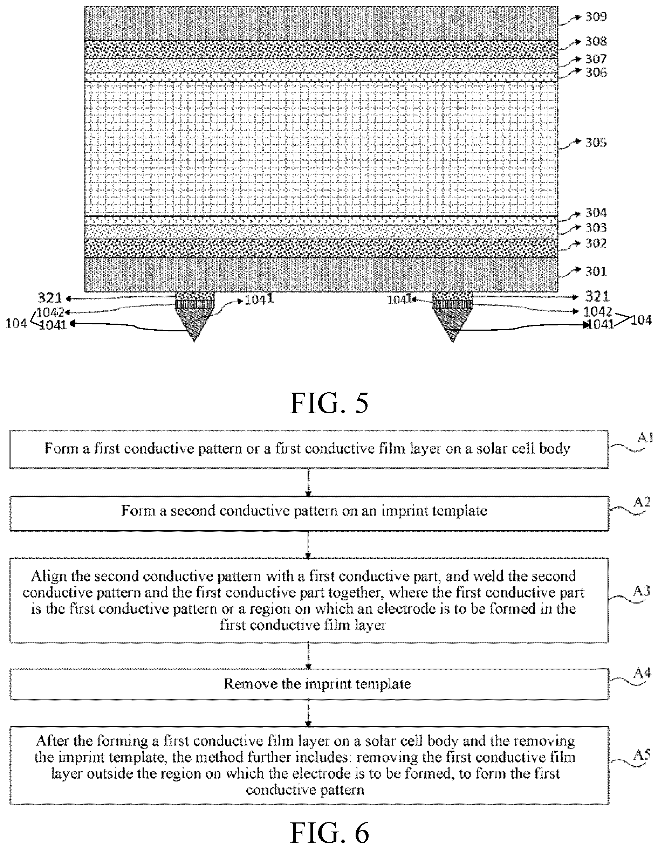

FIG. 2 is a schematic diagram of a structure of a first HJT solar cell according to an exemplary embodiment of the present invention. FIG. 3 is a schematic diagram of a structure of a first HBC solar cell according to an exemplary embodiment of the present invention. FIG. 4 is a schematic diagram of a structure of a second HJT solar cell according to an exemplary embodiment of the present invention. FIG. 5 is a schematic diagram of a structure of a third HJT solar cell according to an exemplary embodiment of the present invention.

As shown in FIG. 2, FIG. 3, FIG. 4, and FIG. 5, the solar cell includes a solar cell body, and a positive electrode and a negative electrode arranged on the solar cell body. Based on this, it may be understood that, the solar cell outside the positive electrode and the negative electrode may be considered as the solar cell body. Structures of solar cell bodies are different for different types of solar cells, which are described below by using two examples.

Example 1: When the solar cell is an HJT solar cell, as shown in FIG. 2, FIG. 4, and FIG. 5, the HJT solar cell may include, for example, a front-side transparent conducting oxide (TCO) film 301, an N-type hydrogen-doped amorphous silicon/micro-crystalline silicon oxide passivation layer 302, a front-side intrinsic amorphous silicon passivation layer 303, a front-side intrinsic amorphous silicon buffer layer 304, a silicon substrate 305, a back-side intrinsic amorphous silicon buffer layer 306, a back-side intrinsic amorphous silicon passivation layer 307, a P-type amorphous silicon emitter 308, and a back-side TCO film 309 that are sequentially laminated, a negative electrode arranged on the front-side TCO film 301, and a positive electrode arranged on the back-side TCO film 309. It may be considered that, the front-side TCO film 301, the N-type hydrogen-doped amorphous silicon/micro-crystalline silicon oxide passivation layer 302, the front-side intrinsic amorphous silicon passivation layer 303, the front-side intrinsic amorphous silicon buffer layer 304, the silicon substrate 305, the back-side intrinsic amorphous silicon buffer layer 306, the back-side intrinsic amorphous silicon passivation layer 307, the P-type amorphous silicon emitter 308, and the back-side TCO film 309 that are sequentially laminated are a solar cell body of the HJT solar cell.

Example 2: When the solar cell is a heterojunction back contact (HBC) solar cell, as shown in FIG. 3, the HBC solar cell may include, for example, a front-side silicon nitride layer 401, a front-side n layer 402, a front-side i layer 403, a silicon substrate 305, a back-side i layer 405, an n-type layer 406, a p-type layer 408, an isolation layer 409, a back-side TCO film 309, a positive electrode arranged on the p-type layer 408, and a negative electrode arranged on the n-type layer 406. The front-side silicon nitride layer 401, the front-side n-layer 402, the front-side i layer 403, the silicon substrate 305, the back-side i layer 405, the n-type layer 406, the p-type layer 408, the isolation layer 409, and the back-side TCO film 309 may be considered as a solar cell body of the HBC solar cell.

In the solar cell, the positive electrode and the negative electrode may be located on a same side of the solar cell body, or may be separately arranged on two opposite sides of the solar cell body.

The following provides a plurality of embodiments to describe a structure of a solar cell and a method for preparing a solar cell.

### Embodiment 1

Embodiment 1 provides a solar cell. Referring to FIG. 2, FIG. 3, FIG. 4, and FIG. 5, the solar cell includes a solar cell body, and a positive electrode and a negative electrode arranged on the solar cell body, where a structure of the positive electrode and a structure of the negative electrode may be the same or may be different. An electrode (where the electrode may be the positive electrode or the negative electrode) of the solar cell includes a first conductive pattern 321 and a second conductive pattern 104 laminated on the solar cell body, where the first conductive pattern 321 and the second conductive pattern 104 are welded together. The welding means that the first conductive pattern 321 and the second conductive pattern 104 are connected together through mutual melting and alloying at a specific temperature. The welding temperature may be determined according to materials of the first conductive pattern 321 and the second conductive pattern 104. The specific temperature required for the welding is not limited in the present invention.

For example, for a double-sided solar cell, an electrode may be located on a light receiving side or a back side of a solar cell body. For a back contact solar cell, an electrode may be located on a back side of a solar cell body. It may be understood that, a part of the solar cell body in contact with the first conductive pattern herein can conduct electricity. For example, the part of the solar cell body in contact with the first conductive pattern may be a TCO film; or the part of the solar cell body in contact with the first conductive pattern may be a doped layer. For another example, if a passivation layer is formed on a surface of the solar cell body, the part of the solar cell body in contact with the first conductive pattern herein is a layer that is exposed after the passivation layer is grooved and that can conduct electricity.

The first conductive pattern 321 and the second conductive pattern 104 are welded together. The welding process is simple and mature, and mass production is easy to be implemented. In addition, the welding features a low bonding temperature and high bonding strength. The low bonding temperature can reduce a heat effect on the solar cell body, thereby having little effect on photoelectric conversion efficiency of the solar cell. The high bonding strength can make the electrode of the solar cell have good reliability. In addition, during the welding, the materials of the second conductive pattern 104 and the first conductive pattern 321 can be welded, are not limited to a silver paste, and have more material selections; and compared with the silver paste, selecting copper, tin, or the like can appropriately reduce costs. In addition, the silver paste is granular, resulting in little contact between silver particles; and the silver paste includes an organic component, and the organic component also affects the contact between the silver particles. In this way, an electrode made of a silver paste has high resistivity and poor conductivity performance. However, in this embodiment of the present invention, a material of the electrode may not be granular (for example, a silver paste), and the material of the electrode may be, for example, silver, copper, tin, or an alloy thereof, so that the electrode has good conductivity performance. In addition, because the second conductive pattern 104 may not be prepared on the solar cell body, a process of preparing the second conductive pattern has little or substantially no effect on the solar cell body, and mass production is easy to be implemented. Therefore, preparation costs can be reduced.

It should be noted that, the materials of the first conductive pattern 321 and the second conductive pattern 104 may be materials that can be welded, and the materials of the first conductive pattern 321 and the second conductive pattern 104 are not specifically limited.

It should be noted that, a difference between FIG. 2 and FIG. 3 mainly lies in that structures of the solar cell bodies are different, and shapes of the second conductive patterns 104 are different. A difference between FIG. 2 and FIG. 4 mainly lies in that shapes of the second conductive patterns 104 are different.

Optionally, the first conductive pattern 321 and the second conductive pattern 104 each may be made of a low-temperature conductive material, so that the heat effect of the welding on the solar cell body can be reduced. For example, the first conductive pattern 321 and the second conductive pattern 104 may be made of at least one of the following eight low-temperature conductive materials: A first low-temperature conductive material has a melting point of 98°C and has the following components in percentage by mass: Bismuth (Bi): 50%, lead (Pb): 25%, and tin (Sn): 25%. A second low-temperature conductive material has a melting point of 74°C and has the following components in percentage by mass: Bismuth (Bi): 42.5%, lead (Pb): 37.7%, tin (Sn): 11.3%, and cadmium (Cd): 8.5%. A third low-temperature conductive material has a melting point of 70°C and has the following components in percentage by mass: Bismuth (Bi): 50%, lead (Pb): 26.7%, tin (Sn): 13.3%, and cadmium (Cd): 10%. A fourth low-temperature conductive material has a melting point of 62°C and has the following components in percentage by mass: Bismuth (Bi): 32.5%, tin (Sn): 16.5%, and indium (In): 51%. A fifth low-temperature conductive material has a melting point of 58°C and has the following components in percentage by mass: Bismuth (Bi): 49%, lead (Pb): 18%, tin (Sn): 12%, and indium (In): 21%. A sixth low-temperature conductive material has a melting point of 47.2 °C and has the following components in percentage by mass: Bismuth (Bi): 44.7%, lead (Pb): 22.6%, tin (Sn): 8.3%, indium (In): 19.1%, and cadmium (Cd): 5.3%. A seventh low-temperature conductive material has a melting point of 41.5°C and has the following components in percentage by mass: Bismuth (Bi): 40.3%, lead (Pb): 22.2%, tin (Sn): 10.7%, indium (In): 17.7%, cadmium (Cd): 8.1%, and thallium (TI): 1.1%. An eighth low-temperature conductive material has a melting point of 30.0°C and has the following component in percentage by mass: gallium (Ga): 100%.

Optionally, referring to FIG. 2 to FIG. 5, the first conductive pattern 321 is closer to the solar cell body than the second conductive pattern 104 is. In FIG. 2, a direction shown by a dashed arrow L1 is a direction away from the solar cell body. In the direction away from the solar cell body, an area of a cross section of a partial region of the second conductive pattern 104 away from the solar cell body gradually decreases, where the cross section is perpendicular to a lamination direction of the first conductive pattern 321 and the second conductive pattern 104, or the cross section is perpendicular to a lamination direction of the solar cell body and the first conductive pattern 321. The lamination direction of the first conductive pattern 321 and the second conductive pattern 104 is parallel to the lamination direction of the solar cell body and the first conductive pattern 321. In other words, the farther away from the first conductive pattern 321, the smaller the area of the cross section of the partial region of the second conductive pattern 104 away from the solar cell body. This design helps reduce reflection and shading, so that the photoelectric conversion efficiency of the solar cell can be increased.

Referring to FIG. 2 and FIG. 5, in some examples, the second conductive pattern 104 includes a second conductive sub-pattern 1041 and a second conductive sub-pattern 1042 that are laminated, where the second conductive sub-pattern 1042 is closer to the first conductive pattern 321 than the second conductive sub-pattern 1041 is. In the direction away from the solar cell body, an area of a cross section of the second conductive pattern 104 gradually decreases, so that reflection and shading can be reduced. Alternatively, in the direction away from the solar cell body, areas of various cross sections of the second conductive sub-pattern 1042 close to the first conductive pattern 321 in the second conductive pattern 104 are equal, and an area of a cross section of the second conductive sub-pattern 1041 away from the first conductive pattern 321 in the second conductive pattern 104 gradually decreases. The second conductive sub-pattern 1041 can reduce reflection and shading.

Optionally, a shape of a longitudinal section of the second conductive pattern 104 or a partial region of the second conductive pattern 104 away from the solar cell body is a triangle, a trapezoid, or a shape formed by an arc and a line segment connecting two endpoints of the arc, where a length of the line segment is less than or equal to a diameter of a circle corresponding to the arc; and the longitudinal section is parallel to a lamination direction of the first conductive pattern 321 and the second conductive pattern 104, or the longitudinal section is parallel to a lamination direction of the solar cell body and the first conductive pattern 321. It should be noted that, if the length of the line segment is equal to the diameter of the circle corresponding to the arc, the shape of the longitudinal section of the second conductive pattern 104 or the partial region of the second conductive pattern 104 away from the solar cell body is a semicircle, and a shape of the second conductive pattern 104 or the partial region of the second conductive pattern 104 away from the solar cell body is a semi-cylinder. If the length of the line segment is less than the diameter of the circle corresponding to the arc, the arc is an inferior arc of the circle corresponding to the arc.

For example, in FIG. 2 and FIG. 5, a shape of a longitudinal section of the second conductive sub-pattern 1041 away from the solar cell body in the second conductive pattern 104 is a triangle, and a shape of a longitudinal section of the second conductive sub-pattern 1042 close to the solar cell body in the second conductive pattern 104 is a rectangle. The shape of the longitudinal section of the second conductive pattern 104 is a shape spliced by the rectangle and the triangle, a bottom edge of the triangle coincides with an edge of the rectangle, and an angle opposite to the bottom edge is located on a side of the second conductive pattern 104 away from the first conductive pattern 321.

Optionally, referring to FIG. 2 to FIG. 4, the electrode of the solar cell further includes a bonding pattern 311 located between the first conductive pattern 321 and the solar cell body, where the bonding pattern 311 is used for improving bonding force between the first conductive pattern 321 and the solar cell body, so that the electrode has good reliability. A shape of the bonding pattern 311 may be the same as or similar to a shape of the first conductive pattern 321. A material of the bonding pattern 311 may be selected from at least one of titanium, chromium, copper, nickel, lead, tin, titanium nitride, titanium tungsten, or silver. Bonding force between the bonding pattern 311 made of the foregoing material and the solar cell body is strong, thereby indirectly improving the bonding force between the first conductive pattern 321 and the solar cell body. It should be noted that, the bonding pattern 311 may also be a single-layer structure or a multi-layer structure. For example, as shown in FIG. 2 to FIG. 5, the bonding pattern 311 is a single-layer structure.

Optionally, a thickness of the bonding pattern 311 may range from 1 nm to 50 nm; and a thickness direction is parallel to the lamination direction of the first conductive pattern 321 and the second conductive pattern 104, or the thickness direction is parallel to the lamination direction of the solar cell body and the first conductive pattern 321. When the thickness of the bonding pattern 311 is within the range, the effect of improving the bonding force between the first conductive pattern 321 and the solar cell body is good, and costs are low. For example, the bonding pattern 311 may be a titanium bonding pattern of 10 nm.

In some examples, the thickness of the bonding pattern 311 may be, for example, 1 nm, 10 nm, 20 nm, 30 nm, 40 nm, or 50 nm. Compared with FIG. 2, FIG. 3, and FIG. 4, the solar cell shown in FIG. 5 has no bonding pattern.

Optionally, the solar cell may further include a diffusion control pattern (not shown in the figure) located between the first conductive pattern 321 and the second conductive pattern 104, where the diffusion control pattern is used for controlling a thickness of an alloy formed in the welding of the second conductive pattern 104 and the first conductive pattern 321, to obtain an ideal interface alloy region. Specifically, the diffusion control pattern located between the first conductive pattern 321 and the second conductive pattern 104 can slow down atomic diffusion speeds of both the first conductive pattern 321 and the second conductive pattern 104 during the welding, so that a thickness of the alloy formed at various positions of a welding interface is relatively uniform, and the thickness of the alloy formed during the welding is not excessively thick, so that bonding force between the first conductive pattern 321 and the second conductive pattern 104 can be improved. In addition, the diffusion control pattern located between the first conductive pattern 321 and the second conductive pattern 104 can also improve infiltration of the first conductive pattern 321 and infiltration of the second conductive pattern 104, so that fewer bubbles are formed during bonding of the first conductive pattern 321 and the second conductive pattern 104, and the first conductive pattern 321 and the second conductive pattern 104 are bonded more tightly, thereby further improving the bonding force between the first conductive pattern 321 and the second conductive pattern 104. In addition, the diffusion control pattern located between the first conductive pattern 321 and the second conductive pattern 104 can also prevent the atomic diffusion speeds of both the first conductive pattern 321 and the second conductive pattern 104 to a certain extent when the solar cell is heated or cooled after the welding, to prevent the alloy from continuously thickening. A material of the diffusion control pattern is not specifically limited. For example, the material of the diffusion control pattern may be graphene, and may be single-layer graphene or multi-layer graphene. A shape of the diffusion control pattern may be the same as or similar to the shapes of the first conductive pattern 321 and the second conductive pattern 104.

It should be noted that, if both a flux pattern and the diffusion control pattern exist between the first conductive pattern 321 and the second conductive pattern 104, the diffusion control pattern is located between the flux pattern and the first conductive pattern 321, or the diffusion control pattern is located between the flux pattern and the second conductive pattern 104. For example, the structure of the electrode may be as follows: The first conductive pattern 321, the diffusion control pattern, the flux pattern, and the second conductive pattern 104 are sequentially laminated, and the diffusion control pattern is located between the flux pattern and the first conductive pattern 321. In this case, the diffusion control pattern can control the thickness of the alloy formed in the welding of the second conductive pattern 104 and the first conductive pattern 321, and can also control a thickness of an alloy formed in welding of the flux pattern and the second conductive pattern 104. For example, for the foregoing example, during the welding, the flux pattern and the second conductive pattern 104 also need to be welded, and the diffusion control pattern can also control the thickness of the alloy formed in the welding of the flux pattern and the second conductive pattern 104.

Optionally, a thickness of the second conductive pattern 104 ranges from 5 µm to 50 µm, and/or a thickness of the first conductive pattern 321 ranges from 10 nm to 100 nm; and a thickness direction is parallel to the lamination direction of the first conductive pattern 321 and the second conductive pattern 104. The thickness of the second conductive pattern 104 and the thickness of the first conductive pattern 321 are within the ranges, so that the electrode has a good carrier collection effect. It should be noted that, the thickness direction involved in this specification is the definition.

For example, the thickness of the second conductive pattern 104 may be 5 µm, 10 µm, 20 µm, 30 µm, 40 µm, or 50 µm. For example, the thickness of the first conductive pattern 321 may be 10 nm, 20 nm, 30 nm, 40 nm, 50 nm, 60 nm, 70 nm, 80 nm, 90 nm, or 100 nm.

Optionally, referring to FIG. 1 to FIG. 5, the second conductive pattern 104 is formed by at least two second conductive sub-patterns laminated in a direction parallel to the lamination direction of the first conductive pattern 321 and the second conductive pattern 104. In FIG. 2, a dashed line L1 may indicate the direction parallel to the lamination direction of the first conductive pattern 321 and the second conductive pattern 104. It should be noted that, a specific quantity of second conductive sub-patterns forming the second conductive pattern 104 is not specifically limited. For example, as shown in FIG. 1, FIG. 2, FIG. 3, and FIG. 5, the second conductive pattern 104 is formed by the second conductive sub-pattern 1041 and the second conductive sub-pattern 1042 that are laminated in the direction parallel to the lamination direction of the first conductive pattern 321 and the second conductive pattern 104. For another example, as shown in FIG. 4, the second conductive pattern 104 is formed by the second conductive sub-pattern 1041, the second conductive sub-pattern 1042, and a second conductive sub-pattern 1043 that are laminated in the direction parallel to the lamination direction of the first conductive pattern 321 and the second conductive pattern 104.

Optionally, in a direction parallel to the lamination direction of the solar cell body and the first conductive pattern 321, the second conductive pattern 104 includes a seed layer pattern and a plating pattern that are laminated, where the plating pattern is closer to the solar cell body than the seed layer pattern is, and the plating pattern wraps the seed layer pattern. To be specific, the plating pattern is located between the seed layer pattern and the solar cell body, and the plating pattern is formed on a side of the seed layer pattern close to the solar cell body through electroplating or chemical plating. Therefore, the plating pattern wraps the side of the seed layer pattern close to the solar cell body. There is an interface between the plating pattern and the seed layer pattern, and the second conductive pattern 104 is formed in flexible and diverse manners. The electroplating is to plate a material of the plating pattern on the seed layer pattern by using the principle of electrolysis. The chemical plating is to reduce metal ions in a chemical plating solution to a metal by using an appropriate reducing agent without an applied current, and deposit the metal onto the seed layer pattern. A process parameter such as a temperature of the electroplating or the chemical plating is not specifically limited, and is suitable for forming the plating pattern. A specific manner of the chemical plating is not limited. For example, the chemical plating may be lithium plating.

Optionally, a material of the second conductive sub-pattern 1041 farthest away from the first conductive pattern 321 in the second conductive pattern 104 may include tin. The second conductive sub-pattern 1041 farthest away from the first conductive pattern 321 in the second conductive pattern 104 is also a part of the electrode farthest away from the solar cell body, and a material of the part includes tin. This can avoid oxidation of the remaining second conductive sub-patterns in the second conductive pattern 104. In addition, a melting point of tin is low, and during welding of a solder strip and the electrode, a welding temperature can be low due to the low melting point of tin. This helps reduce the welding temperature of the electrode in a process of forming a solar cell module, to reduce a heat effect on the solar cell or the solar cell module. A material of a second conductive sub-pattern closest to the first conductive pattern 321 in the second conductive pattern 104 may be tin or a tin alloy. For example, in the solar cell shown in FIG. 4, the material of the second conductive sub-pattern 1041 farthest away from the first conductive pattern 321 in the second conductive pattern 104 includes tin, which may mainly avoid oxidation of the second conductive sub-pattern 1042 and the second conductive sub-pattern 1043. During the welding of the solder strip and the electrode, the welding temperature can be low due to the low melting point of tin, so that the heat effect on the solar cell or the solar cell module can be reduced.

It should be noted that, the tin alloy herein may be a copper-tin alloy, a lead-tin alloy, or the like.

Optionally, the solar cell may further include a flux pattern (not shown in the figure) located between the first conductive pattern 321 and the second conductive pattern 104. There is the flux pattern between the first conductive pattern 321 and the second conductive pattern 104, and flux usually includes tin. During the welding of the solder strip and the electrode, the welding temperature can be low due to the low melting point of tin, so that the heat effect on the solar cell or the solar cell module can be reduced. In addition, after the flux comes into contact with the first conductive pattern 321 and the second conductive pattern 104, impurities on a surface of the first conductive pattern 321 and a surface of the second conductive pattern 104 can be appropriately adsorbed. The flux is usually volatile, and volatilized flux can carry out some of the impurities. Therefore, the welding effect is good.

Embodiment 1 further provides a method for preparing a solar cell, which can be used to prepare the solar cell in Embodiment 1. FIG. 6 is a flowchart of steps of a first method for preparing a solar cell according to an exemplary embodiment of the present invention. Referring to FIG. 6, the method for preparing a solar cell includes the following steps.

Step A1: Form a first conductive pattern or a first conductive film layer on a solar cell body.

A manner of forming the first conductive pattern on the solar cell body may include: forming the first conductive pattern on a region on which an electrode is to be arranged in the solar cell body through screen printing, deposition, electroplating, or the like; or forming the entire first conductive film layer on the solar cell body in the foregoing manner, and patterning the first conductive film layer, to form the first conductive pattern. For example, a first conductive film layer 321 may be formed through vacuum deposition such as vacuum sputtering deposition. If the entire first conductive film layer 321 is formed, a mask layer may be arranged on the first conductive film layer 321, and the mask layer is patterned, to form the first conductive pattern 321 through wet etching. Alternatively, the first conductive film layer 321 may be patterned by using laser, to form the first conductive pattern 321. This is not specifically limited in the embodiments.

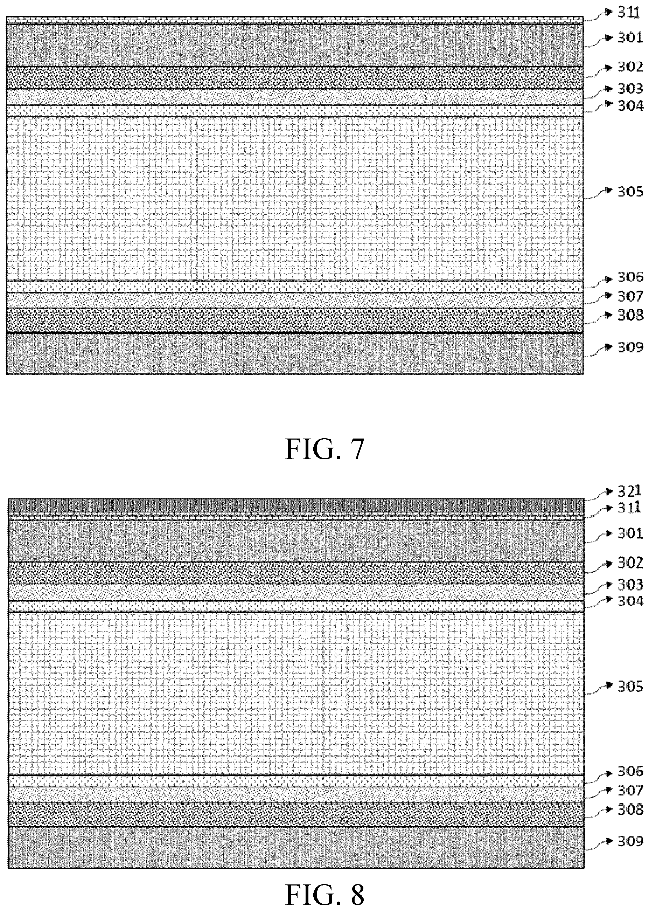

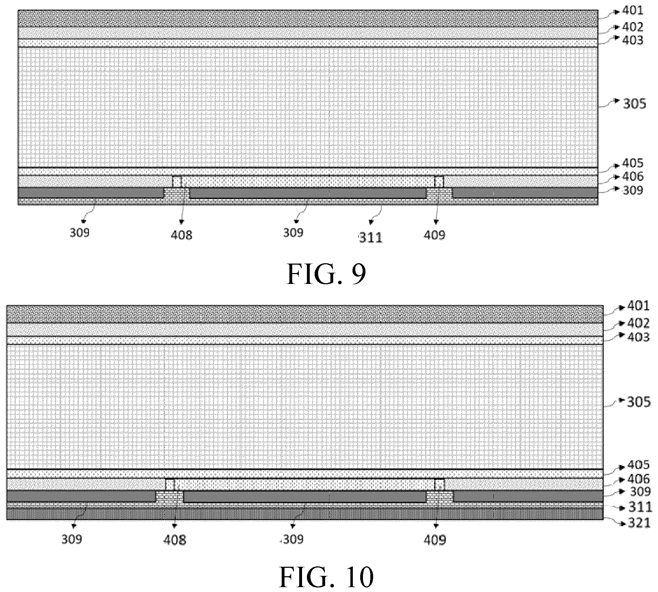

FIG. 7 is a schematic diagram of a local structure of a first HJT solar cell according to an exemplary embodiment of the present invention. FIG. 8 is a schematic diagram of a local structure of a second HJT solar cell according to an exemplary embodiment of the present invention. FIG. 9 is a schematic diagram of a local structure of a first HBC solar cell according to an exemplary embodiment of the present invention. FIG. 10 is a schematic diagram of a local structure of a second HBC solar cell according to an exemplary embodiment of the present invention. Referring to FIG. 8 and FIG. 10, the first conductive film layer 321 is formed on the solar cell body through screen printing, deposition, electroplating, or the like.

Optionally, the forming a first conductive pattern or a first conductive film layer on a solar cell body may include: laying a metal foil on the solar cell body, to form the first conductive film layer; and patterning the metal foil, to form the first conductive pattern. The patterning manner is not specifically limited. A material of the metal foil is the same as a material of the first conductive pattern or the first conductive film layer.

Optionally, after the laying a metal foil on the solar cell body, the method may include: pressing the metal foil, to bond the metal foil to the solar cell body. Specifically, if the solar cell body has a pyramid shape, a gap between the metal foil and the solar cell body may be relatively large. The metal foil and the solar cell body are well bonded through the pressing. This facilitates aligning and welding, and improves reliability of the electrode. The pressing manner is not specifically limited. For example, pressing may be performed by using a roller. After the pressing, a surface of the metal foil may be further cleaned, to reduce pollution of a pressing substance on the surface of the metal foil, and the like. This is not specifically limited in the embodiments of the present invention.

Step A2: Form a second conductive pattern on an imprint template.

It should be noted that, in this embodiment of this application, the imprint template may be a rigid template or a flexible template.

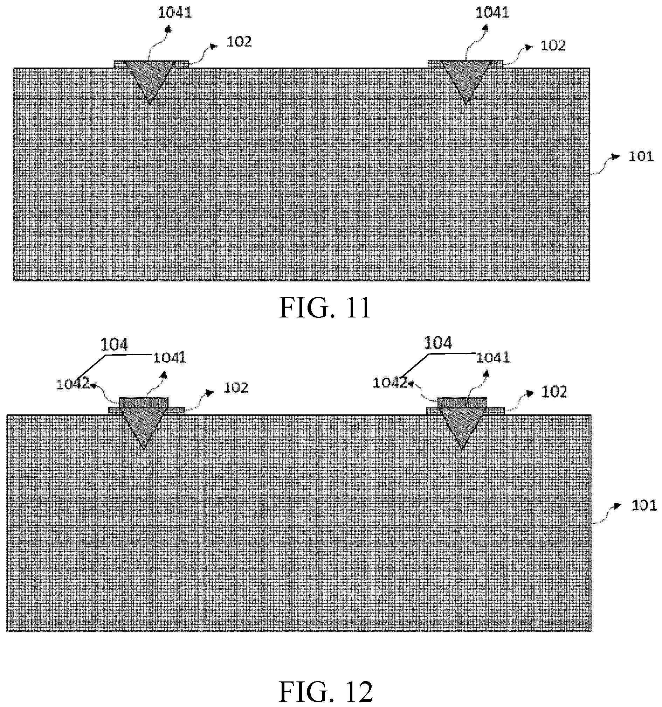

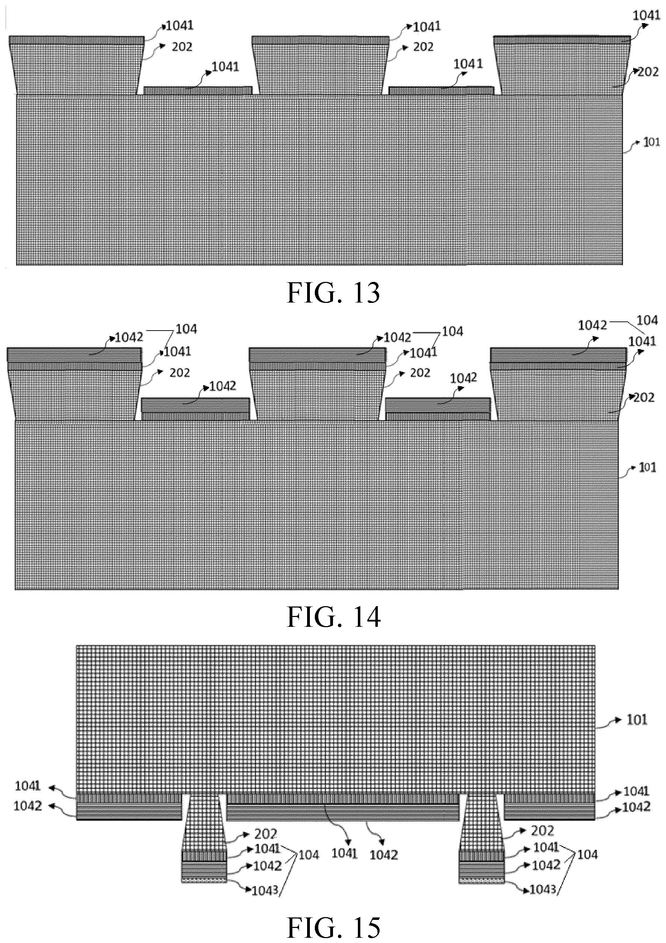

FIG. 11 is a schematic diagram of a first local structure forming a second conductive pattern according to an exemplary embodiment of the present invention. FIG. 12 is a schematic diagram of a second local structure forming a second conductive pattern according to an exemplary embodiment of the present invention. FIG. 13 is a schematic diagram of a third local structure forming a second conductive pattern according to an exemplary embodiment of the present invention. FIG. 14 is a schematic diagram of a fourth local structure forming a second conductive pattern according to an exemplary embodiment of the present invention. FIG. 15 is a schematic diagram of a fifth local structure forming a second conductive pattern according to an exemplary embodiment of the present invention. Referring to FIG. 11 to FIG. 15, a second conductive pattern 104 is formed on the imprint template. For example, an entire second conductive film layer is formed on the imprint template, and then the second conductive pattern 104 is formed through laser etching. A function of the imprint template is mainly that the imprint template may be used as a component for carrying the second conductive pattern 104 in a process of welding the second conductive pattern 104 to the first conductive pattern or the first conductive film layer 321 on the solar cell body. The second conductive pattern 104 shown in FIG. 12 and FIG. 13 is formed by a second conductive sub-pattern 1041 and a second conductive sub-pattern 1042 that are laminated in a direction parallel to a lamination direction of the first conductive pattern 321 and the second conductive pattern 104. The second conductive pattern 104 shown in FIG. 15 is formed by the second conductive sub-pattern 1041, the second conductive sub-pattern 1042, and a second conductive sub-pattern 1043 that are laminated in the direction parallel to the lamination direction of the first conductive pattern 321 and the second conductive pattern 104.

In some examples, the forming a second conductive pattern 104 on an imprint template includes: first, in FIG. 11, forming the second conductive sub-pattern 1041 on the imprint template, and then, in FIG. 12, forming the second conductive sub-pattern 1042 on the second conductive sub-pattern 1041.

In some other examples, the forming a second conductive pattern 104 on an imprint template includes: first, in FIG. 13, forming the second conductive sub-pattern 1041 on the imprint template, and then, in FIG. 14, forming the second conductive sub-pattern 1042 on the second conductive sub-pattern 1041; or in FIG. 15, forming the second conductive sub-pattern 1042 on the second conductive sub-pattern 1041, and then forming the second conductive sub-pattern 1043 on the second conductive sub-pattern 1042.

A manner of forming the second conductive pattern 104 on the imprint template may include: electroplating, deposition, or the like. The second conductive pattern 104 is formed on the imprint template, instead of being prepared on the solar cell body, and a process of preparing the second conductive pattern 104 has little or substantially no effect on the solar cell body, so that the effect on the solar cell body can be reduced, and mass production is easy to be implemented.

Step A3: Align the second conductive pattern with a first conductive part, and weld the second conductive pattern and the first conductive part together, where the first conductive part is the first conductive pattern or a region on which an electrode is to be formed in the first conductive film layer.

The second conductive pattern 104 is aligned with the first conductive pattern 321. The aligning herein may be that a first projection of the second conductive pattern 104 on the solar cell body and a second projection of the first conductive pattern 321 on the solar cell body have an overlapping region. An area of the overlapping region is not specifically limited. For example, an area of the first projection may be equal to an area of the second projection, and the area of the overlapping region may be smaller than the area of the first projection; or the area of the first projection may be equal to the area of the second projection, and the area of the overlapping region may be equal to the area of the first projection; or the area of the second projection may be larger than the area of the first projection, and the first projection may completely fall within the second projection. It should be noted that, aligning involved in this specification is the same as or similar to the definition of the aligning herein.

After the first conductive pattern 321 is aligned with the second conductive pattern 104, the second conductive pattern 104 and the first conductive pattern 321 are welded together, so that welding transfer of the second conductive pattern 104 located on the imprint template to the first conductive film layer 321 or the first conductive pattern 321 on the solar cell body is implemented. The welding features a low bonding temperature and high bonding strength. The low bonding temperature can reduce a heat effect on the solar cell body, thereby having little effect on photoelectric conversion efficiency of the solar cell. The high bonding strength can make the electrode of the solar cell have good reliability. Compared with screen printing, in the present invention, materials of the second conductive pattern and the first conductive film layer or the first conductive pattern can be welded, and are not limited to a silver paste. Therefore, costs can be appropriately reduced. Compared with laser transfer printing, in the present invention, the second conductive pattern and the first conductive pattern can be welded together, or the second conductive pattern and the region on which the electrode is to be formed in the first conductive film layer can be welded together. The welding process is mature, and process difficulty is relatively low, so that production efficiency can be appropriately improved. Compared with electroplating, in the present invention, the second conductive pattern and the first conductive pattern can be welded together, or the second conductive pattern and the region on which the electrode is to be formed in the first conductive film layer can be welded together. **In** this way, there is no process problem such as winding plating for the solar cell body, the yield and the reliability are good, and mass production is easy to be implemented.

That the second conductive pattern 104 is aligned with the region on which the electrode is to be formed in the first conductive film layer 321 is similar to that the second conductive pattern 104 is aligned with the first conductive pattern 321. Reference may be made to the foregoing related descriptions, and the same or similar beneficial effects can be achieved. To avoid repetition, details are not described herein again.

For that the second conductive pattern 104 and the region on which the electrode is to be formed in the first conductive film layer 321 are welded together, reference may also be made to the foregoing related descriptions in which the second conductive pattern 104 and the first conductive pattern 321 are welded together, and the same or similar beneficial effects can be achieved. To avoid repetition, details are not described herein again.

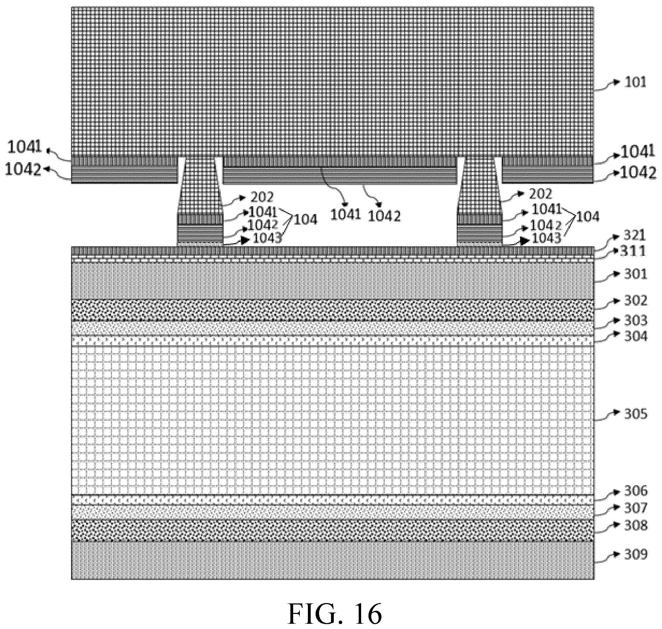

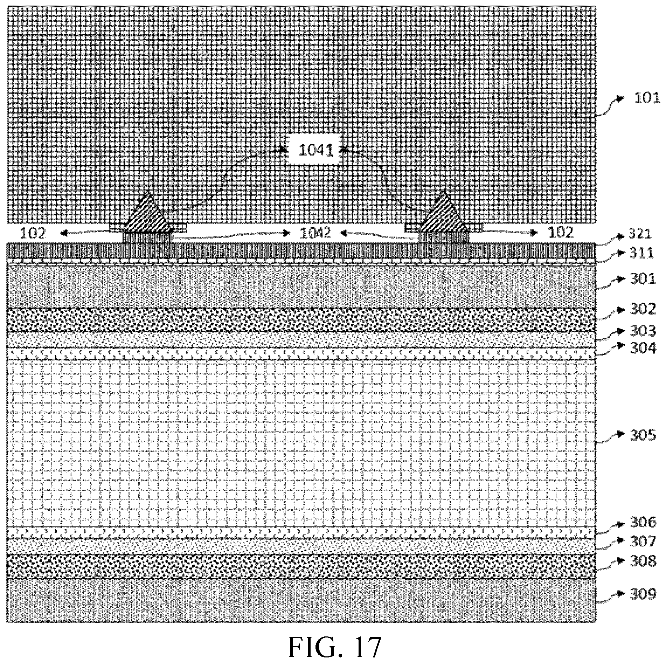

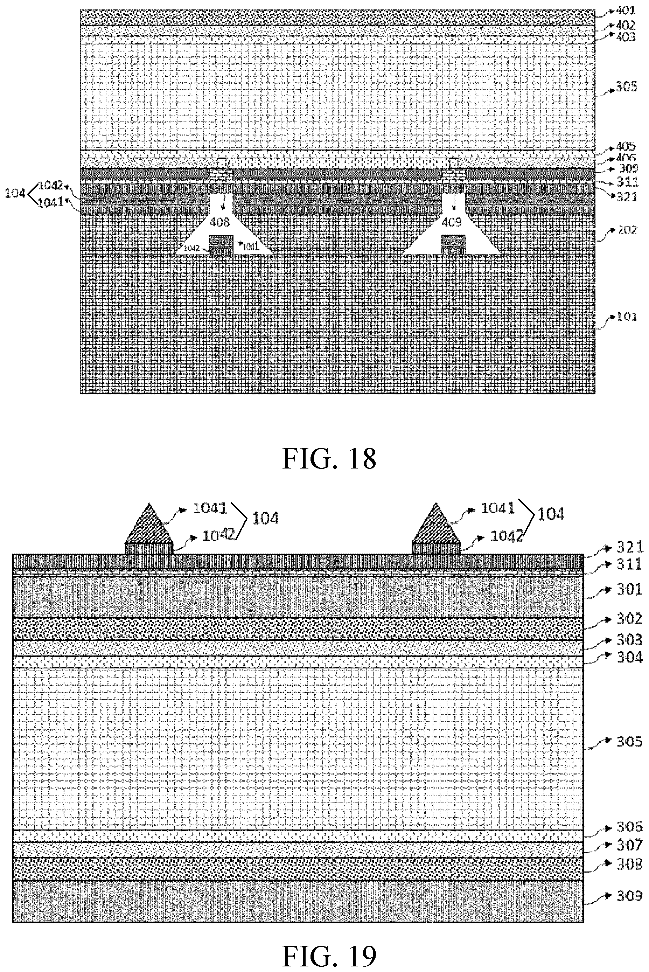

FIG. 16 is a schematic diagram of a first structure in which a second conductive pattern is aligned with a region on which an electrode is to be formed in a first conductive film layer according to an exemplary embodiment of the present invention. FIG. 17 is a schematic diagram of a second structure in which a second conductive pattern is aligned with a region on which an electrode is to be formed in a first conductive film layer according to an exemplary embodiment of the present invention. FIG. 18 is a schematic diagram of a third structure in which a second conductive pattern is aligned with a region on which an electrode is to be formed in a first conductive film layer according to an exemplary embodiment of the present invention. Referring to FIG. 16, FIG. 17, and FIG. 18, the second conductive pattern 104 is aligned with the region on which the electrode is to be formed in the first conductive film layer 321, and the second conductive pattern 104 and the region on which the electrode is to be formed in the first conductive film layer 321 are welded together. A difference between FIG. 16 and FIG. 18 mainly lies in that quantities of second conductive patterns 104 are different, structures of the solar cell bodies are different, and quantities of second conductive sub-patterns in the second conductive patterns 104 are different. A difference between FIG. 16 and FIG. 17 mainly lies in that shapes of the second conductive patterns 104 are different.

Step A4: Remove the imprint template.

The welding transfer of the second conductive pattern 104 located on the imprint template to the first conductive film layer 321 or the first conductive pattern 321 on the solar cell body is implemented, so that the electrode of the solar cell is substantially formed. Then, the imprint template is removed. The imprint template may be removed by using mechanical external force or the like. The manner of removing the imprint template is not specifically limited in the embodiments of the present invention. Removing the imprint template mainly relies on that bonding force between the second conductive pattern 104 and the imprint template is less than welding force between the second conductive pattern 104 and the first conductive film layer 321 or the first conductive pattern 321, to remove the imprint template. Optionally, a coating or the like for making the second conductive pattern 104 easy to be separated from the imprint template may be coated between the imprint template and the second conductive pattern 104, thereby further facilitating removing the imprint template. For example, tin or a tin alloy is provided between the imprint template and the second conductive pattern 104. Tin or the tin alloy has a low melting point, so that the imprint template can be easily removed by heating.

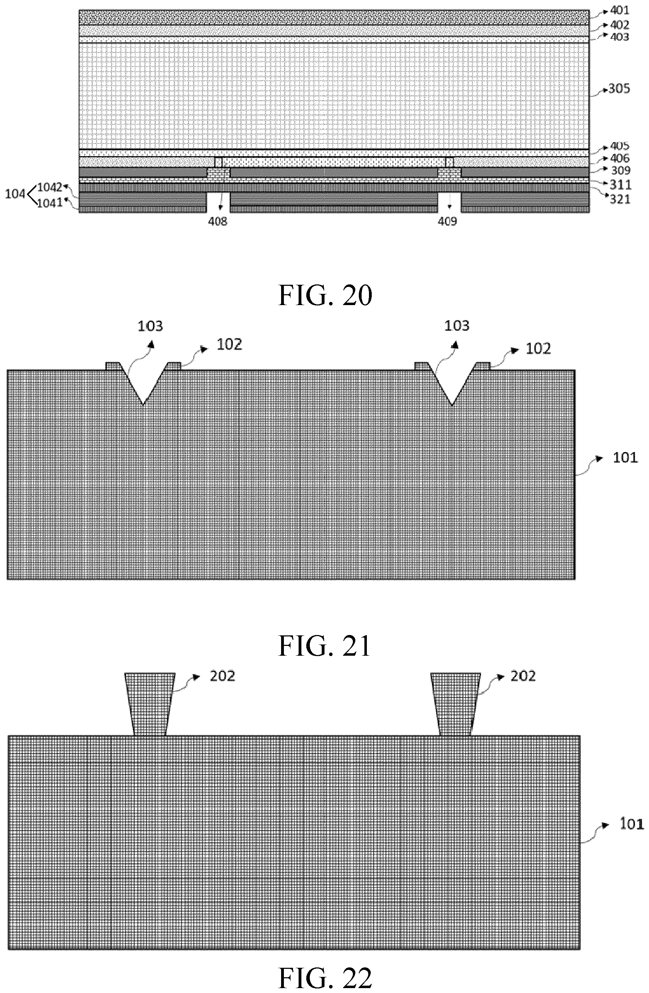

FIG. 19 is a schematic diagram of a local structure of a third HJT solar cell according to an exemplary embodiment of the present invention. FIG. 20 is a schematic diagram of a local structure of a third HBC solar cell according to an exemplary embodiment of the present invention. FIG. 19 and FIG. 20 are schematic diagrams of the solar cell with the imprint template being removed.

It should be noted that, after the imprint template is removed, second conductive pattern residues on the imprint template may be further cleaned by using an acid solution or an alkali solution, so that the imprint template can be reused, thereby further reducing costs. Specifically, whether the imprint template is cleaned by using the acid solution or the imprint template is cleaned by using the alkali solution needs to be determined according to the material of the second conductive pattern. This is not specifically limited in the embodiments.

Step A5: After the forming a first conductive film layer on a solar cell body and the removing the imprint template, the method further includes: removing the first conductive film layer outside the region on which the electrode is to be formed, to form the first conductive pattern.

The first conductive film layer 321 is entirely arranged on the solar cell body, and the first conductive film layer 321 outside the region of the electrode may be removed by using a removal solution corresponding to the material of the first conductive film layer 321, to form the first conductive pattern, thereby avoiding a problem such as a short circuit.

It should be noted that, a concentration and/or removal time of the removal solution may be controlled, to control precision of forming the first conductive pattern, to obtain the first conductive pattern with an appropriate shape. This is not specifically limited in the embodiments.

FIG. 2 to FIG. 5 may be schematic diagrams of structures after the first conductive film layer outside the region of the electrode is removed to form the first conductive pattern 321.

Optionally, before Step A3, the method may further include: annealing the imprint template on which the second conductive pattern 104 has been formed, to cause the second conductive pattern 104 to recrystallize, to eliminate a stress. The annealing is performed on the second conductive pattern 104 on the imprint template, instead of being performed after the second conductive pattern 104 is transferred to the solar cell body. **In** this case, the annealing has no heat effect on the solar cell body, thereby having no adverse effect on the photoelectric conversion efficiency of the solar cell.

Optionally, an annealing temperature ranges from 200°C to 700°C, and annealing time ranges from 0.5 min to 2 min. When the annealing is performed within the temperature range, the stress of the second conductive pattern 104 located on the imprint template is completely relieved, and energy is saved. For example, the annealing temperature is 200°C, and the annealing time is 30s. For another example, the annealing temperature is 700°C, and the annealing time is 2 min. For another example, the annealing temperature is 400°C, and the annealing time is 60s. For another example, the annealing temperature is 700°C, and the annealing time is 45s.

Optionally, an annealing temperature ranges from 500°C to 700°C, and annealing time is 1 min. At the annealing temperature and the annealing time, a relief degree of the stress of the second conductive pattern 104 located on the imprint template and energy saving are well balanced.

The annealing manner may be infrared heating, ultrasonic heating, resistance heating, or the like. This is not specifically limited in the embodiments of the present invention.

Optionally, before the welding, the method may further include: forming a flux pattern on the second conductive pattern; and/or forming a flux pattern on the first conductive part, that is, the first conductive pattern or the region on which the electrode is to be formed in the first conductive film layer, to improve a welding effect. The flux pattern may be formed through coating, deposition, or the like. This is not specifically limited in the embodiments.

Optionally, before the welding, the method may further include: forming a diffusion control pattern on the first conductive part, that is, the first conductive pattern or the region on which the electrode is to be formed in the first conductive film layer; and/or forming a diffusion control pattern on the second conductive pattern, where the diffusion control pattern is used for controlling a thickness of an alloy formed in the welding of the second conductive pattern and the first conductive pattern, to obtain an ideal welded alloy region. For a material, a structure, and the like of the diffusion control pattern, reference may be made to the foregoing descriptions, and the same or similar beneficial effects can be achieved. To avoid repetition, details are not described herein again. A manner of forming the diffusion control pattern may be deposition, coating, or the like.

Optionally, before the forming a first conductive pattern or a first conductive film layer on the solar cell body, the method may further include: forming a bonding pattern or a bonding film layer on the solar cell body, where the bonding pattern or the bonding film layer is used for improving bonding force between the first conductive pattern and the solar cell body; and the forming a first conductive pattern may include: forming the first conductive pattern on the bonding pattern or the bonding film layer. Forming the bonding film layer herein means forming the entire bonding film layer on the solar cell body. After the entire bonding film layer is patterned, the bonding pattern is obtained. A manner of forming the bonding pattern may also include: first, forming the entire bonding film layer on the solar cell body through screen printing, electroplating, deposition, or the like; and then forming a mask on the bonding film layer, patterning the mask, and then performing wet etching, to obtain the bonding pattern; or patterning the bonding film layer by using laser, to obtain the bonding pattern. This is not specifically limited in the embodiments. For a material and the like of the bonding pattern, reference may be made to the foregoing descriptions, and the same or similar beneficial effects can be achieved. To avoid repetition, details are not described herein again.

For example, referring to FIG. 7 and FIG. 9, before the forming a first conductive film layer 321 on the solar cell body, the method may further include: forming a bonding film layer 311 on the solar cell body. Referring to FIG. 8 and FIG. 10, the forming a first conductive film layer 321 includes: forming the first conductive film layer 321 on the bonding film layer 311. After the welding, the method may further include: removing the bonding film layer 311 outside a region of the electrode, to form a bonding pattern 311, to avoid a short circuit and the like as much as possible. When the bonding film layer 311 outside the region of the electrode is removed, a removal solution corresponding to a material of the bonding film layer 311 may also be selected. A concentration and/or removal time of the removal solution are controlled, to obtain the bonding pattern 311 with a precise shape.

FIG. 21 is a schematic diagram of a structure of a first imprint template according to an exemplary embodiment of the present invention. Optionally, referring to FIG. 21, the imprint template includes a first groove 103. Referring to FIG. 11 and FIG. 12, Step A2 may include: forming the second conductive pattern 104 in the first groove 103 of the imprint template, where the second conductive pattern 104 is flush with a surface of a side of the imprint template provided with the first groove 103, or protrudes from the surface of the side of the imprint template provided with the first groove 103. **In** this way, in a process of welding the second conductive pattern 104 to the first conductive pattern 321 or the region on which the electrode is to be formed in the first conductive film layer 321, the second conductive pattern 104 can come into contact with the first conductive pattern 321 or the region on which the electrode is to be formed in the first conductive film layer 321. The first groove 103 is used as a gate line plate corresponding to the second conductive pattern 104, to form the second conductive pattern 104 with a precise shape. The second conductive pattern may be formed in the first groove 103 of the imprint template through electroplating, deposition, or the like. This is not specifically limited in the embodiments. It should be noted that, if the deposition manner is selected, after the deposition is completed, the second conductive film layer outside the first groove 103 further needs to be etched away.

For example, the first groove 103 is provided inward on a partial region of a surface of a substrate 101, to form the imprint template. Referring to FIG. 17, in a process of implementing the welding transfer of the second conductive pattern 104 to the region on which the electrode is to be arranged in the first conductive film layer 321 on the solar cell body, the surface of the substrate may be a surface of the substrate 101 close to the solar cell body. If the second conductive pattern 104 is formed in the first groove 103 through electroplating, a surface of the first groove 103 needs to be a conductive surface, and remaining surfaces of the substrate 101 are all non-conductive surfaces. A non-conductive hard substrate or flexible substrate may be selected. A conductive substance is deposited on the hard substrate or the flexible substrate, and a part of the conductive substance away from the hard substrate or the flexible substrate is oxidized into a non-conductive substance, to form the substrate 101. Then, the first groove 103 is provided inward on the non-conductive substance, so that the conductive substance under the non-conductive substance at a groove bottom of the first groove 103 is exposed. The exposed conductive substance is used as a cathode for the electroplating, and the remaining surfaces of the substrate 101 are all the non-conductive surfaces and are not electroplated during the electroplating, to form the imprint template. A size of the first groove 103 is not specifically limited. For example, a notch of the first groove 103 may be strip-shaped, and a width of the notch of the first groove 103 may be 10 µm.

The hard substrate or the flexible substrate herein only needs to have a specific support degree, and both a thickness and a material of the substrate are not specifically limited. Materials of the conductive substance and the non-conductive substance are also not specifically limited. For example, the hard substrate may be ceramic with a thickness of 5 nm. An aluminum layer may be deposited on the ceramic of 5 nm. For example, the aluminum layer of 20 µm is formed through sputtering or evaporation. Then, the aluminum layer is oxidized, so that a part of the thickness of the aluminum layer away from the ceramic is oxidized into aluminum oxide, and a remaining aluminum layer close to the ceramic is not oxidized. Thicknesses of the oxidized aluminum layer and the non-oxidized aluminum layer are not specifically limited herein. For example, the thickness of the oxidized aluminum layer may be 10 µm, and the thickness of the non-oxidized aluminum layer is 10 µm. Then, the groove may be etched by using laser, so that a part of aluminum oxide is removed until the aluminum layer is exposed. During the electroplating, aluminum oxide is not electroplated, and only the aluminum layer at the groove bottom of the first groove 103 is electroplated.

Optionally, referring to FIG. 21, the imprint template further includes the substrate 101, the first groove 103 is arranged on the substrate 101, and the imprint template further includes a first boss 102 arranged on the substrate 101 and located on an edge of the first groove 103. Referring to FIG. 11 and FIG. 12, the forming the second conductive pattern 104 in the first groove 103 of the imprint template includes: forming the second conductive pattern 104 in the first groove 103 of the imprint template and in a region defined by the first boss 102, where the second conductive pattern 104 is flush with a surface of the first boss 102 away from the substrate 101, or protrudes from the surface of the first boss 102 away from the substrate 101. Referring to FIG. 17, the first boss 102 protrudes from the substrate 101. Therefore, during aligning and welding between the region on which the electrode is to be arranged in the first conductive film layer 321 and the second conductive pattern 104, only a part of the second conductive pattern 104 protruding from the surface of the first boss 102 away from the substrate 101 or only a part of the second conductive pattern 104 flush with the surface of the first boss 102 away from the substrate 101 is in contact with the region on which the electrode is to be arranged in the first conductive film layer 321, and a remaining part of the imprint template is not in contact with the first conductive film layer 321. In this way, the first conductive film layer 321 or the solar cell body cannot be polluted, and the imprint template cannot press against the first conductive film layer 321 or the solar cell body.

It should be noted that, the second conductive pattern is not formed on the surface of the first boss 102 away from the substrate 101, so that a waste can be reduced, and a current loss can be reduced. More specifically, if the second conductive pattern is formed on the surface of the first boss 102 away from the substrate 101, a projection of the part of the second conductive pattern on a surface of the substrate 101 close to the first boss 102 does not coincide with a projection of the second conductive pattern located in the first groove 103 and in the region defined by the first boss 102 on the surface of the substrate 101 close to the first boss 102, and carriers collected on the part need to be transported in a direction parallel to the width of the notch of the first groove 103 to be exported. A transport path of the carriers is long, resulting in a specific current loss. Therefore, in some examples, the second conductive pattern is not formed on the surface of the first boss 102 away from the substrate 101. In this way, a current loss can be reduced, and a waste of the material of the second conductive pattern can be reduced. An implementation in which the second conductive pattern is not formed on the surface of the first boss 102 away from the substrate 101 may be as follows: In a process of depositing the second conductive pattern, the second conductive pattern is also deposited on the surface of the first boss 102 away from the substrate 101, then a mask is arranged, the mask is patterned, and the second conductive pattern formed on the surface of the first boss 102 away from the substrate 101 is removed through wet etching. Alternatively, in a process of depositing the second conductive pattern, the second conductive pattern is also deposited on the surface of the first boss 102 away from the substrate 101, and the second conductive pattern formed on the surface of the first boss 102 away from the substrate 101 is removed through laser etching. Alternatively, the region defined by two sides of the first boss 102 is configured as a conductive surface, and the surface of the first boss 102 away from the substrate 101 is configured as a non-conductive surface. **In** a specific implementation, a conductive substance may be selected as a part of the first boss 102 close to the substrate 101. Then, a non-conductive substance is arranged on the part of the first boss 102 close to the substrate 101 through deposition, coating, or the like. Then, the non-conductive substance in the region defined by the two sides of the first boss 102 is etched, so that the region defined by the two sides of the first boss 102 is a conductive surface, and the surface of the first boss 102 away from the substrate 101 is a non-conductive surface. During electroplating, the second conductive pattern can be electroplated on the region defined by the two sides of the first boss 102, which is a conductive surface and serves as a cathode, and the second conductive pattern cannot be electroplated on the surface of the first boss 102 away from the substrate 101.

It should be noted that, the first boss 102 and the substrate 101 may be integrally formed, or the first boss 102 and the substrate 101 are separately manufactured; and then the first boss 102 and the substrate 101 are fixedly connected together by using an adhesive layer or the like. This is not specifically limited in the embodiments.

Optionally, referring to FIG. 21, in a direction from the notch of the first groove 103 to the groove bottom of the first groove 103, an area of a cross section of the first groove 103 gradually decreases, where the cross section of the first groove 103 is perpendicular to the lamination direction of the first conductive pattern 321 and the second conductive pattern 104. Further, in the direction from the notch of the first groove 103 to the groove bottom of the first groove 103, an area of a cross section of the formed second conductive pattern 104 also gradually decreases, to facilitate reducing shading and reflection.

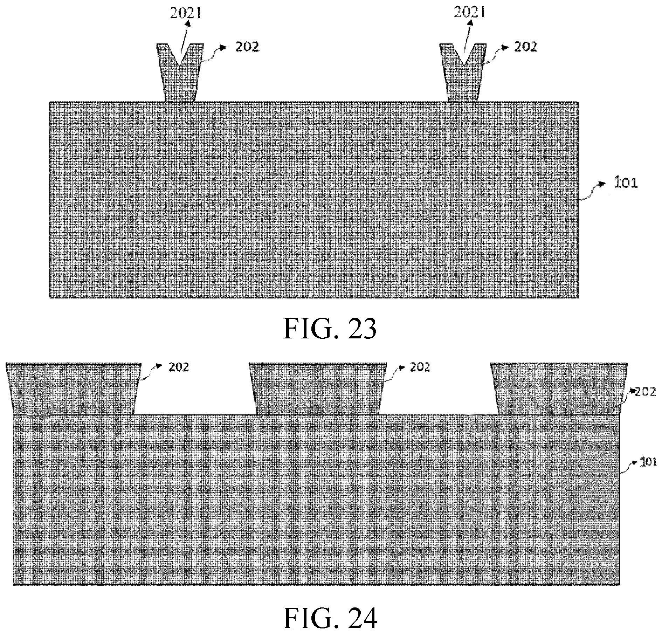

FIG. 22 is a schematic diagram of a structure of a second imprint template according to an exemplary embodiment of the present invention. FIG. 23 is a schematic diagram of a structure of a third imprint template according to an exemplary embodiment of the present invention. FIG. 24 is a schematic diagram of a structure of a fourth imprint template according to an exemplary embodiment of the present invention. Optionally, referring to FIG. 22 to FIG. 24, the imprint template includes the substrate 101 and a second boss 202 located on the substrate 101. A quantity of second bosses 202 on the substrate 101 is not specifically limited. For example, in the imprint template shown in FIG. 22, there are two second bosses 202 on the substrate 101; and in the imprint template shown in FIG. 23, there are three second bosses 202 on the substrate 101. It should be noted that, the substrate 101 and the second boss 202 may be formed once or separately. This is not specifically limited in the embodiments. Referring to FIG. 13 and FIG. 14, Step A2 may include: forming a second conductive film layer 104 on a side of the imprint template on which the second boss 202 is formed, where a part of the second conductive film layer 104 located on the second boss 202 is the second conductive pattern. For that the second conductive film layer 104 is formed through deposition, electroplating, or the like, a height difference between the second boss 202 and the substrate 101 may be used to disconnect the part of the second conductive film layer 104 located on the second boss 202 from a part of the second conductive film layer 104 located on the substrate 101. In this way, after the second conductive pattern 104 is aligned with the first conductive pattern 321 or the region on which the electrode is to be arranged in the first conductive film layer 321, it can be ensured that only the part of the second conductive film layer 104 located on the second boss 202 is in contact with the first conductive pattern 321, to facilitate aligning the second conductive pattern 104 with the first conductive pattern 321; and the part of the second conductive film layer 104 located on the substrate 101 is not in contact with the first conductive pattern 321 or the region on which the electrode is to be arranged in the first conductive film layer 321, so that pollution on the first conductive film layer 321 or the solar cell body can be reduced. In addition, only the second boss 202 in the imprint template is in indirect contact with the first conductive film layer 321 or the solar cell body, and a remaining part of the imprint template is not in contact with the first conductive film layer 321 or the solar cell body, to facilitate removing the imprint template.

The second conductive film layer 104 herein may be a metal foil, and Step A3 may include: laying the metal foil on the side of the imprint template on which the second boss 202 is formed, where a part of the metal foil located on the second boss 202 is the second conductive pattern 104. A part of the metal foil located outside the second boss 202 may be adsorbed on the substrate 101 through lamination, or the like, to avoid displacement of the metal foil. For example, pressing may be performed by using a roller. After the pressing, a surface of the metal foil may be further cleaned, to reduce pollution of a pressing substance on the surface of the metal foil, and the like. This is not specifically limited in the embodiments of the present invention. Similarly, the part of the metal foil located outside the second boss 202 is adsorbed on the substrate 101. **In** this way, after the second conductive pattern 104 is aligned with the first conductive pattern 321 or the region on which the electrode is to be arranged in the first conductive film layer 321, it can be ensured that only the part of the second conductive film layer 104 located on the second boss 202 is in contact with the first conductive pattern 321, to facilitate aligning the second conductive pattern 104 with the first conductive pattern 321; and the part of the second conductive film layer 104 located on the substrate 101 is not in contact with the first conductive pattern 321 or the region on which the electrode is to be arranged in the first conductive film layer 321, so that pollution on the first conductive film layer 321 or the solar cell body can be reduced. **In** this case, the part of the metal foil located on the second boss 202 and the part of the metal foil located outside the second boss 202 may not be disconnected before the welding, and may be disconnected after the welding. A material of the metal foil herein may be the same as the material of the second conductive pattern 104 described above. To avoid repetition, details are not described herein again. For example, the metal foil may be a copper foil.

Small burrs or the like may be provided on a surface of the second boss 202 away from the substrate 101. The small burrs or the like may hang the metal foil, so that the second conductive pattern is not prone to positional deviation or the like during aligning and welding between the second conductive pattern and the first conductive pattern or the region on which the electrode is to be arranged in the first conductive film layer. The material of the metal foil herein is the same as or similar to the material of the second conductive pattern described above. For example, the metal foil may be a copper foil.

Optionally, referring to FIG. 22 or FIG. 24, the surface of the second boss 202 away from the substrate 101 is a plane, so that a surface of the formed second conductive pattern 104 close to the second boss 202 is also a plane.

Alternatively, optionally, referring to FIG. 23, a side of the second boss 202 away from the substrate 101 includes a second groove 2021. The forming a second conductive pattern on an imprint template includes: forming the second conductive pattern in the second groove 2021. A surface of the second groove 2021 on the first boss 202 herein is used as a gate line plate. For example, an area of a cross section of the second groove 2021 gradually decreases in a direction close to the substrate 101, so that in the finally formed solar cell, an area of a cross section of a part of the second conductive pattern 104 away from the solar cell body gradually decreases in a direction away from the solar cell body, so that reflection and shading can be reduced. The second conductive pattern is flush with a notch of the second groove 2021, or protrudes from the second groove 2021.

Optionally, the imprint template may include a substrate, and Step A2 may include: laying a metal foil on the substrate, and patterning the metal foil, to form the second conductive pattern. **In** other words, the metal foil is entirely laid on the substrate, and then the metal foil is patterned through laser etching or the like, to form the second conductive pattern. A material or the like of the metal foil may also be the same as the material of the second conductive pattern 104 or the second conductive film layer 104 described above. To avoid repetition, details are not described herein again.

Optionally, before Step A2, the method may further include: providing a plurality of metal foil patterns; the imprint template may include a plurality of adsorption regions; and Step A2 may include: at least aligning one of the adsorption regions with one of the metal foil patterns, and adsorbing the metal foil pattern on the adsorption region, to form the second conductive pattern on the imprint template. For example, the imprint template may include the substrate and a plurality of adsorption regions arranged on the substrate at intervals. At least one of the adsorption regions is aligned with one of the metal foil patterns, and the metal foil pattern is adsorbed on the adsorption region, to form the second conductive pattern on the substrate. The adsorption region herein may be located on a local region on a surface of the substrate. Alternatively, for example, a boss is provided on the substrate, adsorption regions are provided on the boss, at least one of the adsorption regions on the boss is aligned with one of metal foil patterns, and the metal foil pattern is adsorbed on the adsorption region, to form the second conductive pattern on the boss of the substrate. For the aligning herein, reference may be made to the definition of the aligning described above. To avoid repetition, details are not described herein again.

For example, the substrate may be a hollow structure, and a vacuum adsorption component, a magnet, or the like may be locally arranged in the hollow structure of the substrate. The metal foil pattern is absorbed by using the vacuum adsorption component, the magnet, or the like. A specific absorption manner is not specifically limited in the embodiments of the present invention.

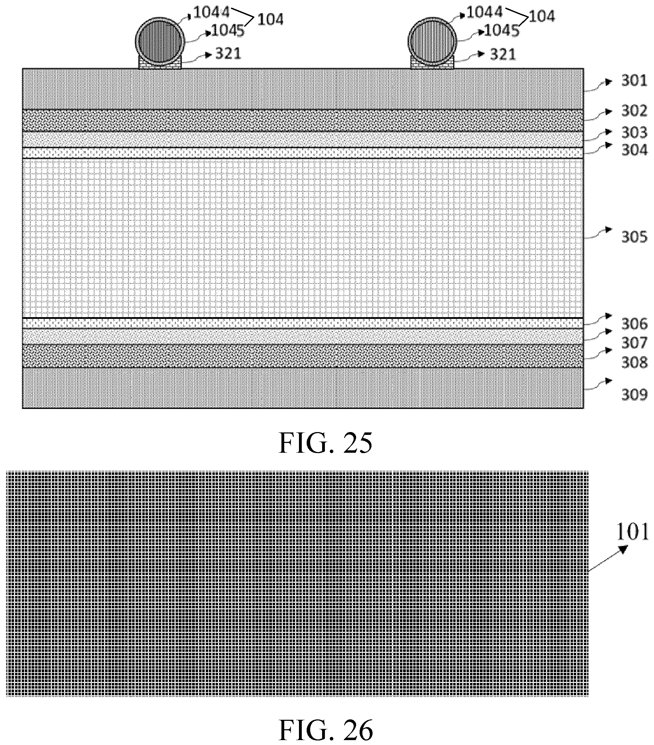

FIG. 25 is a schematic diagram of a structure of a fourth HJT solar cell according to an exemplary embodiment of the present invention. Optionally, referring to FIG. 25, the second conductive pattern 104 may also be a metal wire 1044. A shape, a size, and the like of the metal wire 1044 are all not specifically limited. For example, a wire diameter of the metal wire 1044 may range from 10 µm to 50 µm, and a length of the metal wire 1044 may range from 10 µm to 1000 µm. A material of the metal wire 1044 may be the same as the material of the second conductive pattern described above, and details are not described herein again. For example, the material of the metal wire 1044 may be copper or aluminum.

Optionally, referring to FIG. 25, a surface of the metal wire 1044 may be further coated with a coating 1045. A material of the coating 1045 may include nickel, tin, a conductive adhesive, or the like. The coating 1045 made of the foregoing material has good conductivity performance, which can appropriately reduce contact resistance and the like between the metal wire 1044 and the first conductive pattern 321 or the first conductive film layer 321. A thickness of the coating 1045 is not specifically limited. For example, the thickness of the coating 1045 may range from 1 µm to 10 µm.

The metal wire may be arranged in the first groove 103 or the second groove 2021 of the imprint template, so that the metal wire can be stuck. After the metal wire is stuck, the metal wire is flush with the notches of the first groove 103 and the second groove 2021, or the metal wire protrudes from the notches of the first groove 103 and the second groove 2021, to form the second conductive pattern on the imprint template.

It should be noted that, if an entire metal foil is laid on the solar cell body, after welding, due to a high welding temperature during the welding, the metal foil may be partially damaged at a welding boundary, and the like. Therefore, a manner of removing the metal foil outside the region of the electrode may include: blowing the part away by airflow, sticking the part away by using a viscous material, or the like. This is not specifically limited in the embodiments.

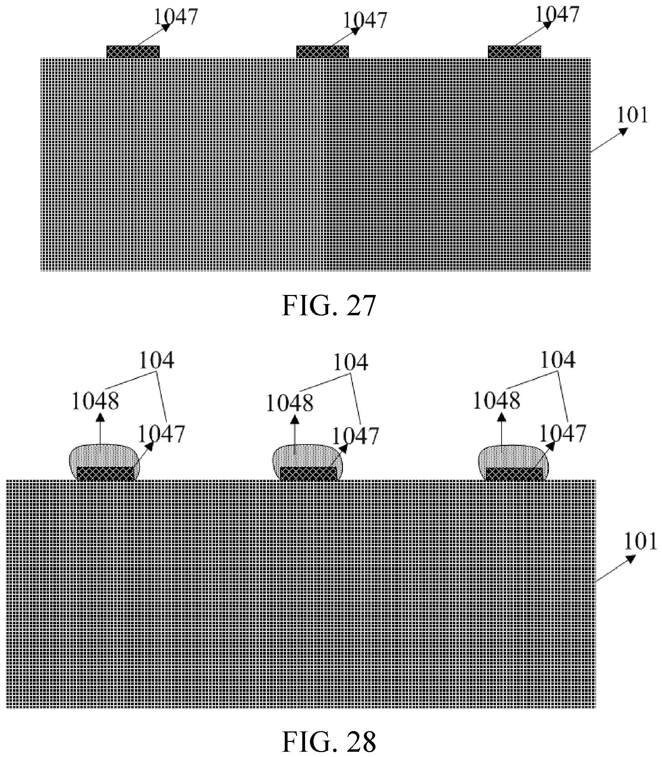

FIG. 26 is a schematic diagram of a structure of a fifth imprint template according to an exemplary embodiment of the present invention. FIG. 27 is a schematic diagram of a sixth local structure forming a second conductive pattern according to an exemplary embodiment of the present invention. FIG. 28 is a schematic diagram of a seventh local structure forming a second conductive pattern according to an exemplary embodiment of the present invention. Optionally, referring to FIG. 27 to FIG. 28, Step A2 may include: forming a seed pattern 1047 on the imprint template; and forming a plating pattern 1048 on the seed pattern 1047 through electroplating or chemical plating, where the plating pattern 1048 and the seed pattern 1047 together form the second conductive pattern 104. A function of the imprint template herein is mainly to provide a carrying table for forming the seed pattern 1047. Therefore, a structure of the imprint template is not limited. For example, referring to FIG. 26, the imprint template may include only the substrate 101. The seed pattern 1047 may be formed through deposition, printing, or the like. A manner of forming the seed pattern 1047 is not limited. A material of the plating pattern 1048 may be a material suitable for electroplating or chemical plating. For example, the material of the plating pattern 1048 is nickel. A material of the seed pattern 1047 can be used as a material of the seed layer. For example, the material of the seed pattern 1047 may be copper. In Step A3, the plating pattern 1048 in the second conductive pattern 104 is aligned with the first conductive part, and the plating pattern 1048 in the second conductive pattern 104 and the first conductive part are welded together. The second conductive pattern 104 is formed in flexible and diverse manners.

For example, referring to FIG. 28, in the direction parallel to the lamination direction of the solar cell body and the first conductive pattern 321, the second conductive pattern 104 is formed by the seed layer pattern 1047 and the plating pattern 1048 that are laminated, where the plating pattern 1048 is closer to the solar cell body than the seed layer pattern 1047 is, and the plating pattern 1048 wraps the seed layer pattern 1047. For the materials of the plating pattern 1048 and the seed layer pattern 1047, reference may be made to the foregoing related descriptions.

### Embodiment 2

Embodiment 2 provides another solar cell. The solar cell includes a solar cell body, and a positive electrode and a negative electrode arranged on the solar cell body, where a structure of the positive electrode and a structure of the negative electrode may be the same or may be different. An electrode (where the electrode may be the positive electrode or the negative electrode) of the solar cell includes a second conductive pattern laminated on the solar cell body, where the second conductive pattern is welded to the solar cell body.

For the solar cell body, reference is made to the related descriptions in Embodiment 1. To avoid repetition, details are not described herein again. For example, the solar cell body herein may be a silicon substrate. If a passivation layer or the like is further arranged on the solar cell body, the passivation layer may be grooved, so that the silicon substrate is exposed.

The second conductive pattern is welded to the solar cell body. The welding process is simple and mature, and mass production is easy to be implemented. In addition, the welding features a low bonding temperature and high bonding strength. The low bonding temperature can reduce a heat effect on the solar cell body, thereby having little effect on photoelectric conversion efficiency of the solar cell. The high bonding strength can make the electrode of the solar cell have good reliability. In addition, during the welding, a material of the second conductive pattern can be welded to the solar cell body, is not limited to a silver paste, and has more material selections; and compared with the silver paste, selecting copper, tin, or the like can appropriately reduce costs. In addition, the silver paste is granular, resulting in little contact between silver particles; and the silver paste includes an organic component, and the organic component also affects the contact between the silver particles. In this way, an electrode made of a silver paste has high resistivity and poor conductivity performance. However, in this embodiment of the present invention, a material of the electrode may not be granular (for example, a silver paste), and the material of the electrode may be, for example, silver, copper, tin, or an alloy thereof, so that the electrode has good conductivity performance. In addition, because a second conductive pattern 104 may not be prepared on the solar cell body, a process of preparing the second conductive pattern has little or substantially no effect on the solar cell body, and mass production is easy to be implemented. Therefore, preparation costs can be reduced.

It should be noted that, the material of the second conductive pattern may be a material that can be welded to the solar cell body. The material of the second conductive pattern is not specifically limited. For example, the material of the second conductive pattern may include nickel or aluminum. For example, the material of the second conductive pattern may be singular nickel or a nickel alloy, or the material of the second conductive pattern may be aluminum. The material of the second conductive pattern can be welded to the solar cell body at a temperature of about 800°C to 900°C. The welding process is simple and mature, and mass production is easy to be implemented. In addition, the bonding temperature of about 800°C to 900°C can reduce the heat effect on the solar cell body. In addition, the high bonding strength of the welding can make the electrode of the solar cell have the good reliability.

In addition, compared with screen printing, the second conductive pattern can be welded to the solar cell body, and is not limited to a silver paste. Therefore, costs can be appropriately reduced. In addition, compared with laser transfer printing, in the present invention, the second conductive pattern and the solar cell body are welded together. The welding process is mature, and process difficulty is relatively low, so that production efficiency can be appropriately improved. Compared with electroplating, in the present invention, the second conductive pattern and the solar cell body can be welded together. In this way, there is no process problem such as winding plating for the solar cell body, the yield and the reliability are good, and mass production is easy to be implemented.

Optionally, in a direction parallel to a lamination direction of the solar cell body and a first conductive pattern 321, the second conductive pattern 104 includes a seed layer pattern and a plating pattern that are laminated, where the plating pattern is closer to the solar cell body than the seed layer pattern is, and the plating pattern wraps the seed layer pattern. For the descriptions herein, reference may be correspondingly made to the related descriptions in Embodiment 1, and the same or similar beneficial effects can be achieved. To avoid repetition, details are not described herein again.

Optionally, for a shape, a thickness, the structure, and the like of the second conductive pattern in Embodiment 2, reference may be correspondingly made to the related descriptions in Embodiment 1, and the same or similar beneficial effects can be achieved. To avoid repetition, details are not described herein again.

Optionally, the solar cell may further include a diffusion control pattern located between the second conductive pattern and the solar cell body, where the diffusion control pattern is used for controlling a thickness of an alloy formed in the welding of the second conductive pattern and the solar cell body, to obtain an ideal interface alloy region, and avoid a possible effect on the solar cell body during the welding. For a material, a structure, and the like of the diffusion control pattern, reference may be made to the related descriptions in Embodiment 1, and the same or similar beneficial effects can be achieved. To avoid repetition, details are not described herein again.

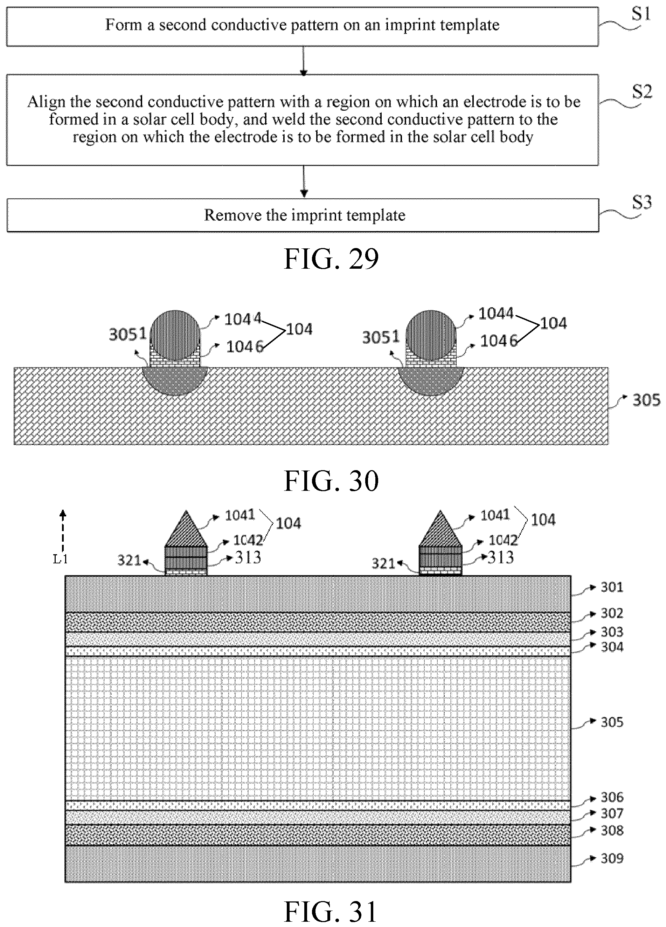

Embodiment 2 further provides a method for preparing a solar cell, which can be used to prepare the solar cell in Embodiment 2. FIG. 29 is a flowchart of steps of another method for preparing a solar cell according to an exemplary embodiment of the present invention. Referring to FIG. 29, the method for preparing a solar cell includes the following steps.

Step S1: Form a second conductive pattern on an imprint template.

For Step S1, reference may be made to the related descriptions in Embodiment 1, and the same or similar beneficial effects can be achieved. To avoid repetition, details are not described herein again.

Step S2: Align the second conductive pattern with a region on which an electrode is to be formed in a solar cell body, and weld the second conductive pattern to the region on which the electrode is to be formed in the solar cell body.

For the aligning in Step S2, reference may also be made to the related descriptions in Embodiment 1. To avoid repetition, details are not described herein again. In Step S2, the second conductive pattern is transferred to the solar cell body.

Step S3: Remove the imprint template.

For Step S3, reference may be made to the related descriptions in Embodiment 1, and the same or similar beneficial effects can be achieved. To avoid repetition, details are not described herein again.

Optionally, before the welding, the method may further include: annealing the imprint template on which the second conductive pattern has been formed, to cause the second conductive pattern to recrystallize, to eliminate a stress. For an annealing temperature, annealing time, an annealing manner, and the like, reference may be correspondingly made to the related descriptions in Embodiment 1, and the same or similar beneficial effects can be achieved. To avoid repetition, details are not described herein again.

Optionally, before the welding, the method may further include: forming a diffusion control pattern on the second conductive pattern; and/or forming a diffusion control pattern on the region on which the electrode is to be formed in the solar cell body, where the diffusion control pattern is used for controlling a thickness of an alloy formed in the welding of the second conductive pattern and the region on which the electrode is to be formed in the solar cell body, to obtain an ideal welded alloy region. For a material, a structure, a forming manner, and the like of the diffusion control pattern, reference may be correspondingly made to the related descriptions in Embodiment 1, and the same or similar beneficial effects can be achieved. To avoid repetition, details are not described herein again.

Optionally, referring to FIG. 21, the imprint template includes a first groove 103. Referring to FIG. 11 and FIG. 12, Step S1 may include: forming a second conductive pattern 104 in the first groove 103 of the imprint template, where the second conductive pattern 104 is flush with a surface of a side of the imprint template provided with the first groove 103, or protrudes from the surface of the side of the imprint template provided with the first groove 103. For that the second conductive pattern is formed in the first groove 103 of the imprint template, reference may be made to the related descriptions in Embodiment 1, and the same or similar beneficial effects can be achieved. To avoid repetition, details are not described herein again.

Optionally, referring to FIG. 21, the imprint template further includes a substrate 101, the first groove 103 is arranged on the substrate 101, and the imprint template may further include a first boss 102 arranged on the substrate 101 and located on an edge of the first groove 103. Step S1 may include: forming the second conductive pattern 104 in the first groove 103 and in a region defined by the first boss 102, where the second conductive pattern 104 is flush with a surface of the first boss 102 away from the substrate 101, or protrudes from the surface of the first boss 102 away from the substrate 101. For the descriptions herein, reference may also be made to the related descriptions in Embodiment 1, and the same or similar beneficial effects can be achieved. To avoid repetition, details are not described herein again.

Optionally, referring to FIG. 21, in a direction from a notch of the first groove 103 to a groove bottom of the first groove 103, an area of a cross section of the first groove 103 gradually decreases, where the cross section of the first groove 103 is perpendicular to a lamination direction of the second conductive pattern and the solar cell body. Further, in the direction from the notch of the first groove 103 to the groove bottom of the first groove 103, an area of a cross section of the formed second conductive pattern also gradually decreases, to facilitate reducing shading and reflection. For the descriptions herein, reference may also be made to the related descriptions in Embodiment 1, and the same or similar beneficial effects can be achieved. To avoid repetition, details are not described herein again.

Optionally, referring to FIG. 22 to FIG. 24, the imprint template includes a substrate 101 and a second boss 202 located on the substrate 101. A quantity of second bosses 202 on the substrate 101 is not specifically limited. Referring to FIG. 13 and FIG. 14, Step S1 may include: forming the second conductive pattern on a side of the imprint template on which the second boss 202 is formed. For a manner of forming the second conductive pattern, the quantity of second bosses, and the like, reference may be correspondingly made to the related descriptions in Embodiment 1, and the same or similar beneficial effects can be achieved. To avoid repetition, details are not described herein again.

Optionally, a surface of the second boss 202 away from the substrate 101 is a plane; or optionally, a side of the second boss 202 away from the substrate 101 includes a second groove 2021, where the second conductive pattern 104 is flush with a notch of the second groove 2021, or protrudes from the second groove 2021. For the descriptions herein, reference may be correspondingly made to the related descriptions in Embodiment 1, and the same or similar beneficial effects can be achieved. To avoid repetition, details are not described herein again.

Optionally, referring to FIG. 22 to FIG. 24, the imprint template includes a substrate 101, and Step S1 may include: laying a metal foil on the substrate, and patterning the metal foil, to form the second conductive pattern. For the descriptions herein, reference may be correspondingly made to the related descriptions in Embodiment 1, and the same or similar beneficial effects can be achieved. To avoid repetition, details are not described herein again.

Optionally, before Step S1, the method may further include: providing a plurality of metal foil patterns; the imprint template may include a plurality of adsorption regions; and Step S1 may include: at least aligning one of the adsorption regions with one of the metal foil patterns, and adsorbing the metal foil pattern on the adsorption region, to form the second conductive pattern on the imprint template. For example, the imprint template may include the substrate and a plurality of adsorption regions arranged on the substrate at intervals. Step S1 may include: at least aligning one of the adsorption regions with one of the metal foil patterns, and adsorbing the metal foil pattern on the adsorption region, to form the second conductive pattern on the substrate. Alternatively, for example, a boss is provided on the substrate, adsorption regions are provided on the boss, at least one of the adsorption regions on the boss is aligned with one of metal foil patterns, and the metal foil pattern is adsorbed on the adsorption region, to form the second conductive pattern on the boss of the substrate. For the descriptions herein, reference may be correspondingly made to the related descriptions in Embodiment 1, and the same or similar beneficial effects can be achieved. To avoid repetition, details are not described herein again.

FIG. 30 is a schematic diagram of a local structure of a first solar cell according to an exemplary embodiment of the present invention. Optionally, referring to FIG. 30, a material of the second conductive pattern 104 is aluminum, and the second conductive pattern 104 is in contact with a silicon substrate 305 of the solar cell body. Step S2 may include that in a process of welding the second conductive pattern 104 to the region on which the electrode is to be formed in the solar cell body, a part of aluminum in the second conductive pattern 104 diffuses into a region on which the electrode is to be formed in the silicon substrate 305, to dope the region on which the electrode is to be formed in the silicon substrate 305 to form a P-type doped region 3051, and use a remaining part of the second conductive pattern 104 as the electrode. In other words, based on the shape of the second conductive pattern 104 made of aluminum, a distribution position of the second conductive pattern 104 made of aluminum on the solar cell body, and a temperature during the welding, in a process of transferring the second conductive pattern 104 made of aluminum to the solar cell body, local P-type doping of the silicon substrate 305 is also implemented, so that a step of specially performing the local P-type doping is not required, and production efficiency can be improved. The part of aluminum in the second conductive pattern 104 diffuses into the region on which the electrode is to be formed in the silicon substrate 305 by using a contact position between the second conductive pattern and the silicon substrate 305 as a center. It should be noted that, when the part of aluminum in the second conductive pattern 104 diffuses into the region on which the electrode is to be formed in the silicon substrate 305, a formed P-type doping concentration is not specifically limited.

Optionally, referring to FIG. 30, the second conductive pattern 104 made of aluminum may also be an aluminum metal wire 1044. A shape, a size, and the like of the aluminum metal wire 1044 are also not specifically limited.

Optionally, referring to FIG. 26 to FIG. 28, Step S1 may include: forming a seed pattern 1047 on the imprint template; and forming a plating pattern 1048 on the seed pattern 1047 through electroplating or chemical plating, where the plating pattern 1048 and the seed pattern 1047 together form a second conductive pattern 104. A function of the imprint template herein is mainly to provide a carrying table for forming the seed pattern. For the descriptions herein, reference may be correspondingly made to the related descriptions in Embodiment 1, and the same or similar beneficial effects can be achieved. To avoid repetition, details are not described herein again.

Optionally, Step S1 may include: forming at least two aluminum conductive sub-patterns laminated on the imprint template. In the process of aligning the second conductive pattern 104 with the region on which the electrode is to be formed in the solar cell body, an aluminum conductive sub-pattern located on a side of the second conductive pattern 104 away from the imprint template is in direct contact with the silicon substrate 305. Therefore, in the process in which the part of aluminum in the second conductive pattern 104 made of aluminum diffuses into the silicon substrate 305, the aluminum conductive sub-pattern located on the side of the second conductive pattern 104 away from the imprint template preferentially diffuses into the silicon substrate 305. Under a specific welding heat, a remaining aluminum conductive sub-pattern may partially diffuse into the silicon substrate 305 or may not diffuse into the silicon substrate 305. In other words, during the diffusion, the aluminum conductive sub-pattern located on the side of the second conductive pattern 104 away from the imprint template is equivalent to appropriately protecting the remaining aluminum conductive sub-pattern, so that the remaining aluminum conductive sub-pattern has little diffusion, so that a shape of the remaining aluminum conductive sub-pattern has little deformation. The remaining aluminum conductive sub-pattern is used as the electrode, which can ensure precision of the formed electrode.

For example, referring to FIG. 30, the second conductive pattern 104 includes at least two aluminum conductive sub-patterns. An aluminum conductive sub-pattern farthest away from the silicon substrate in the at least two aluminum conductive sub-patterns may be an aluminum metal wire 1044. A shape, a size, and the like of the aluminum metal wire 1044 are also not specifically limited. An aluminum conductive sub-pattern farthest away from the imprint template in the at least two aluminum conductive sub-patterns may be an aluminum paste sub-pattern 1046. During the welding, the aluminum paste sub-pattern 1046 located on a side of the aluminum metal wire 1044 away from the imprint template is in direct contact with the silicon substrate 305. Therefore, in the process in which the part of aluminum in the second conductive pattern 104 made of aluminum diffuses into the silicon substrate 305, the aluminum paste sub-pattern 1046 preferentially diffuses into the silicon substrate 305. Under a specific welding heat, the aluminum metal wire 1044 may partially diffuse into the silicon substrate 305 or may not diffuse into the silicon substrate 305. In other words, during the diffusion, the aluminum paste sub-pattern 1046 located on the side of the aluminum metal wire 1044 away from the imprint template is equivalent to appropriately protecting the aluminum metal wire 1044, so that the aluminum metal wire 1044 has little diffusion, so that the shape of the aluminum metal wire 1044 has little deformation. Subsequently, the aluminum metal wire 1044 is used as the electrode, which can ensure precision of the formed electrode.

The present invention is further described below with reference to a more detailed embodiment.

As shown in FIG. 4, a second conductive sub-pattern 1041 is a tin conductive sub-pattern with a thickness of 1 µm, a second conductive sub-pattern 1042 is a copper conductive sub-pattern with a thickness of 12 µm, and a second conductive sub-pattern 1043 is a tin conductive sub-pattern with a thickness of 0.5 µm. The second conductive sub-pattern 1041, the second conductive sub-pattern 1042, and the second conductive sub-pattern 1043 are all prepared through deposition and patterning.

In FIG. 4, a first conductive pattern 321 is a copper conductive pattern with a thickness of 20 nm, and the first conductive pattern 321 is obtained through deposition. A bonding pattern 311 is a titanium pattern with a thickness of 10 nm, and the bonding pattern 311 is also obtained through deposition. The first conductive pattern 321 and a second conductive pattern 104 are welded together.

### Embodiment 3

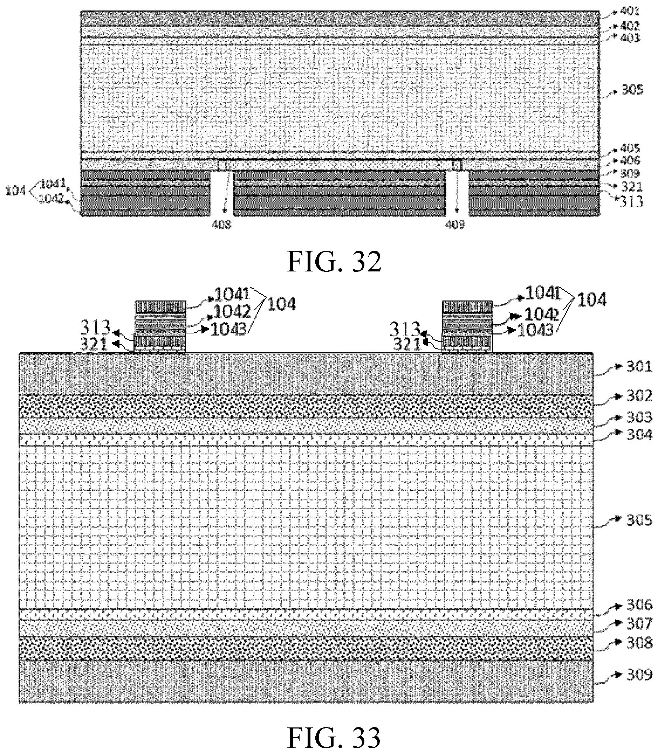

FIG. 31 is a schematic diagram of a structure of a fifth HJT solar cell according to an exemplary embodiment of the present invention. FIG. 32 is a schematic diagram of a structure of a second HBC solar cell according to an exemplary embodiment of the present invention. FIG. 33 is a schematic diagram of a structure of a sixth HJT solar cell according to an exemplary embodiment of the present invention.

Embodiment 3 provides a solar cell. Referring to FIG. 31, FIG. 32, and FIG. 33, the solar cell includes a solar cell body, and a positive electrode and a negative electrode arranged on the solar cell body, where a structure of the positive electrode and a structure of the negative electrode may be the same or may be different. An electrode (where the electrode may be the positive electrode or the negative electrode) of the solar cell includes a first conductive pattern 321, a bonding part, and a second conductive pattern 104 sequentially laminated on the solar cell body. Optionally, the bonding part may include a conductive adhesive pattern 313. The conductive adhesive pattern 313 is located between the first conductive pattern 321 and the second conductive pattern 104. The first conductive pattern 321 and the second conductive pattern 104 are bonded together through the conductive adhesive pattern 313. The conductive adhesive pattern 313 has little or substantially no deformation during the bonding. Before and after the bonding, surfaces of the conductive adhesive pattern 313 have substantially no change. In addition, a material of the conductive adhesive pattern 313 includes a conductive material and an adhesive. The conductive material may be a metal, an organic conductive material, or the like. For example, the conductive material may be copper or aluminum. The adhesive may be an organic adhesive. For example, the adhesive may be an epoxy glue or a polyurethane glue. In the present invention, the conductive material and the adhesive are not specifically limited. For an arrangement position and a connection relationship of the electrode, reference may be made to Embodiment 1, and details are not described herein again.

The first conductive pattern 321 and the second conductive pattern 104 are bonded together through the conductive adhesive pattern 313. The bonding process is simple and mature, and mass production is easy to be implemented. In addition, the bonding features a low bonding temperature and high bonding strength. The low bonding temperature can reduce a heat effect on the solar cell body, thereby having little effect on photoelectric conversion efficiency of the solar cell. The high bonding strength can make the electrode of the solar cell have good reliability. In addition, during the bonding, materials of the second conductive pattern 104 and the first conductive pattern 321 can conduct electricity, are not limited to a silver paste, and have more material selections; and compared with the silver paste, selecting copper, tin, conductive resin, or the like can appropriately reduce costs. In addition, the conductive adhesive pattern 313 can have bonding performance and conductivity performance, and has more material selections; and compared with the silver paste, selecting conductive resin or the like can appropriately reduce costs. In addition, because a material of the electrode in this embodiment of the present invention may not be granular (for example, a silver paste), a process of preparing the second conductive pattern has little or substantially no effect on the solar cell body, and mass production is easy to be implemented. Therefore, preparation costs can be reduced. For the descriptions herein, reference is made to Embodiment 1. To avoid repetition, details are not described again.

It should be noted that, the materials of the first conductive pattern 321 and the second conductive pattern 104 may be materials that can conduct electricity, and the materials of the first conductive pattern 321 and the second conductive pattern 104 are not specifically limited. The conductive adhesive pattern 313 can have the bonding performance and the conductivity performance, and a material of the conductive adhesive pattern 313 is also not specifically limited. For example, the first conductive pattern 321 and the second conductive pattern 104 each may be made of a metal material. For example, the material of the conductive adhesive pattern 313 may include a silver paste. Alternatively, for example, at least one of the first conductive pattern 321, the second conductive pattern 104, or the conductive adhesive pattern 313 may be made of an organic conductive material or the like. Compared with the metal material, the organic conductive material may further reduce a weight of the solar cell, thereby reducing a weight of a solar cell module. When being applied to a photovoltaic rooftop, a lightweight solar cell module can appropriately reduce mechanical requirements on a building rooftop.

It should be noted that, a difference between FIG. 31 and FIG. 32 mainly lies in that structures of the solar cell bodies are different, and shapes of the second conductive patterns 104 are different. A difference between FIG. 31 and FIG. 33 mainly lies in that shapes of the second conductive patterns 104 are different.

Optionally, the conductive adhesive pattern 313 may have good bonding performance at a normal temperature or a low temperature. The first conductive pattern 321 and the second conductive pattern 104 can be firmly bonded at the normal temperature or the low temperature, so that a heat effect of the bonding on the solar cell body can be reduced. For example, the material of the conductive adhesive pattern 313 may be selected from a conductive adhesive including graphite, which has reliable bonding performance and excellent conductivity performance at about 150°C. The bonding process may be accompanied by a curing reaction or sintering. The curing reaction herein may include heat curing or light curing.

Optionally, referring to FIG. 31 to FIG. 33, the conductive adhesive pattern 313 is closer to the solar cell body than the second conductive pattern 104 is. In FIG. 31, a direction shown by a dashed arrow L1 is a direction away from the solar cell body. In the direction away from the solar cell body, an area of a cross section of a partial region of the second conductive pattern 104 away from the solar cell body gradually decreases. For the descriptions herein, reference is made to Embodiment 1. To avoid repetition, details are not described again.

Optionally, a shape of a longitudinal section of the second conductive pattern 104 or a partial region of the second conductive pattern 104 away from the solar cell body is a triangle, a trapezoid, or a shape formed by an arc and a line segment connecting two endpoints of the arc, where a length of the line segment is less than or equal to a diameter of a circle corresponding to the arc; and the longitudinal section is parallel to a lamination direction of the conductive adhesive pattern 313 and the second conductive pattern 104. For the longitudinal section herein, reference may be correspondingly made to the related descriptions in Embodiment 1, and the same or similar beneficial effects can be achieved. To avoid repetition, details are not described herein again.

Optionally, the electrode of the solar cell further includes a bonding pattern located between the first conductive pattern 321 and the solar cell body. For a material, a thickness, and the like of the bonding pattern, reference may be correspondingly made to the related descriptions in Embodiment 1, and the same or similar beneficial effects can be achieved. To avoid repetition, details are not described herein again.

It should be noted that, a thickness of the conductive adhesive pattern 313 is not specifically limited, provided that the second conductive pattern 104 and the first conductive pattern 321 can be firmly bonded and costs can be reduced. For example, the thickness of the conductive adhesive pattern 313 may be 5 nm. If the silver paste is selected for the conductive adhesive pattern 313, because the thickness of the conductive adhesive pattern 313 is significantly smaller than a thickness of the electrode, costs of the conductive adhesive pattern 313 are relatively low, and costs of a solar cell formed accordingly are still relatively low.

Optionally, for the materials, shapes, thicknesses, structures, and the like of the first conductive pattern 321 and the second conductive pattern in Embodiment 3, reference may be correspondingly made to the related descriptions in Embodiment 1, and the same or similar beneficial effects can be achieved. To avoid repetition, details are not described herein again.

Optionally, referring to FIG. 31 to FIG. 33, the second conductive pattern 104 is formed by at least two second conductive sub-patterns laminated in the direction parallel to the lamination direction of the conductive adhesive pattern 313 and the second conductive pattern 104. For the arranged at least two second conductive sub-patterns, reference may be correspondingly made to the related descriptions in Embodiment 1, and the same or similar beneficial effects can be achieved. To avoid repetition, details are not described herein again.

Optionally, a material of the second conductive sub-pattern 1041 farthest away from the first conductive pattern 321 in the second conductive pattern 104 may include tin. For an advantage, a component, and the like of tin herein, reference may be correspondingly made to the related descriptions in Embodiment 1, and the same or similar beneficial effects can be achieved. To avoid repetition, details are not described herein again.

Optionally, in a direction parallel to the lamination direction of the solar cell body and the first conductive pattern 321, the second conductive pattern 104 includes a seed layer pattern and a plating pattern that are laminated, where the plating pattern is closer to the solar cell body than the seed layer pattern is, and the plating pattern wraps the seed layer pattern. For the descriptions herein, reference may be correspondingly made to the related descriptions in Embodiment 1, and the same or similar beneficial effects can be achieved. To avoid repetition, details are not described herein again.

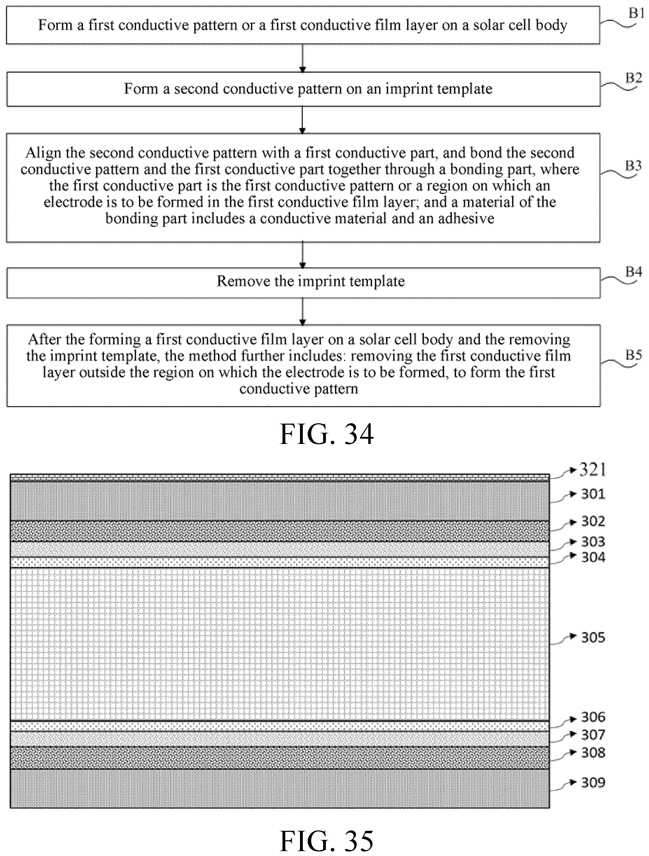

Embodiment 3 further provides a method for preparing a solar cell, which can be used to prepare the solar cell in Embodiment 3. FIG. 34 is a flowchart of steps of a third method for preparing a solar cell according to an exemplary embodiment of the present invention. Referring to FIG. 34, the method for preparing a solar cell includes the following steps.

Step B1: Form a first conductive pattern or a first conductive film layer on a solar cell body.

For Step B1, reference may be correspondingly made to the related descriptions in Embodiment 1, and the same or similar beneficial effects can be achieved. To avoid repetition, details are not described herein again.

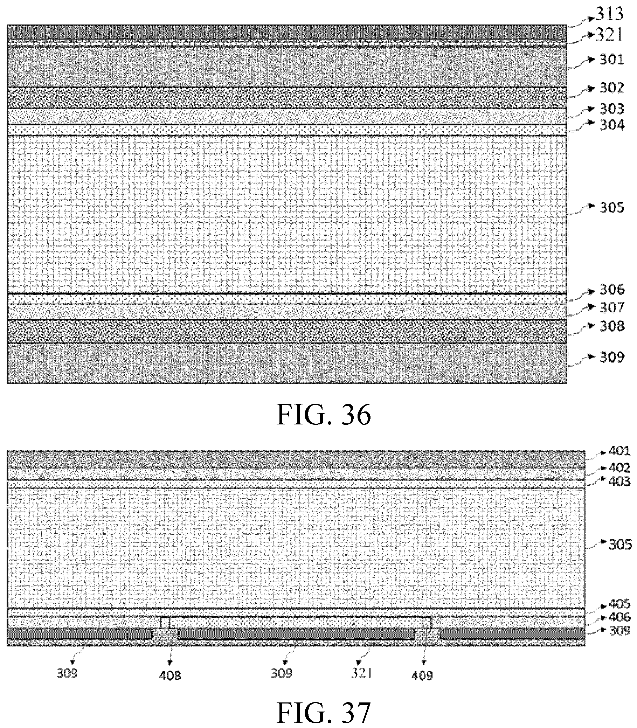

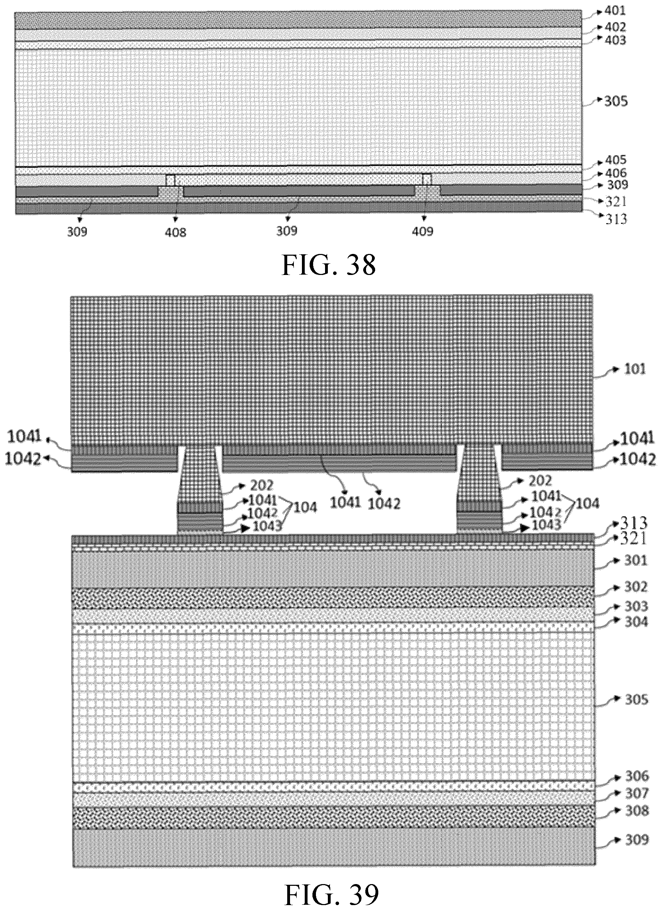

FIG. 35 is a schematic diagram of a local structure of a fourth HJT solar cell according to an exemplary embodiment of the present invention. FIG. 36 is a schematic diagram of a local structure of a fifth HJT solar cell according to an exemplary embodiment of the present invention. FIG. 37 is a schematic diagram of a local structure of a fourth HBC solar cell according to an exemplary embodiment of the present invention. FIG. 38 is a schematic diagram of a local structure of a fifth HBC solar cell according to an exemplary embodiment of the present invention. Referring to FIG. 35 and FIG. 37, a first conductive film layer 321 is formed on the solar cell body through screen printing, deposition, electroplating, or the like.

Optionally, the forming a first conductive pattern or a first conductive film layer on a solar cell body may include: laying a metal foil on the solar cell body, to form the first conductive film layer. For the part, reference may be correspondingly made to the related descriptions in Embodiment 1, and the same or similar beneficial effects can be achieved. To avoid repetition, details are not described herein again.

Optionally, after the laying a metal foil on the solar cell body, the method may include: pressing the metal foil, to bond the metal foil to the solar cell body. For the part, reference may be correspondingly made to the related descriptions in Embodiment 1, and the same or similar beneficial effects can be achieved. To avoid repetition, details are not described herein again.

Step B2: Form a second conductive pattern on an imprint template.

For Step B2, reference may be correspondingly made to the related descriptions in Embodiment 1, and the same or similar beneficial effects can be achieved. To avoid repetition, details are not described herein again.

Step B3: Align the second conductive pattern with a first conductive part, and bond the second conductive pattern and the first conductive part together through a bonding part, where the first conductive part is the first conductive pattern or a region on which an electrode is to be formed in the first conductive film layer; and a material of the bonding part includes a conductive material and an adhesive.

For that a second conductive pattern 104 is aligned with the first conductive part, reference may be correspondingly made to the related descriptions in Embodiment 1, and the same or similar beneficial effects can be achieved. To avoid repetition, details are not described herein again.

After the first conductive part is aligned with the second conductive pattern 104, the second conductive pattern 104 and the first conductive part are bonded together through a conductive adhesive film layer 313 or a conductive adhesive pattern 313, so that bonding transfer of the second conductive pattern 104 located on the imprint template to the first conductive film layer 321 or a first conductive pattern 321 on the solar cell body is implemented. The bonding features a low bonding temperature and high bonding strength. The low bonding temperature can reduce a heat effect on the solar cell body, thereby having little effect on photoelectric conversion efficiency of the solar cell. The high bonding strength can make the electrode of the solar cell have good reliability. Compared with screen printing, in the present invention, materials of the second conductive pattern and the first conductive film layer or the first conductive pattern can conduct electricity, and are not limited to a silver paste. Therefore, costs can be appropriately reduced. **In** addition, the conductive adhesive film layer 313 or the conductive adhesive pattern 313 can have bonding performance and conductivity performance, and is also not limited to the silver paste. Therefore, costs can be appropriately reduced. Compared with laser transfer printing, in the present invention, the second conductive pattern and the first conductive pattern can be bonded together through the conductive adhesive film layer 313 or the conductive adhesive pattern 313, or the second conductive pattern and the region on which the electrode is to be formed in the first conductive film layer can be bonded together through the conductive adhesive film layer 313 or the conductive adhesive pattern 313. The bonding process is mature, and process difficulty is relatively low, so that production efficiency can be appropriately improved. Compared with electroplating, in the present invention, the second conductive pattern and the first conductive pattern can be bonded together through the conductive adhesive film layer 313 or the conductive adhesive pattern 313, or the second conductive pattern and the region on which the electrode is to be formed in the first conductive film layer can be bonded together through the conductive adhesive film layer 313 or the conductive adhesive pattern. In this way, there is no process problem such as winding plating for the solar cell body, the yield and the reliability are good, and mass production is easy to be implemented.

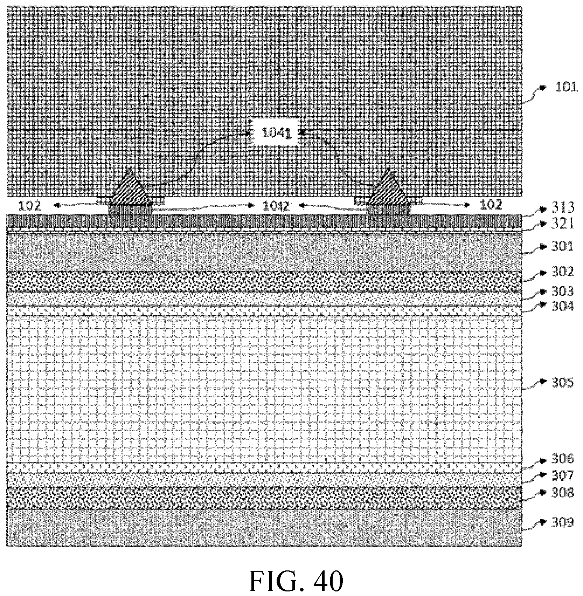

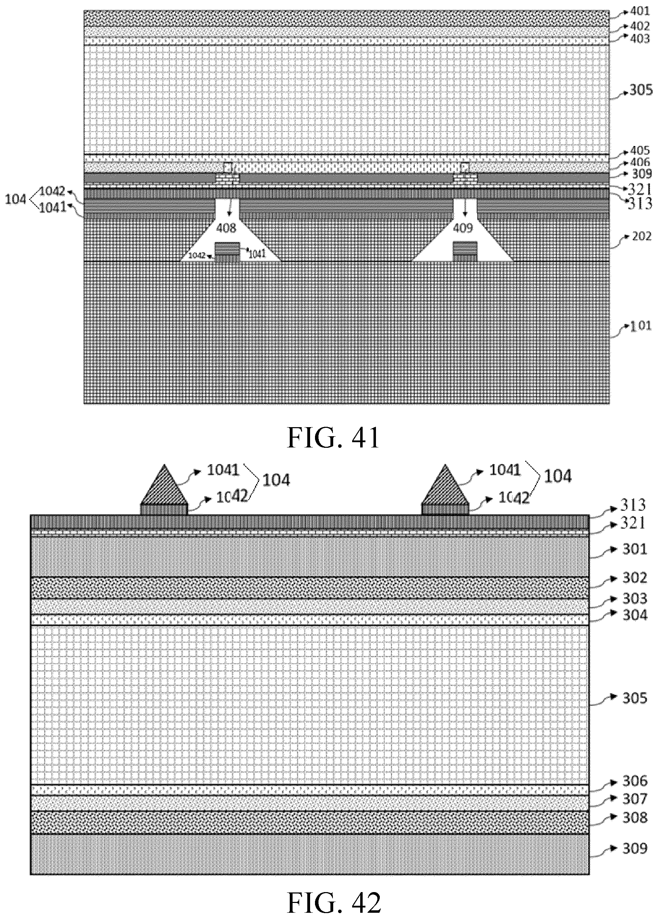

FIG. 39 is a schematic diagram of a fourth structure in which a second conductive pattern is aligned with a region on which an electrode is to be formed in a first conductive film layer according to an exemplary embodiment of the present invention. FIG. 40 is a schematic diagram of a fifth structure in which a second conductive pattern is aligned with a region on which an electrode is to be formed in a first conductive film layer according to an exemplary embodiment of the present invention. FIG. 41 is a schematic diagram of a sixth structure in which a second conductive pattern is aligned with a region on which an electrode is to be formed in a first conductive film layer according to an exemplary embodiment of the present invention. Referring to FIG. 39, FIG. 40, and FIG. 41, the second conductive pattern 104 is aligned with the region on which the electrode is to be formed in the first conductive film layer 321, and the second conductive pattern 104 and the region on which the electrode is to be formed in the first conductive film layer 321 are bonded together through the conductive adhesive film layer 313. A difference between FIG. 39 and FIG. 41 mainly lies in that quantities of second conductive patterns 104 are different, structures of the solar cell bodies are different, and quantities of second conductive sub-patterns in the second conductive patterns 104 are different. A difference between FIG. 39 and FIG. 40 mainly lies in that shapes of the second conductive patterns 104 are different.

Step B4: Remove the imprint template.

The bonding transfer of the second conductive pattern 104 located on the imprint template to the first conductive film layer 321 or the first conductive pattern 321 on the solar cell body is implemented, so that the electrode of the solar cell is substantially formed. Then, the imprint template is removed. Removing the imprint template mainly relies on that bonding force between the second conductive pattern 104 and the imprint template is less than bonding force between the second conductive pattern 104 and the conductive adhesive film layer 313 or the conductive adhesive pattern 313, to remove the imprint template. For a manner of removing the imprint template and the like, reference may be correspondingly made to the related descriptions in Embodiment 1, and the same or similar beneficial effects can be achieved. To avoid repetition, details are not described herein again.

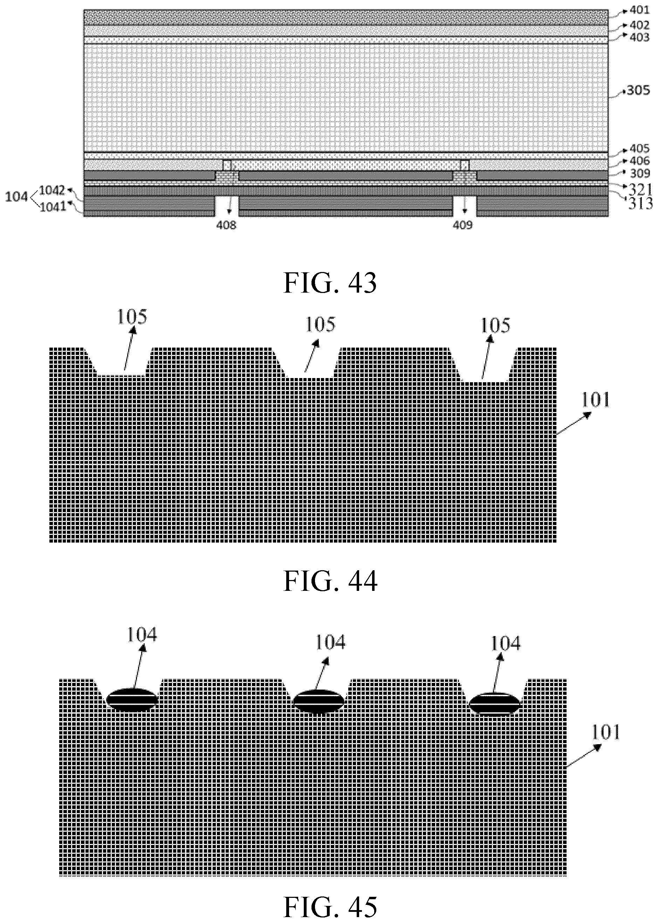

FIG. 42 is a schematic diagram of a local structure of a sixth HJT solar cell according to an exemplary embodiment of the present invention. FIG. 43 is a schematic diagram of a local structure of a sixth HBC solar cell according to an exemplary embodiment of the present invention. FIG. 42 and FIG. 43 are schematic diagrams of the solar cell with the imprint template being removed.

It should be noted that, after the imprint template is removed, second conductive pattern residues on the imprint template may be further cleaned by using an acid solution or an alkali solution, so that the imprint template can be reused, thereby further reducing costs. Specifically, whether the imprint template is cleaned by using the acid solution or the imprint template is cleaned by using the alkali solution needs to be determined according to the material of the second conductive pattern. This is not specifically limited in the embodiments.

Step B5: After the forming a first conductive film layer on a solar cell body and the removing the imprint template, the method further includes: removing the first conductive film layer outside the region on which the electrode is to be formed, to form the first conductive pattern.

FIG. 31 to FIG. 33 may be schematic diagrams of structures after the first conductive film layer outside the region of the electrode is removed to form the first conductive pattern 321.

For Step B5, reference may be correspondingly made to the related descriptions in Embodiment 1, and the same or similar beneficial effects can be achieved. To avoid repetition, details are not described herein again.

Optionally, the bonding part may include a conductive adhesive film layer 313 or a conductive adhesive pattern 313. When the first conductive part and the second conductive pattern 104 are bonded together through the conductive adhesive film layer 313, after the removing the imprint template, the method may further include: removing the conductive adhesive film layer 313 outside a region on which the electrode is to be formed, to form the conductive adhesive pattern 313. The conductive adhesive film layer 313 is entirely arranged on the solar cell body or the second conductive pattern 104, and the conductive adhesive film layer 313 outside the region of the electrode may be removed by using a removal solution corresponding to the material of the conductive adhesive film layer 313, to form the conductive adhesive pattern 313, thereby avoiding a problem such as a short circuit.

It should be noted that, a concentration and/or removal time of the removal solution may be controlled, to control precision of forming the conductive adhesive pattern 313, to obtain the conductive adhesive pattern 313 with an appropriate shape. This is not specifically limited in the embodiments.

FIG. 31 to FIG. 33 may be schematic diagrams of structures after the conductive adhesive film layer outside the region of the electrode is removed to form the conductive adhesive pattern 313.

Optionally, before Step B3, the method may further include: annealing the imprint template on which the second conductive pattern 104 has been formed. For an annealing manner, an annealing temperature, and the like in Embodiment 3, reference may be correspondingly made to the related descriptions in Embodiment 1, and the same or similar beneficial effects can be achieved. To avoid repetition, details are not described herein again.

Optionally, before the bonding, the method may further include: forming the bonding part, that is, the conductive adhesive pattern or the conductive adhesive film layer, on the second conductive pattern. A manner of forming the conductive adhesive pattern or the conductive adhesive film layer on the second conductive pattern of the imprint template may include: screen printing, coating, or the like. The conductive adhesive pattern or the conductive adhesive film layer is formed on the second conductive pattern of the imprint template, instead of being prepared on the solar cell body, and a process of preparing the conductive adhesive pattern or the conductive adhesive film layer has little or substantially no effect on the solar cell body, so that the effect on the solar cell body can be reduced, and mass production is easy to be implemented. It should be noted that, if the entire conductive adhesive film layer is formed on the second conductive pattern of the imprint template, a mask layer may be arranged on the entire conductive adhesive film layer, and the mask layer is patterned, to form the conductive adhesive pattern is formed through wet etching. Alternatively, the entire conductive adhesive film layer may be patterned by using laser, to form the conductive adhesive pattern. This is not specifically limited in the embodiments.

In Step B3, the aligning the second conductive pattern with a first conductive part includes: aligning the first conductive part with the conductive adhesive pattern or the region on which the electrode is to be formed in the conductive adhesive film layer. For the definition of the aligning, reference is made to the foregoing related descriptions. To avoid repetition, details are not described herein again.

Optionally, before the bonding, the method may further include: forming the bonding part, that is, the conductive adhesive pattern 313 or the conductive adhesive film layer 313, on one of the first conductive pattern 321, the region on which the electrode is to be formed in the first conductive film layer 321, or the first conductive film layer 321. For example, referring to FIG. 36 and FIG. 38, the conductive adhesive film layer 313 is formed on the first conductive film layer 321. Optionally, in Step B3, the aligning the second conductive pattern with a first conductive part includes: aligning the second conductive pattern 104 with the conductive adhesive pattern 313 or the region on which the electrode is to be formed in the conductive adhesive film layer 313. For the definition of the aligning, reference is made to the foregoing related descriptions. To avoid repetition, details are not described herein again. For example, FIG. 39, FIG. 40, and FIG. 41 may be schematic diagrams in which the second conductive pattern 104 is aligned with the region on which the electrode is to be formed in the conductive adhesive film layer 313.

Optionally, before the forming a first conductive pattern or a first conductive film layer on the solar cell body, the method may further include: forming a bonding pattern or a bonding film layer on the solar cell body. For a function, a material, a forming manner, and the like of the bonding pattern or the bonding film layer, reference may be correspondingly made to the related descriptions in Embodiment 1, and the same or similar beneficial effects can be achieved. To avoid repetition, details are not described herein again.

Optionally, referring to FIG. 21, the imprint template includes a first groove 103. Referring to FIG. 11 and FIG. 12, Step B2 may include: forming the second conductive pattern 104 in the first groove 103 of the imprint template, where the second conductive pattern 104 is flush with a surface of a side of the imprint template provided with the first groove 103, or protrudes from the surface of the side of the imprint template provided with the first groove 103. In this way, in a process of bonding the second conductive pattern 104 to the first conductive pattern 321 or the region on which the electrode is to be formed in the first conductive film layer 321, the conductive adhesive pattern on the second conductive pattern 104 can come into contact with the first conductive pattern 321 or the region on which the electrode is to be formed in the first conductive film layer 321, or the second conductive pattern 104 can come into contact with the conductive adhesive pattern or the conductive adhesive film layer. The first groove 103 is used as a gate line plate corresponding to the second conductive pattern 104, to form the second conductive pattern 104 with a precise shape. If the conductive adhesive pattern is formed on the second conductive pattern 104, the first groove 103 is further used as a gate line plate corresponding to the conductive adhesive pattern, to form the conductive adhesive pattern with a precise shape. The second conductive pattern may be formed in the first groove 103 of the imprint template through electroplating, deposition, or the like. This is not specifically limited in the embodiments. It should be noted that, if the deposition manner is selected, after the deposition is completed, the second conductive film layer outside the first groove 103 further needs to be etched away.

For example, the first groove 103 is provided inward on a partial region of a surface of a substrate 101, to form the imprint template. Referring to FIG. 40, in a process of implementing the bonding transfer of the second conductive pattern 104 to the region on which the electrode is to be arranged in the first conductive film layer 321 on the solar cell body, the surface of the substrate may be a surface of the substrate 101 close to the solar cell body.

For a forming manner, a structure, and a size of the first groove 103, a material of the substrate, and the like, reference may be correspondingly made to the related descriptions in Embodiment 1, and the same or similar beneficial effects can be achieved. To avoid repetition, details are not described herein again.

Optionally, referring to FIG. 21, the imprint template further includes the substrate 101, the first groove 103 is arranged on the substrate 101, and the imprint template further includes a first boss 102 arranged on the substrate 101 and located on an edge of the first groove 103. Referring to FIG. 11 and FIG. 12, the forming the second conductive pattern 104 in the first groove 103 of the imprint template includes: forming the second conductive pattern 104 in the first groove 103 of the imprint template and in a region defined by the first boss 102, where the second conductive pattern 104 is flush with a surface of the first boss 102 away from the substrate 101, or protrudes from the surface of the first boss 102 away from the substrate 101. Referring to FIG. 40, the first boss 102 protrudes from the substrate 101. Therefore, in a process of bonding the region on which the electrode is to be arranged in the first conductive film layer 321 to the second conductive pattern 104, only a part of the second conductive pattern 104 protruding from the surface of the first boss 102 away from the substrate 101 or only a part of the second conductive pattern 104 flush with the surface of the first boss 102 away from the substrate 101 is in contact with the conductive adhesive pattern 313 or the region on which the electrode is to be arranged in the conductive adhesive film layer 313, and a remaining part of the imprint template is not in contact with the conductive adhesive pattern 313 or the conductive adhesive film layer 313. In this way, the conductive adhesive pattern 313 or the conductive adhesive film layer 313, the first conductive film layer 321, or the solar cell body cannot be polluted, and the imprint template cannot press against the conductive adhesive pattern 313 or the conductive adhesive film layer 313, the first conductive film layer 321, or the solar cell body. If the conductive adhesive pattern or the conductive adhesive film layer is formed on the second conductive pattern 104, in a process of bonding the region on which the electrode is to be arranged in the first conductive film layer 321 to the conductive adhesive pattern or the region on which the electrode is to be formed in the conductive adhesive film layer, only a part of the conductive adhesive pattern or the region on which the electrode is to be formed in the conductive adhesive film layer protruding from the surface of the first boss 102 away from the substrate 101 or only a part of the conductive adhesive pattern or the region on which the electrode is to be formed in the conductive adhesive film layer flush with the surface of the first boss 102 away from the substrate 101 is in contact with the region on which the electrode is to be arranged in the first conductive film layer 321, and a remaining part of the imprint template is not in contact with the first conductive film layer 321. In this way, the first conductive film layer 321 or the solar cell body cannot be polluted, and the imprint template cannot press against the first conductive film layer 321 or the solar cell body. If the conductive adhesive pattern or the conductive adhesive film layer is formed on the second conductive pattern and the second conductive pattern is not formed on the surface of the first boss 102 away from the substrate 101, the conductive adhesive pattern is also not formed on the surface of the first boss 102 away from the substrate 101. For beneficial effects, implementations, and the like corresponding to the imprint template, reference may be made to the descriptions related to the second conductive pattern in Embodiment 1. To avoid repetition, details are not described herein again.

It should be noted that, for an advantage of not forming the second conductive pattern on the surface of the first boss 102 away from the substrate 101, a method of preparing the first boss 102, and the like, reference may be made to the related descriptions in Embodiment 1, and the same or similar beneficial effects can be achieved. To avoid repetition, details are not described herein again.

Optionally, referring to FIG. 21, in a direction from a notch of the first groove 103 to a groove bottom of the first groove 103, an area of a cross section of the first groove 103 gradually decreases, where the cross section of the first groove 103 is perpendicular to a lamination direction of the conductive adhesive film layer 313 or the conductive adhesive pattern 313 and the second conductive pattern 104. For the cross section of the first groove 103, reference may be made to the related descriptions in Embodiment 1, and the same or similar beneficial effects can be achieved. To avoid repetition, details are not described herein again.

Optionally, referring to FIG. 22 to FIG. 24, the imprint template includes the substrate 101 and a second boss 202 located on the substrate 101. A quantity of second bosses 202 on the substrate 101 is not specifically limited. For the quantity of second bosses 202, and forming manners of the second boss 202 and the substrate 101, reference may be made to the related descriptions in Embodiment 1, and the same or similar beneficial effects can be achieved. To avoid repetition, details are not described herein again. Referring to FIG. 13 and FIG. 14, Step B2 may include: forming a second conductive film layer 104 on a side of the imprint template on which the second boss 202 is formed, where a part of the second conductive film layer 104 located on the second boss 202 is the second conductive pattern. For that the second conductive film layer 104 is formed through deposition, electroplating, or the like, a height difference between the second boss 202 and the substrate 101 may be used to disconnect the part of the second conductive film layer 104 located on the second boss 202 from a part of the second conductive film layer 104 located on the substrate 101. In this way, if the conductive adhesive film layer or the conductive adhesive pattern is formed on the first conductive pattern 321 or the region on which the electrode is to be arranged in the first conductive film layer 321, after the second conductive pattern 104 is aligned with the conductive adhesive pattern or the region on which the electrode is to be arranged in the conductive adhesive film layer, it can be ensured that only the part of the second conductive film layer 104 located on the second boss 202 is in contact with the conductive adhesive film layer or the conductive adhesive pattern, to facilitate aligning the second conductive pattern 104 with the conductive adhesive film layer or the conductive adhesive pattern; and the part of the second conductive film layer 104 located on the substrate 101 is not in contact with the conductive adhesive pattern or the region on which the electrode is to be arranged in the conductive adhesive film layer, so that pollution on the conductive adhesive film layer or the conductive adhesive pattern, the first conductive film layer 321, or the solar cell body can be reduced. In addition, only the second boss 202 in the imprint template is in indirect contact with the conductive adhesive film layer or the conductive adhesive pattern, the first conductive film layer 321, or the solar cell body, and a remaining part of the imprint template is not in contact with the conductive adhesive film layer or the conductive adhesive pattern, the first conductive film layer 321, or the solar cell body, to facilitate removing the imprint template. If the conductive adhesive film layer is formed on the second conductive pattern 104, the height difference between the second boss 202 and the substrate 101 may also be used to disconnect a part of the conductive adhesive film layer located on the second boss 202 from a part of the conductive adhesive film layer located on the substrate 101, which has similar beneficial effects. To avoid repetition, details are not described herein again.

Optionally, referring to FIG. 26 to FIG. 28, Step B2 may include: forming a seed pattern 1047 on the imprint template; and forming a plating pattern 1048 on the seed pattern 1047 through electroplating or chemical plating, where the plating pattern 1048 and the seed pattern 1047 together form a second conductive pattern 104. A function of the imprint template herein is mainly to provide a carrying table for forming the seed pattern. For the descriptions herein, reference may be correspondingly made to the related descriptions in Embodiment 1, and the same or similar beneficial effects can be achieved. To avoid repetition, details are not described herein again.

The second conductive film layer 104 herein may be a metal foil, and Step B2 may include: laying the metal foil on the side of the imprint template on which the second boss 202 is formed, where a part of the metal foil located on the second boss 202 is the second conductive pattern 104. A part of the metal foil located outside the second boss 202 may be adsorbed on the substrate 101 through lamination, or the like, to avoid displacement of the metal foil. The part of the metal foil located outside the second boss 202 is absorbed on the substrate 101. In this way, if the conductive adhesive film layer or the conductive adhesive pattern is formed on the first conductive pattern 321 or the region on which the electrode is to be arranged in the first conductive film layer 321, after the second conductive pattern 104 is aligned with the conductive adhesive pattern or the region on which the electrode is to be arranged in the conductive adhesive film layer, it can be ensured that only the part of the second conductive film layer 104 located on the second boss 202 is in contact with the conductive adhesive film layer or the conductive adhesive pattern, to facilitate aligning the second conductive pattern 104 with the conductive adhesive film layer or the conductive adhesive pattern; and the part of the second conductive film layer 104 located on the substrate 101 is not in contact with the conductive adhesive pattern or the region on which the electrode is to be arranged in the conductive adhesive film layer, so that pollution on the conductive adhesive film layer or the conductive adhesive pattern, the first conductive film layer 321, or the solar cell body can be reduced. In this case, the part of the metal foil located on the second boss 202 and the part of the metal foil located outside the second boss 202 may not be disconnected before the bonding, and may be disconnected after the bonding. For a material, an arrangement manner, and the like of the metal foil herein, reference may be made to Embodiment 1. To avoid repetition, details are not described again. Small burrs or the like may be provided on a surface of the second boss 202 away from the substrate 101. The small burrs or the like may hang the metal foil, so that the second conductive pattern is not prone to positional deviation or the like in a process of bonding the second conductive pattern to the first conductive pattern or the region on which the electrode is to be arranged in the first conductive film layer. A material of the metal foil herein is the same as or similar to the material of the second conductive pattern described above. For example, the metal foil may be a copper foil.

Optionally, referring to FIG. 22 or FIG. 24, the surface of the second boss 202 away from the substrate 101 is a plane, so that a surface of the formed second conductive pattern 104 close to the second boss 202 is also a plane. Alternatively, optionally, referring to FIG. 23, a side of the second boss 202 away from the substrate 101 includes a second groove 2021. The forming a second conductive pattern on an imprint template includes: forming the second conductive pattern in the second groove 2021. For a shape, a function, and the like of the second groove 2021, reference may be correspondingly made to the related descriptions in Embodiment 1, and the same or similar beneficial effects can be achieved. To avoid repetition, details are not described herein again.

Optionally, the imprint template may include a substrate, and Step B2 may include: laying a metal foil on the substrate, and patterning the metal foil, to form the second conductive pattern. For laying of the metal foil, patterning of the metal foil, and the like, reference may be correspondingly made to the related descriptions in Embodiment 1, and the same or similar beneficial effects can be achieved. To avoid repetition, details are not described herein again.

Optionally, before Step B2, the method may further include: providing a plurality of metal foil patterns; the imprint template may include a plurality of adsorption regions; and Step B2 may include: at least aligning one of the adsorption regions with one of the metal foil patterns, and adsorbing the metal foil pattern on the adsorption region, to form the second conductive pattern on the imprint template. For providing of a metal foil, the aligning of the metal foil pattern, the absorption of the metal foil, and the like, reference may be correspondingly made to the related descriptions in Embodiment 1, and the same or similar beneficial effects can be achieved. To avoid repetition, details are not described herein again.

Optionally, the second conductive pattern 104 may also be a metal wire. A shape, a size, and the like of the metal wire are all not specifically limited. For example, a wire diameter of the metal wire may range from 10 µm to 50 µm, and a length of the metal wire may range from 10 µm to 1000 µm. A material of the metal wire may be the same as the material of the second conductive pattern described above, and details are not described herein again. For example, the material of the metal wire may be copper or aluminum.

Optionally, a surface of the metal wire may be further coated with a coating. For a material, a thickness, and the like of the coating, reference may be correspondingly made to the related descriptions in Embodiment 1, and the same or similar beneficial effects can be achieved. To avoid repetition, details are not described herein again.

The metal wire may be arranged in the first groove 103 or the second groove 2021 of the imprint template, so that the metal wire can be stuck. After the metal wire is stuck, the metal wire is flush with the notches of the first groove 103 and the second groove 2021, or the metal wire protrudes from the notches of the first groove 103 and the second groove 2021, to form the second conductive pattern on the imprint template.

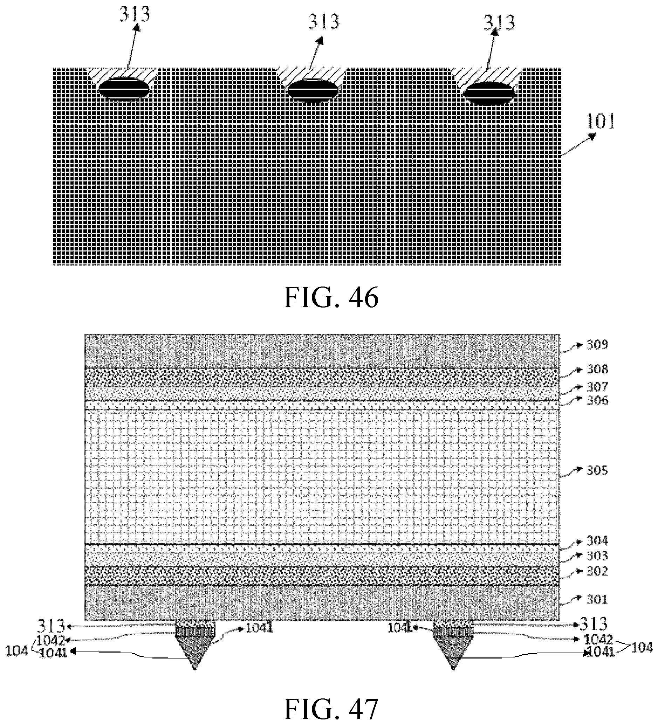

FIG. 44 is a schematic diagram of a structure of a sixth imprint template according to an exemplary embodiment of the present invention. FIG. 45 is a schematic diagram of an eighth local structure forming a second conductive pattern according to an exemplary embodiment of the present invention. FIG. 46 is a schematic diagram of a ninth local structure forming a second conductive pattern according to an exemplary embodiment of the present invention. Optionally, referring to FIG. 44 to FIG. 46, the bonding part includes a conductive adhesive pattern 313, and the imprint template includes a third groove 105. Step B2 may include: forming the second conductive pattern 104 in the third groove 105 of the imprint template, and forming the conductive adhesive pattern 313 on the second conductive pattern 104, where the conductive adhesive pattern 313 is flush with a surface of a side of the imprint template provided with the third groove 105, or protrudes from the surface of the side of the imprint template provided with the third groove 105; and The second conductive pattern 104 herein may be a metal wire or the like. The metal wire or the like may be arranged in the third groove 105 of the imprint template, so that the metal wire can be stuck. After the metal wire is stuck, the metal wire is lower than a notch of the third groove 105, or is flush with from the notch of the third groove 105, to form the second conductive pattern on the imprint template. A function of the imprint template herein is mainly to provide a component for forming the third groove 105. Therefore, a structure of the imprint template is not limited. For example, referring to FIG. 44, the imprint template may include only the substrate 101. The second conductive pattern 104 is formed in flexible and diverse manners. The conductive adhesive pattern 313 may be formed on the second conductive pattern 104 through coating or the like. Step B3 may include: aligning the conductive adhesive pattern with the first conductive part, where the second conductive pattern 104 and the first conductive part are bonded together through the conductive adhesive pattern. The conductive adhesive pattern 313 is limited by the third groove 105, so that the process of forming the conductive adhesive pattern 313 is simpler.

### Embodiment 4

FIG. 47 is a schematic diagram of a structure of a seventh HJT solar cell according to an exemplary embodiment of the present invention. Embodiment 4 provides another solar cell. The solar cell includes a solar cell body, and a positive electrode and a negative electrode arranged on the solar cell body, where a structure of the positive electrode and a structure of the negative electrode may be the same or may be different. Referring to FIG. 47, an electrode (where the electrode may be the positive electrode or the negative electrode) of the solar cell includes a conductive adhesive pattern 313 and a second conductive pattern 104 sequentially laminated on the solar cell body, where the second conductive pattern 104 is bonded to the solar cell body through the conductive adhesive pattern 313; and a material of the conductive adhesive pattern includes a conductive material and an adhesive. For the conductive material, the adhesive, and the like herein, reference may be made to the related descriptions in Embodiment 3. To avoid repetition, details are not described herein again.

For the solar cell body, reference is made to the related descriptions in Embodiment 3. To avoid repetition, details are not described herein again. For example, the solar cell body herein may be a part that can conduct electricity. For example, the solar cell body herein may be a TCO film or a silicon substrate. If a passivation layer or the like is further arranged on the solar cell body, the passivation layer may be grooved, so that the part that can conduct electricity is exposed.

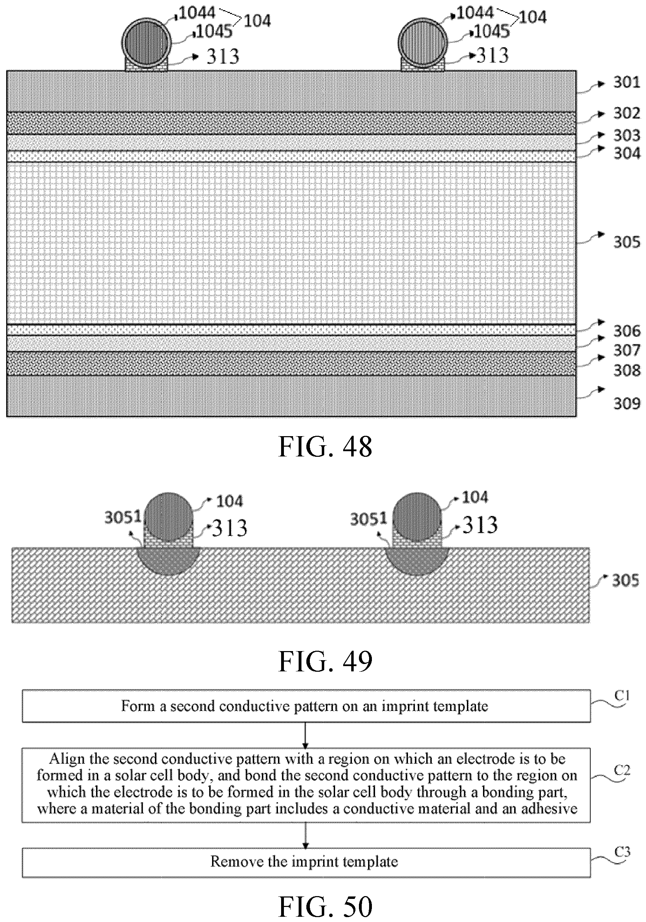

FIG. 48 is a schematic diagram of a structure of an eighth HJT solar cell according to an exemplary embodiment of the present invention. FIG. 49 is a schematic diagram of a local structure of a second solar cell according to an exemplary embodiment of the present invention. Referring to FIG. 47 to FIG. 49, the second conductive pattern 104 is bonded to the solar cell body through the conductive adhesive pattern 313. The bonding process is simple and mature, and mass production is easy to be implemented. In addition, the bonding features a low bonding temperature and high bonding strength. The low bonding temperature can reduce a heat effect on the solar cell body, thereby having little effect on photoelectric conversion efficiency of the solar cell. The high bonding strength can make the electrode of the solar cell have good reliability. In addition, during the bonding, a material of the second conductive pattern can conduct electricity and can be bonded through the conductive adhesive pattern 313, is not limited to a silver paste, and has more material selections; and compared with the silver paste, selecting copper, tin, or the like can appropriately reduce costs. In addition, the conductive adhesive pattern 313 can have bonding performance and conductivity performance, is not limited to the silver paste, and has more material selections; and compared with the silver paste, selecting conductive resin or the like can appropriately reduce costs. For other advantages of using the conductive adhesive pattern 313, an advantage of preparing the second conductive pattern, and the like, reference may be correspondingly made to the related descriptions in Embodiment 3 and Embodiment 1, and the same or similar beneficial effects can be achieved. To avoid repetition, details are not described herein again.

It should be noted that, the material of the second conductive pattern may be a material that can conduct electricity and can be bonded through the conductive adhesive pattern 313. The material of the second conductive pattern is not specifically limited. For example, the material of the second conductive pattern may include nickel, aluminum, or another metal material. For example, the material of the second conductive pattern may be singular nickel or a nickel alloy, or the material of the second conductive pattern may be aluminum. Alternatively, the material of the second conductive pattern may include an organic conductive material, for example, conductive resin. For the material of the second conductive pattern, reference may be made to the related descriptions in Embodiment 1. To avoid repetition, details are not described herein again. For example, the material of the second conductive pattern and the solar cell body can be bonded together at a normal temperature or a low temperature through the conductive adhesive pattern 313. The bonding process is simple and mature, and mass production is easy to be implemented. In addition, the low bonding temperature can reduce the heat effect on the solar cell body. In addition, the high bonding strength of the bonding can make the electrode of the solar cell have the good reliability.

In addition, compared with screen printing, the second conductive pattern 104 can be bonded through the conductive adhesive pattern 313, and is not limited to the silver paste. Therefore, costs can be appropriately reduced. The conductive adhesive pattern 313 can have conductivity performance and bonding performance, and is not limited to the silver paste. Therefore, the costs can be appropriately reduced. In addition, compared with laser transfer printing, in the present invention, the second conductive pattern 104 and the solar cell body are bonded together through the conductive adhesive pattern 313. The bonding process is mature, and process difficulty is relatively low, so that production efficiency can be appropriately improved. Compared with electroplating, in the present invention, the second conductive pattern 104 and the solar cell body can be bonded together through the conductive adhesive pattern 313. In this way, there is no process problem such as winding plating for the solar cell body, the yield and the reliability are good, and mass production is easy to be implemented.

Optionally, in a direction parallel to a lamination direction of the solar cell body and a first conductive pattern 321, the second conductive pattern 104 includes a seed layer pattern and a plating pattern that are laminated, where the plating pattern is closer to the solar cell body than the seed layer pattern is, and the plating pattern wraps the seed layer pattern. For the descriptions herein, reference may be correspondingly made to the related descriptions in Embodiment 1, and the same or similar beneficial effects can be achieved. To avoid repetition, details are not described herein again.

Optionally, for a shape, a thickness, the structure, and the like of the second conductive pattern in Embodiment 4, reference may be correspondingly made to the related descriptions in Embodiment 3, and the same or similar beneficial effects can be achieved. To avoid repetition, details are not described herein again.

Optionally, referring to FIG. 48, the second conductive pattern 104 may also be a metal wire 1044. A surface of the metal wire 1044 may be further coated with a coating 1045. For a shape, a size, and a structure of the metal wire 1044, a matching manner between the metal wire 1044 and the imprint template, and the like, reference may be made to the foregoing related descriptions. To avoid repetition, details are not described herein again.

Embodiment 4 further provides a method for preparing a solar cell, which can be used to prepare the solar cell in Embodiment 4. FIG. 50 is a flowchart of steps of a fourth method for preparing a solar cell according to an exemplary embodiment of the present invention. Referring to FIG. 50, the method for preparing a solar cell includes the following steps.

Step C1: Form a second conductive pattern on an imprint template.

For Step C1, reference may be made to the related descriptions in Embodiment 3, and the same or similar beneficial effects can be achieved. To avoid repetition, details are not described herein again.

Step C2: Align the second conductive pattern with a region on which an electrode is to be formed in a solar cell body, and bond the second conductive pattern to the region on which the electrode is to be formed in the solar cell body through a bonding part, where a material of the bonding part includes a conductive material and an adhesive.

For the aligning, the conductive material, the adhesive, and the like in Step C2, reference may also be made to the related descriptions in Embodiment 3. To avoid repetition, details are not described herein again. In Step C2, the second conductive pattern is transferred to the solar cell body.

Step C3: Remove the imprint template.

For Step C3, reference may be made to the related descriptions in Embodiment 3, and the same or similar beneficial effects can be achieved. To avoid repetition, details are not described herein again.

Optionally, the bonding part includes a conductive adhesive film layer or a conductive adhesive pattern; and after the second conductive pattern is bonded to the region on which the electrode is to be formed in the solar cell body through the conductive adhesive film layer, and after the removing the imprint template, the method may further include: removing the conductive adhesive film layer outside a region on which the electrode is to be formed, to form the conductive adhesive pattern. For the step, reference may be made to the related descriptions in Embodiment 3, and the same or similar beneficial effects can be achieved. To avoid repetition, details are not described herein again.

Optionally, before the bonding, the method may further include: annealing the imprint template on which the second conductive pattern has been formed, to cause the second conductive pattern to recrystallize, to eliminate a stress. For an annealing temperature, annealing time, an annealing manner, and the like, reference may be correspondingly made to the related descriptions in Embodiment 3, and the same or similar beneficial effects can be achieved. To avoid repetition, details are not described herein again.

Optionally, before the bonding, the method may further include: forming the conductive adhesive pattern or the conductive adhesive film layer on the second conductive pattern. For a manner of forming the conductive adhesive pattern or the conductive adhesive film layer, reference may be made to the related descriptions in Embodiment 1. To avoid repetition, details are not described herein again. In Step C2, the aligning the second conductive pattern with a region on which an electrode is to be formed in a solar cell body may include: aligning the region on which the electrode is to be formed in the solar cell body with the conductive adhesive pattern or the region on which the electrode is to be formed in the conductive adhesive film layer; or For the aligning herein, reference may be made to the related descriptions in Embodiment 3, and the same or similar beneficial effects can be achieved. To avoid repetition, details are not described herein again.

Optionally, before the bonding, the method may further include: forming the conductive adhesive pattern or the conductive adhesive film layer on one of the region on which the electrode is to be formed in the solar cell body or the solar cell body. In Step C2, the aligning the second conductive pattern with a region on which an electrode is to be formed in a solar cell body includes: aligning the second conductive pattern with the conductive adhesive pattern or the region on which the electrode is to be formed in the conductive adhesive film layer. For the descriptions herein, reference may also be made to the related descriptions in Embodiment 3, and the same or similar beneficial effects can be achieved. To avoid repetition, details are not described herein again.

Optionally, referring to FIG. 21, the imprint template includes a first groove 103. Referring to FIG. 11 and FIG. 12, Step C1 may include: forming a second conductive pattern 104 in the first groove 103 of the imprint template, where the second conductive pattern 104 is flush with a surface of a side of the imprint template provided with the first groove 103, or protrudes from the surface of the side of the imprint template provided with the first groove 103. For that the second conductive pattern is formed in the first groove 103 of the imprint template, reference may be made to the related descriptions in Embodiment 3, and the same or similar beneficial effects can be achieved. To avoid repetition, details are not described herein again.

Optionally, referring to FIG. 21, the imprint template further includes a substrate 101, the first groove 103 is arranged on the substrate 101, and the imprint template may further include a first boss 102 arranged on the substrate 101 and located on an edge of the first groove 103. Step C1 may include: forming the second conductive pattern 104 in the first groove 103 and in a region defined by the first boss 102, where the second conductive pattern 104 is flush with a surface of the first boss 102 away from the substrate 101, or protrudes from the surface of the first boss 102 away from the substrate 101. For the descriptions herein, reference may also be made to the related descriptions in Embodiment 3, and the same or similar beneficial effects can be achieved. To avoid repetition, details are not described herein again.

Optionally, referring to FIG. 21, in a direction from a notch of the first groove 103 to a groove bottom of the first groove 103, an area of a cross section of the first groove 103 gradually decreases, where the cross section of the first groove 103 is perpendicular to a lamination direction of the second conductive pattern and a conductive adhesive film layer 313 or a conductive adhesive pattern 313. Further, in the direction from the notch of the first groove 103 to the groove bottom of the first groove 103, an area of a cross section of the formed second conductive pattern also gradually decreases, to facilitate reducing shading and reflection. For the descriptions herein, reference may also be made to the related descriptions in Embodiment 3, and the same or similar beneficial effects can be achieved. To avoid repetition, details are not described herein again.

Optionally, referring to FIG. 22 to FIG. 24, the imprint template includes a substrate 101 and a second boss 202 located on the substrate 101. A quantity of second bosses 202 on the substrate 101 is not specifically limited. Referring to FIG. 13 and FIG. 14, Step C1 may include: forming the second conductive pattern on a side of the imprint template on which the second boss 202 is formed. For a manner of forming the second conductive pattern, the quantity of second bosses, and the like, reference may be correspondingly made to the related descriptions in Embodiment 3, and the same or similar beneficial effects can be achieved. To avoid repetition, details are not described herein again.

Optionally, a surface of the second boss 202 away from the substrate 101 is a plane; or optionally, a side of the second boss 202 away from the substrate 101 includes a second groove 2021, where the second conductive pattern 104 is flush with a notch of the second groove 2021, or protrudes from the second groove 2021. For the descriptions herein, reference may be correspondingly made to the related descriptions in Embodiment 3, and the same or similar beneficial effects can be achieved. To avoid repetition, details are not described herein again.

Optionally, referring to FIG. 26 to FIG. 28, Step C1 may include: forming a seed pattern 1047 on the imprint template; and forming a plating pattern 1048 on the seed pattern 1047 through electroplating or chemical plating, where the plating pattern 1048 and the seed pattern 1047 together form a second conductive pattern 104. A function of the imprint template herein is mainly to provide a carrying table for forming the seed pattern. For the descriptions herein, reference may be correspondingly made to the related descriptions in Embodiment 1, and the same or similar beneficial effects can be achieved. To avoid repetition, details are not described herein again.

Optionally, the imprint template includes a substrate 101, and Step C1 may include: laying a metal foil on the substrate, and patterning the metal foil, to form the second conductive pattern. For the descriptions herein, reference may be correspondingly made to the related descriptions in Embodiment 3, and the same or similar beneficial effects can be achieved. To avoid repetition, details are not described herein again.

Optionally, before Step C1, the method may further include: providing a plurality of metal foil patterns; the imprint template may include a plurality of adsorption regions; and Step C1 may include: at least aligning one of the adsorption regions with one of the metal foil patterns, and adsorbing the metal foil pattern on the adsorption region, to form the second conductive pattern on the imprint template. For example, the imprint template may include the substrate and a plurality of adsorption regions arranged on the substrate at intervals. Step C1 may include: at least aligning one of the adsorption regions with one of the metal foil patterns, and adsorbing the metal foil pattern on the adsorption region, to form the second conductive pattern on the substrate. Alternatively, for example, a boss is provided on the substrate, adsorption regions are provided on the boss, at least one of the adsorption regions on the boss is aligned with one of metal foil patterns, and the metal foil pattern is adsorbed on the adsorption region, to form the second conductive pattern on the boss of the substrate. For the descriptions herein, reference may be correspondingly made to the related descriptions in Embodiment 3, and the same or similar beneficial effects can be achieved. To avoid repetition, details are not described herein again.

Optionally, referring to FIG. 49, a material of the conductive adhesive pattern 313 is an aluminum paste, and the conductive adhesive pattern 313 is in contact with a silicon substrate 305 of the solar cell body. Step C2 may include that the second conductive pattern 104 is bonded to the region on which the electrode is to be formed in the solar cell body through the conductive adhesive pattern 313, that is, the second conductive pattern 104 is bonded to a region on which the electrode is to be formed in the silicon substrate 305 through the conductive adhesive pattern 313, and sintering is performed, where during the sintering, a part of the aluminum paste in the conductive adhesive pattern 313 diffuses into the region on which the electrode is to be formed in the silicon substrate 305, to dope the region on which the electrode is to be formed in the silicon substrate 305 to form a P-type doped region 3051, and use remaining parts of the second conductive pattern 104 and the conductive adhesive pattern 313 as the electrode. In other words, based on a shape of the conductive adhesive pattern 313, a distribution position of the conductive adhesive pattern 313 on the solar cell body, and a temperature during the sintering, in a process of transferring the second conductive pattern 104 to the solar cell body, local P-type doping of the silicon substrate 305 is also implemented, so that a step of specially performing the local P-type doping is not required, and production efficiency can be improved. The part of the aluminum paste in the conductive adhesive pattern 313 mainly diffuses into a region in contact with the conductive adhesive pattern 313 in the silicon substrate 305, that is, the part of the aluminum paste in the conductive adhesive pattern 313 mainly diffuses into the region on which the electrode is to be formed in the silicon substrate 305. It should be noted that, when the part of the aluminum paste in the conductive adhesive pattern 313 diffuses into the region on which the electrode is to be formed in the silicon substrate 305, a formed P-type doping concentration is not specifically limited.

Optionally, referring to FIG. 49, the second conductive pattern 104 may also be a metal wire. A shape, a size, and the like of the metal wire are all not specifically limited.

Optionally, the forming the conductive adhesive pattern 313 may include: forming at least two conductive adhesive sub-patterns that are laminated, where a material of each of the conductive adhesive sub-patterns is an aluminum paste. During the sintering, an aluminum paste conductive adhesive sub-pattern closest to the silicon substrate 305 preferentially diffuses into the silicon substrate 305. Under a specific sintering heat, a remaining aluminum paste conductive adhesive sub-pattern may partially diffuse into the silicon substrate 305 or may not diffuse into the silicon substrate 305. In other words, during the diffusion, the aluminum paste conductive adhesive sub-pattern close to the silicon substrate 305 is equivalent to appropriately protecting the remaining aluminum paste conductive adhesive sub-pattern, so that the remaining aluminum paste conductive adhesive sub-pattern has little diffusion, so that a shape of the remaining aluminum paste conductive adhesive sub-pattern has little deformation. The remaining aluminum paste conductive adhesive sub-pattern is used as a part of the electrode, which can ensure precision of the formed electrode.

Optionally, referring to FIG. 44 to FIG. 47, the bonding part includes a conductive adhesive pattern 313, and the imprint template includes a third groove 105. Step C2 may include: forming the second conductive pattern 104 in the third groove 105 of the imprint template, and forming the conductive adhesive pattern 313 on the second conductive pattern 104, where the conductive adhesive pattern 313 is flush with a surface of a side of the imprint template provided with the third groove 105, or protrudes from the surface of the side of the imprint template provided with the third groove 105; and The second conductive pattern 104 herein may be a metal wire or the like. The metal wire or the like may be arranged in the third groove 105 of the imprint template, so that the metal wire can be stuck. After the metal wire is stuck, the metal wire is lower than a notch of the third groove 105, or is flush with from the notch of the third groove 105, to form the second conductive pattern on the imprint template. For a function and a structure of the imprint template herein, a manner of forming the conductive adhesive pattern 313, and the like, reference may be correspondingly made to the related descriptions in Embodiment 3, and the same or similar beneficial effects can be achieved. To avoid repetition, details are not described herein again. Step C3 may include: aligning the conductive adhesive pattern with the region on which the electrode is to be formed in the solar cell body, where the second conductive pattern 104 and the region on which the electrode is to be formed in the solar cell body are bonded together through the conductive adhesive pattern. The conductive adhesive pattern 313 is limited by the third groove 105, so that the process of forming the conductive adhesive pattern 313 is simpler.

The present invention is further described below with reference to a more detailed embodiment.

As shown in FIG. 33, a second conductive sub-pattern 1041 is a tin conductive sub-pattern with a thickness of 1 µm, a second conductive sub-pattern 1042 is a copper conductive sub-pattern with a thickness of 12 µm, and a second conductive sub-pattern 1043 is a tin conductive sub-pattern with a thickness of 0.5 µm. The second conductive sub-pattern 1041, the second conductive sub-pattern 1042, and the second conductive sub-pattern 1043 are all prepared through deposition and patterning.

In FIG. 33, a first conductive pattern 321 is a copper conductive pattern with a thickness of 20 nm, and the first conductive pattern 321 is obtained through deposition and patterning. A conductive adhesive pattern 313 may be a silver paste with a thickness of 5 nm, and the conductive adhesive pattern 313 is formed on the second conductive pattern 104, and may be obtained through screen printing. The first conductive pattern 321 and a second conductive pattern 104 are bonded together through the conductive adhesive pattern 313. During the bonding, the first conductive pattern 321 and the second conductive pattern 104 may be first bonded together through the conductive adhesive pattern 313, and then sintering is performed, where a sintering temperature may be about 800°C. It should be noted that, although a material of the conductive adhesive pattern 313 is the silver paste, a thickness of the conductive adhesive pattern 313 is less than a thickness of a silver paste gate line or a silver paste electrode in the related art. Therefore, costs of the solar cell are still low.

### Embodiment 5

Embodiment 5 provides a solar cell. Referring to FIG. 31, FIG. 32, and FIG. 33, the solar cell includes a solar cell body, and a positive electrode and a negative electrode arranged on the solar cell body, where a structure of the positive electrode and a structure of the negative electrode may be the same or may be different. An electrode (where the electrode may be the positive electrode or the negative electrode) of the solar cell includes a first conductive pattern 321, a third conductive pattern 313, and a second conductive pattern 104 sequentially laminated on the solar cell body, where the first conductive pattern 321 and the second conductive pattern 104 are connected together through the third conductive pattern 313. A grain size of the third conductive pattern 313 increases from a part close to the first conductive pattern 321 to a middle region, and increases from a part close to the second conductive pattern 104 to the middle region. In other words, both the first conductive pattern 321 and the second conductive pattern 104 are used as cathodes, and the third conductive pattern 313 is grown on both the second conductive pattern 104 and the first conductive pattern 321 through electroplating or chemical plating. That the third conductive pattern 313 is formed through electroplating or chemical plating means that, the third conductive pattern 313 is formed by connecting a part formed by using the second conductive pattern 104 as the cathode and through electroplating or chemical plating and a part formed by using the first conductive pattern 321 as the cathode and through electroplating or chemical plating. In the third conductive pattern 313, a grain size of a part close to the cathode is smaller, and a grain size of a part away from the cathode is larger. A specific value of the grain size of the part close to the cathode is not limited. A specific value of the grain size of the part away from the cathode is also not limited. A difference between the grain size of the part away from the cathode and the grain size of the part close to the cathode is also not specifically limited. A topography of a surface of the third conductive pattern 313 close to the first conductive pattern 321 continues a topography of the first conductive pattern 321 close to the third conductive pattern 313. A topography of a surface of the third conductive pattern 313 close to the second conductive pattern 104 continues a topography of the second conductive pattern 104 close to the third conductive pattern 313.

For the solar cell body herein, reference may be made to the related descriptions in Embodiment 1, and the same or similar beneficial effects can be achieved. To avoid repetition, details are not described herein again.

The first conductive pattern 321 and the second conductive pattern 104 are connected together through the third conductive pattern 313 formed through electroplating or chemical plating. The electroplating or chemical plating process is simple and mature, and mass production is easy to be implemented. In addition, the electroplating or the chemical plating features a low bonding temperature and high bonding strength. The low bonding temperature can reduce a heat effect on the solar cell body, thereby having little effect on photoelectric conversion efficiency of the solar cell. The high bonding strength can make the electrode of the solar cell have good reliability. Materials of the second conductive pattern 104 and the first conductive pattern 321 can conduct electricity, are not limited to a silver paste, and have more material selections; and compared with the silver paste, selecting copper, tin, or the like can appropriately reduce costs. In addition, a material of the third conductive pattern 313 can conduct electricity, is not limited to the silver paste, and has more material selections; and compared with the silver paste, selecting copper, tin, or the like can appropriately reduce costs. In addition, the silver paste is granular, resulting in little contact between silver particles; and the silver paste includes an organic component, and the organic component also affects the contact between the silver particles. In this way, an electrode made of a silver paste has high resistivity and poor conductivity performance. However, in this embodiment of the present invention, a material of the electrode may not be granular (for example, a silver paste), and the material of the electrode may be, for example, silver, copper, tin, or an alloy thereof, so that the electrode has good conductivity performance. In addition, because the second conductive pattern 104 may not be prepared on the solar cell body, a process of preparing the second conductive pattern has little or substantially no effect on the solar cell body, and mass production is easy to be implemented. Therefore, preparation costs can be reduced.

It should be noted that, the materials of the first conductive pattern 321, the third conductive pattern 313, and the second conductive pattern 104 may be materials that can conduct electricity, and the materials of the first conductive pattern 321, the third conductive pattern 313, and the second conductive pattern 104 are not specifically limited.

Optionally, referring to FIG. 31 to FIG. 33, the third conductive pattern 313 is closer to the solar cell body than the second conductive pattern 104 is. In FIG. 31, a direction shown by a dashed arrow L1 is a direction away from the solar cell body. In the direction away from the solar cell body, an area of a cross section of a partial region of the second conductive pattern 104 away from the solar cell body gradually decreases, where the cross section is perpendicular to a lamination direction of the third conductive pattern 313 and the second conductive pattern 104. In other words, the farther away from the third conductive pattern 313, the smaller the area of the cross section of the partial region of the second conductive pattern 104 away from the solar cell body. This design helps reduce reflection and shading, so that the photoelectric conversion efficiency of the solar cell can be increased.

Optionally, a shape of a longitudinal section of the second conductive pattern 104 or a partial region of the second conductive pattern 104 away from the solar cell body is a triangle, a trapezoid, or a shape formed by an arc and a line segment connecting two endpoints of the arc, where a length of the line segment is less than or equal to a diameter of a circle corresponding to the arc; and the longitudinal section is parallel to a lamination direction of the third conductive pattern 313 and the second conductive pattern 104. For the longitudinal section and the like, reference may be correspondingly made to the related descriptions in Embodiment 1, and the same or similar beneficial effects can be achieved. To avoid repetition, details are not described herein again.

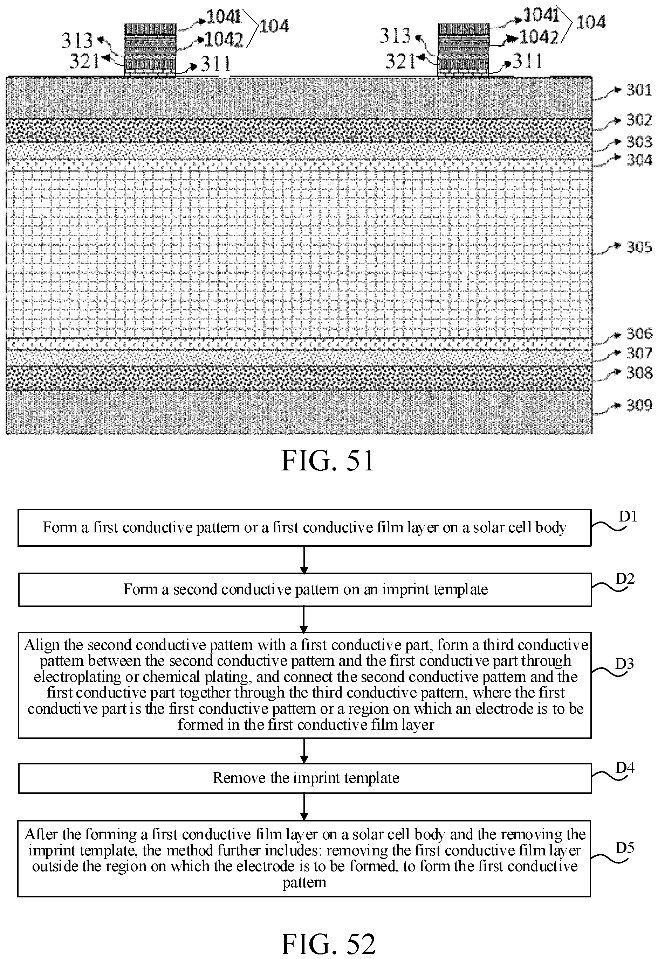

FIG. 51 is a schematic diagram of a structure of a ninth HJT solar cell according to an exemplary embodiment of the present invention. Optionally, referring to FIG. 51, the electrode of the solar cell further includes a bonding pattern 311 located between the first conductive pattern 321 and the solar cell body. For a material, a thickness, and the like of the bonding pattern 311, reference may be correspondingly made to the related descriptions in Embodiment 1, and the same or similar beneficial effects can be achieved. To avoid repetition, details are not described herein again.

Optionally, for the materials, shapes, thicknesses, structures, and the like of the first conductive pattern 321 and the second conductive pattern in Embodiment 5, reference may be correspondingly made to the related descriptions in Embodiment 1, and the same or similar beneficial effects can be achieved. To avoid repetition, details are not described herein again.

Optionally, referring to FIG. 31 to FIG. 33, and FIG. 51, the second conductive pattern 104 is formed by at least two second conductive sub-patterns laminated in the direction parallel to the lamination direction of the third conductive pattern 313 and the second conductive pattern 104. For the arranged at least two second conductive sub-patterns, reference may be correspondingly made to the related descriptions in Embodiment 1, and the same or similar beneficial effects can be achieved. To avoid repetition, details are not described herein again.

Optionally, a material of a second conductive sub-pattern 1041 farthest away from the third conductive pattern 313 in the second conductive pattern 104 may include tin. For an advantage, a component, and the like of tin herein, reference may be correspondingly made to the related descriptions in Embodiment 1, and the same or similar beneficial effects can be achieved. To avoid repetition, details are not described herein again.

Optionally, in a direction parallel to the lamination direction of the solar cell body and the first conductive pattern 321, the second conductive pattern 104 includes a seed layer pattern and a plating pattern that are laminated, where the plating pattern is closer to the solar cell body than the seed layer pattern is, and the plating pattern wraps the seed layer pattern. For the descriptions herein, reference may be correspondingly made to the related descriptions in Embodiment 1, and the same or similar beneficial effects can be achieved. To avoid repetition, details are not described herein again.

Embodiment 5 further provides a method for preparing a solar cell, which can be used to prepare the solar cell in Embodiment 5. FIG. 52 is a flowchart of steps of a fifth method for preparing a solar cell according to an exemplary embodiment of the present invention. Referring to FIG. 52, the method for preparing a solar cell includes the following steps.

Step D1: Form a first conductive pattern or a first conductive film layer on a solar cell body.

For Step D1, reference may be correspondingly made to the related descriptions in Embodiment 1, and the same or similar beneficial effects can be achieved. To avoid repetition, details are not described herein again.

Optionally, the forming a first conductive pattern or a first conductive film layer on a solar cell body may include: laying a metal foil on the solar cell body, to form the first conductive film layer. For the part, reference may be correspondingly made to the related descriptions in Embodiment 1, and the same or similar beneficial effects can be achieved. To avoid repetition, details are not described herein again.

Optionally, after the laying a metal foil on the solar cell body, the method may include: pressing the metal foil, to bond the metal foil to the solar cell body. For the part, reference may be correspondingly made to the related descriptions in Embodiment 1, and the same or similar beneficial effects can be achieved. To avoid repetition, details are not described herein again.

Step D2: Form a second conductive pattern on an imprint template.

For Step D2, reference may be correspondingly made to the related descriptions in Embodiment 1, and the same or similar beneficial effects can be achieved. To avoid repetition, details are not described herein again.

Step D3: Align the second conductive pattern with a first conductive part, form a third conductive pattern between the second conductive pattern and the first conductive part through electroplating or chemical plating, and connect the second conductive pattern and the first conductive part together through the third conductive pattern, where the first conductive part is the first conductive pattern or a region on which an electrode is to be formed in the first conductive film layer.

For that a second conductive pattern 104 is aligned with the first conductive part, reference may be correspondingly made to the related descriptions in Embodiment 1, and the same or similar beneficial effects can be achieved. To avoid repetition, details are not described herein again.

After the first conductive part is aligned with the second conductive pattern 104, the second conductive pattern 104 and the first conductive part are connected together through a third conductive pattern 313 formed through electroplating or chemical plating, so that after the imprint template is removed, the second conductive pattern 104 located on the imprint template is transferred to a first conductive film layer 321 or a first conductive pattern 321 on the solar cell body. The electroplating or the chemical plating features a low bonding temperature and high bonding strength. The low bonding temperature can reduce a heat effect on the solar cell body, thereby having little effect on photoelectric conversion efficiency of the solar cell. The high bonding strength can make the electrode of the solar cell have good reliability. Compared with screen printing, in the present invention, materials of the second conductive pattern, the third conductive pattern, and the first conductive film layer or the first conductive pattern can conduct electricity, and are not limited to a silver paste. Therefore, costs can be appropriately reduced. Compared with laser transfer printing, in the present invention, the second conductive pattern and the first conductive pattern can be connected together through the third conductive pattern formed through electroplating or chemical plating, or the second conductive pattern and the region on which the electrode is to be formed in the first conductive film layer can be connected together through the third conductive pattern formed through electroplating or chemical plating. The electroplating or chemical plating process is mature, and process difficulty is relatively low, so that production efficiency can be appropriately improved.

The electroplating is to plate the material of the third conductive pattern on a surface of the second conductive pattern close to the first conductive pattern by using the principle of electrolysis, and plate the material of the third conductive pattern on a surface of the first conductive pattern close to the second conductive pattern by using the principle of electrolysis. The chemical plating is to reduce metal ions in a chemical plating solution to a metal by using an appropriate reducing agent without an external current, deposit the metal onto a surface of the second conductive pattern close to the first conductive pattern, and deposit the metal onto a surface of the first conductive pattern close to the second conductive pattern. A process parameter such as a temperature of the electroplating or the chemical plating is not specifically limited, and is suitable for forming the third conductive pattern. A specific manner of the chemical plating is not limited. For example, the chemical plating may be lithium plating.

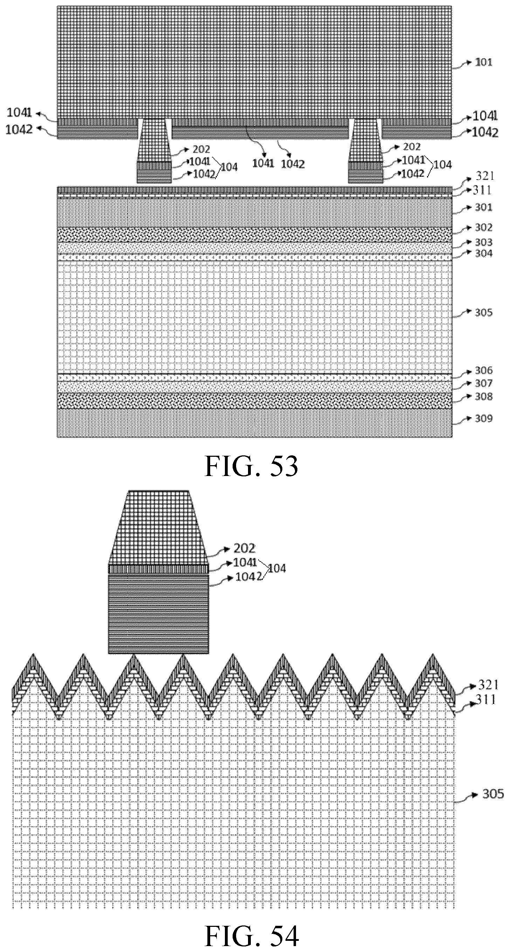

FIG. 53 is a schematic diagram of a seventh structure in which a second conductive pattern is aligned with a region on which an electrode is to be formed in a first conductive film layer according to an exemplary embodiment of the present invention. FIG. 54 is a schematic diagram of a locally enlarged structure in which a second conductive pattern is aligned with a region on which an electrode is to be formed in a first conductive film layer according to an exemplary embodiment of the present invention. Referring to FIG. 53 and FIG. 54, that the second conductive pattern 104 is aligned with the region on which the electrode is to be formed in the first conductive film layer 321 is similar to that the second conductive pattern 104 is aligned with the first conductive pattern 321. Reference may be made to the foregoing related descriptions, and the same or similar beneficial effects can be achieved. To avoid repetition, details are not described herein again.

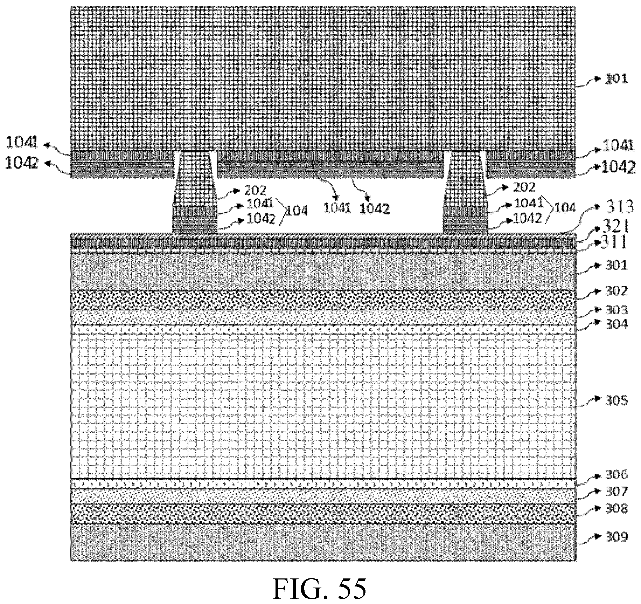

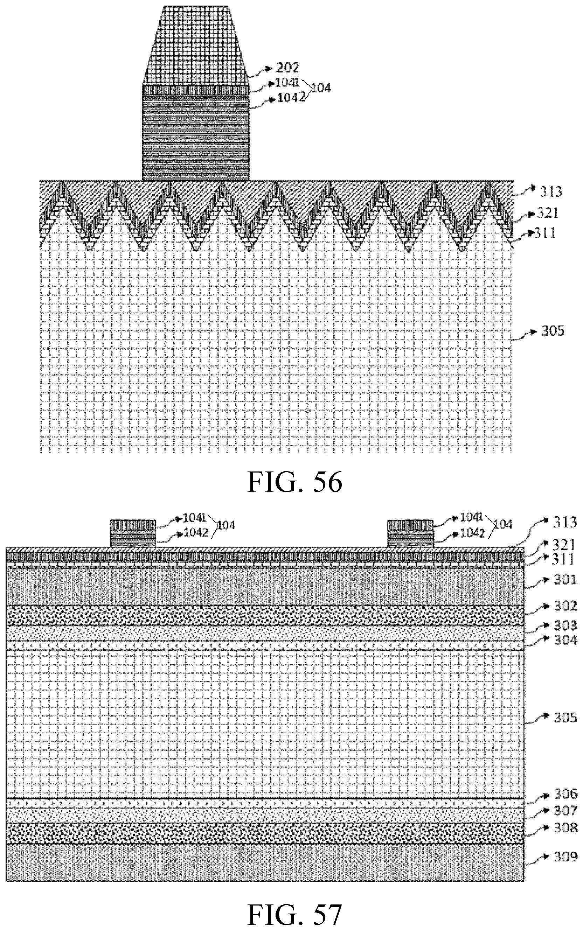

FIG. 55 is a schematic diagram of a structure in which a third conductive film layer is formed between a second conductive pattern and a region on which an electrode is to be formed in a first conductive film layer through electroplating or chemical plating according to an exemplary embodiment of the present invention. FIG. 56 is a schematic diagram of a locally enlarged structure in which a third conductive film layer is formed between a second conductive pattern and a region on which an electrode is to be formed in a first conductive film layer through electroplating or chemical plating according to an exemplary embodiment of the present invention. Referring to FIG. 55 and FIG. 56, for that the second conductive pattern 104 and the region on which the electrode is to be formed in the first conductive film layer 321 are connected together through the third conductive pattern formed through electroplating or chemical plating, reference may also be made to the foregoing related descriptions in which the second conductive pattern 104 and the first conductive pattern 321 are connected together through the third conductive pattern 313 formed through electroplating or chemical plating, and the same or similar beneficial effects can be achieved. To avoid repetition, details are not described herein again. It should be noted that, in Step D3, the forming a third conductive pattern between the second conductive pattern and the region on which the electrode is to be formed in the first conductive film layer through electroplating or chemical plating may include: forming a third conductive film layer between the second conductive pattern and the region on which the electrode is to be formed in the first conductive film layer through electroplating or chemical plating, and patterning the third conductive film layer, to obtain the third conductive pattern. In some examples, the third conductive film layer may be patterned after the imprint template is removed. The patterning manner is not specifically limited. For example, patterning may be implemented by laser.

It should be noted that, if a pyramid textured structure is formed in the first conductive pattern 321 or the region on which the electrode is to be formed in the first conductive film layer, the third conductive pattern or a third conductive film layer 313 is filled in the textured structure during the electroplating or chemical plating of the third conductive pattern.

Step D4: Remove the imprint template.

For Step D4, reference may be correspondingly made to the related descriptions in Embodiment 1, and the same or similar beneficial effects can be achieved. To avoid repetition, details are not described herein again.

FIG. 57 is a schematic diagram of a structure in which an imprint template is removed according to an exemplary embodiment of the present invention. The second conductive pattern 104 located on the imprint template is transferred to the first conductive film layer 321 or the first conductive pattern 321 on the solar cell body, so that the electrode of the solar cell is substantially formed. Then, the imprint template is removed. The imprint template may be removed by using mechanical external force or the like. The manner of removing the imprint template is not specifically limited in the embodiments of the present invention. Removing the imprint template mainly relies on that bonding force between the second conductive pattern 104 and the imprint template is less than electroplating or chemical plating connecting force between the second conductive pattern 104 and the third conductive pattern 313, to remove the imprint template. Optionally, a coating or the like for making the second conductive pattern 104 easy to be separated from the imprint template may be coated between the imprint template and the second conductive pattern 104, thereby further facilitating removing the imprint template. For example, tin or a tin alloy is provided between the imprint template and the second conductive pattern 104. Tin or the tin alloy has a low melting point, so that the imprint template can be easily removed.

It should be noted that, after the imprint template is removed, second conductive pattern residues on the imprint template may be further cleaned by using an acid solution or an alkali solution, so that the imprint template can be reused. For the descriptions herein, reference may be correspondingly made to the related descriptions in Embodiment 1, and the same or similar beneficial effects can be achieved. To avoid repetition, details are not described herein again.

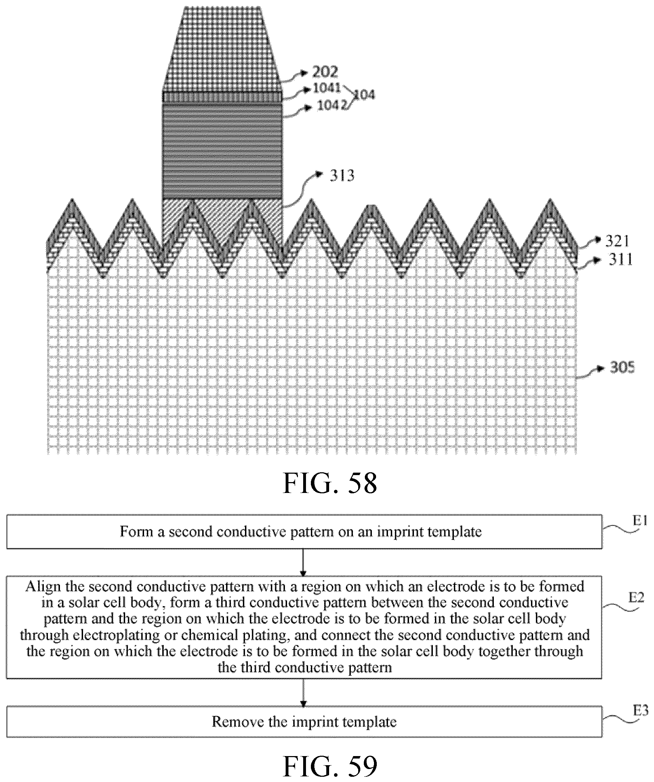

FIG. 58 is a schematic diagram of a locally enlarged structure in which an imprint template is removed according to an exemplary embodiment of the present invention. It should be noted that, as shown in FIG. 55 to FIG. 57, if the entire third conductive film layer 313 is formed through electroplating or chemical plating, as shown in FIG. 58, the third conductive film layer 313 outside a region of the electrode may be removed by using a removal solution corresponding to the material of the third conductive film layer 313, to form the third conductive pattern, thereby avoiding a problem such as a short circuit. If the pyramid textured structure is formed in the first conductive pattern 321 or the region on which the electrode is to be formed in the first conductive film layer, the textured structure outside the region on which the electrode is to be formed in the first conductive film layer is re-exposed when the third conductive film layer 313 outside the region of the electrode is removed.

Step D5: After the forming a first conductive film layer on a solar cell body and the removing the imprint template, the method further includes: removing the first conductive film layer outside the region on which the electrode is to be formed, to form the first conductive pattern.

For Step D5, reference may be correspondingly made to the related descriptions in Embodiment 1, and the same or similar beneficial effects can be achieved. To avoid repetition, details are not described herein again.

FIG. 31 to FIG. 33 may be schematic diagrams of structures after the first conductive film layer outside the region of the electrode is removed to form the first conductive pattern 321.

Optionally, before Step D3, the method may further include: annealing the imprint template on which the second conductive pattern 104 has been formed. For an annealing manner, an annealing temperature, and the like in Embodiment 5, reference may be correspondingly made to the related descriptions in Embodiment 1, and the same or similar beneficial effects can be achieved. To avoid repetition, details are not described herein again.

Optionally, before the forming a first conductive pattern or a first conductive film layer on the solar cell body, the method may further include: forming a bonding pattern 311 or a bonding film layer 311 on the solar cell body. For a function, a material, a forming manner, and the like of the bonding pattern 311 or the bonding film layer 311, reference may be correspondingly made to the related descriptions in Embodiment 1, and the same or similar beneficial effects can be achieved. To avoid repetition, details are not described herein again.

Optionally, referring to FIG. 21, the imprint template includes a first groove 103. Referring to FIG. 11 and FIG. 12, Step D2 may include: forming the second conductive pattern 104 in the first groove 103 of the imprint template, where the second conductive pattern 104 is flush with a surface of a side of the imprint template provided with the first groove 103, or protrudes from the surface of the side of the imprint template provided with the first groove 103. In this way, in the process of forming the third conductive pattern 313 between the second conductive pattern 104 and the first conductive pattern 321 or the region on which the electrode is to be formed in the first conductive film layer 321 through electroplating or chemical plating, only the second conductive pattern 104 is closer to the first conductive pattern 321 or the region on which the electrode is to be formed in the first conductive film layer 321, the third conductive pattern can only be formed between the second conductive pattern 104 and the first conductive pattern 321 or the region on which the electrode is to be formed in the first conductive film layer 321 through electroplating or chemical plating, and the third conductive pattern is substantially not formed on a remaining part of the imprint template through electroplating or chemical plating. In this way, the imprint template cannot be polluted, and a material used for electroplating or chemical plating can be reduced. The first groove 103 is used as a gate line plate corresponding to the second conductive pattern 104, to form the second conductive pattern 104 with a precise shape. The second conductive pattern may be formed in the first groove 103 of the imprint template through electroplating, deposition, or the like. This is not specifically limited in the embodiments. It should be noted that, if the deposition manner is selected, after the deposition is completed, the second conductive film layer outside the first groove 103 further needs to be etched away.

For a forming manner, a structure, and a size of the first groove 103, a material of the substrate, and the like, reference may be correspondingly made to the related descriptions in Embodiment 1, and the same or similar beneficial effects can be achieved. To avoid repetition, details are not described herein again.

Optionally, referring to FIG. 21, the imprint template further includes the substrate 101, the first groove 103 is arranged on the substrate 101, and the imprint template further includes a first boss 102 arranged on the substrate 101 and located on an edge of the first groove 103. Referring to FIG. 11 and FIG. 12, the forming the second conductive pattern 104 in the first groove 103 of the imprint template includes: forming the second conductive pattern 104 in the first groove 103 of the imprint template and in a region defined by the first boss 102, where the second conductive pattern 104 is flush with a surface of the first boss 102 away from the substrate 101, or protrudes from the surface of the first boss 102 away from the substrate 101. Referring to FIG. 15, the first boss 102 protrudes from the substrate 101. Therefore, in the process of aligning the region on which the electrode is to be arranged in the first conductive film layer 321 with the second conductive pattern 104 and forming the third conductive pattern through electroplating or chemical plating, only a part of the second conductive pattern 104 protruding from the surface of the first boss 102 away from the substrate 101 or only a part of the second conductive pattern 104 flush with the surface of the first boss 102 away from the substrate 101 is closer to the region on which the electrode is to be arranged in the first conductive film layer 321, the third conductive pattern can only be formed between the second conductive pattern 104 and the region on which the electrode is to be arranged in the first conductive film layer 321 through electroplating or chemical plating, and the third conductive pattern is substantially not formed on a remaining part of the imprint template through electroplating or chemical plating. In this way, the imprint template cannot be polluted, and a material used for electroplating or chemical plating can be reduced.

It should be noted that, for an advantage of not forming the second conductive pattern on the surface of the first boss 102 away from the substrate 101, a method of preparing the first boss 102, and the like, reference may be made to the related descriptions in Embodiment 1, and the same or similar beneficial effects can be achieved. To avoid repetition, details are not described herein again.

Optionally, referring to FIG. 21, in a direction from a notch of the first groove 103 to a groove bottom of the first groove 103, an area of a cross section of the first groove 103 gradually decreases, where the cross section of the first groove 103 is perpendicular to a lamination direction of a conductive adhesive film layer 313 or a conductive adhesive pattern 313 and the second conductive pattern 104. For the cross section of the first groove 103, reference may be made to the related descriptions in Embodiment 1, and the same or similar beneficial effects can be achieved. To avoid repetition, details are not described herein again.

Optionally, optionally, referring to FIG. 22 to FIG. 24, the imprint template includes the substrate 101 and a second boss 202 located on the substrate 101. A quantity of second bosses 202 on the substrate 101 is not specifically limited. For the quantity of second bosses 202, and forming manners of the second boss 202 and the substrate 101, reference may be made to the related descriptions in Embodiment 1, and the same or similar beneficial effects can be achieved. To avoid repetition, details are not described herein again. Referring to FIG. 13 and FIG. 14, Step D2 may include: forming a second conductive film layer 104 on a side of the imprint template on which the second boss 202 is formed, where a part of the second conductive film layer 104 located on the second boss 202 is the second conductive pattern. For that the second conductive film layer 104 is formed through deposition, electroplating, or the like, a height difference between the second boss 202 and the substrate 101 may be used to disconnect the part of the second conductive film layer 104 located on the second boss 202 from a part of the second conductive film layer 104 located on the substrate 101. For the descriptions herein, reference may be made to the related descriptions in Embodiment 1, and the same or similar beneficial effects can be achieved. To avoid repetition, details are not described herein again.

The second conductive film layer 104 herein may be a metal foil, and Step D2 may include: laying the metal foil on the side of the imprint template on which the second boss 202 is formed, where a part of the metal foil located on the second boss 202 is the second conductive pattern 104. A part of the metal foil located outside the second boss 202 is absorbed on the substrate 101. In this way, after the second conductive pattern 104 is aligned with the first conductive pattern 321 or the region on which the electrode is to be arranged in the first conductive film layer 321, it can be ensured that only the part of the metal foil located on the second boss 202 is closer to the first conductive pattern 321, the third conductive pattern can only be formed between the second conductive pattern 104 and the region on which the electrode is to be arranged in the first conductive film layer 321 through electroplating or chemical plating, and the third conductive pattern is substantially not formed on a remaining part of the imprint template through electroplating or chemical plating. In this way, the imprint template cannot be polluted, and a material used for electroplating or chemical plating can be reduced. For the descriptions herein, reference may be made to Embodiment 1. To avoid repetition, details are not described again.

Small burrs or the like may be provided on a surface of the second boss 202 away from the substrate 101. The small burrs or the like may hang the metal foil, so that the second conductive pattern is not prone to positional deviation or the like in the process of aligning the second conductive pattern with the first conductive pattern or the region on which the electrode is to be arranged in the first conductive film layer and forming the third conductive pattern through electroplating or chemical plating. A material of the metal foil herein is the same as or similar to the material of the second conductive pattern described above. For example, the metal foil may be a copper foil.

Optionally, referring to FIG. 22 or FIG. 24, the surface of the second boss 202 away from the substrate 101 is a plane, so that a surface of the formed second conductive pattern 104 close to the second boss 202 is also a plane. Alternatively, optionally, referring to FIG. 23, a side of the second boss 202 away from the substrate 101 includes a second groove 2021. The forming a second conductive pattern on an imprint template includes: forming the second conductive pattern in the second groove 2021. For a shape, a function, and the like of the second groove 2021, reference may be correspondingly made to the related descriptions in Embodiment 1, and the same or similar beneficial effects can be achieved. To avoid repetition, details are not described herein again.

Optionally, referring to FIG. 26 to FIG. 28, Step D2 may include: forming a seed pattern 1047 on the imprint template; and forming a plating pattern 1048 on the seed pattern 1047 through electroplating or chemical plating, where the plating pattern 1048 and the seed pattern 1047 together form the second conductive pattern 104. A function of the imprint template herein is mainly to provide a carrying table for forming the seed pattern. For the descriptions herein, reference may be correspondingly made to the related descriptions in Embodiment 1, and the same or similar beneficial effects can be achieved. To avoid repetition, details are not described herein again.

Optionally, the imprint template may include a substrate, and Step D2 may include: laying a metal foil on the substrate, and patterning the metal foil, to form the second conductive pattern. For laying of the metal foil, patterning of the metal foil, and the like, reference may be correspondingly made to the related descriptions in Embodiment 1, and the same or similar beneficial effects can be achieved. To avoid repetition, details are not described herein again.

Optionally, before Step D2, the method may further include: providing a plurality of metal foil patterns; the imprint template may include a plurality of adsorption regions; and Step D2 may include: at least aligning one of the adsorption regions with one of the metal foil patterns, and adsorbing the metal foil pattern on the adsorption region, to form the second conductive pattern on the imprint template. For providing of a metal foil, the aligning of the metal foil pattern, the absorption of the metal foil, and the like, reference may be correspondingly made to the related descriptions in Embodiment 1, and the same or similar beneficial effects can be achieved. To avoid repetition, details are not described herein again.

Optionally, the second conductive pattern 104 may also be a metal wire. Optionally, a surface of the metal wire may be further coated with a coating. For a shape and a size of the metal wire, a thickness and a material of the coating, an arrangement manner of the metal wire, and the like, reference may be correspondingly made to the related descriptions in Embodiment 1, and the same or similar beneficial effects can be achieved. To avoid repetition, details are not described herein again.

### Embodiment 6

Embodiment 6 provides another solar cell. The solar cell includes a solar cell body, and a positive electrode and a negative electrode arranged on the solar cell body, where a structure of the positive electrode and a structure of the negative electrode may be the same or may be different. Referring to FIG. 47, an electrode (where the electrode may be the positive electrode or the negative electrode) of the solar cell includes a third conductive pattern 313 and a second conductive pattern 104 laminated on the solar cell body, where the second conductive pattern 104 is connected to the solar cell body through the third conductive pattern 313; and a grain size of the third conductive pattern 313 increases from a part close to the solar cell body to a middle region, and increases from a part close to the second conductive pattern 104 to the middle region.

For the solar cell body, reference is made to the related descriptions in Embodiment 5. To avoid repetition, details are not described herein again. For example, the solar cell body herein may be a part that can conduct electricity, for example, a TCO film or a silicon substrate. If a passivation layer or the like is further arranged on the solar cell body, the passivation layer may be grooved, so that the part that can conduct electricity is exposed. For distribution of the grain size of the third conductive pattern, and the like, reference may be made to the related descriptions in Embodiment 5. To avoid repetition, details are not described herein again.

Referring to FIG. 47 to FIG. 49, the second conductive pattern 104 is connected to the solar cell body through the third conductive pattern 313 formed through electroplating or chemical plating. The electroplating or chemical plating process is simple and mature, and mass production is easy to be implemented. In addition, the electroplating or the chemical plating features a low bonding temperature and high bonding strength. The low bonding temperature can reduce a heat effect on the solar cell body, thereby having little effect on photoelectric conversion efficiency of the solar cell. The high bonding strength can make the electrode of the solar cell have good reliability. Materials of the second conductive pattern and the third conductive pattern can conduct electricity, are not limited to a silver paste, and have more material selections; and compared with the silver paste, selecting copper, tin, or the like can appropriately reduce costs. In addition, the silver paste is granular, resulting in little contact between silver particles; and the silver paste includes an organic component, and the organic component also affects the contact between the silver particles. In this way, an electrode made of a silver paste has high resistivity and poor conductivity performance. However, in this embodiment of the present invention, a material of the electrode may not be granular (for example, a silver paste), and the material of the electrode may be, for example, silver, copper, tin, or an alloy thereof, so that the electrode has good conductivity performance. In addition, because a second conductive pattern 104 is not prepared on the solar cell body, a process of preparing the second conductive pattern has little or substantially no effect on the solar cell body, and mass production is easy to be implemented. Therefore, preparation costs can be reduced.

It should be noted that, the materials of the second conductive pattern and the third conductive pattern can conduct electricity. The materials of the second conductive pattern and the third conductive pattern are not specifically limited. For example, the materials of the second conductive pattern and the third conductive pattern may include metals such as nickel and aluminum. For example, the material of the second conductive pattern may be singular nickel or a nickel alloy, or the material of the second conductive pattern may be aluminum. The electroplating or chemical plating process is simple and mature, and mass production is easy to be implemented. In addition, the low bonding temperature can reduce the heat effect on the solar cell body. In addition, the high bonding strength of the electroplating or chemical plating can make the electrode of the solar cell have good reliability.

In addition, compared with screen printing, the second conductive pattern and the third conductive pattern can conduct electricity, and are not limited to the silver paste. Therefore, costs can be appropriately reduced. In addition, compared with laser transfer printing, in the present invention, the second conductive pattern and the solar cell body are connected together through the third conductive pattern formed through electroplating or chemical plating. The electroplating or chemical plating process is mature, and process difficulty is relatively low, so that production efficiency can be appropriately improved.

Optionally, for a shape, a thickness, the material, a structure, and the like of the second conductive pattern, and a shape, a thickness, the material, a structure, and the like of the third conductive pattern in Embodiment 6, reference may be correspondingly made to the related descriptions in Embodiment 5, and the same or similar beneficial effects can be achieved. To avoid repetition, details are not described herein again.

Optionally, in a direction parallel to a lamination direction of the solar cell body and a first conductive pattern 321, the second conductive pattern 104 includes a seed layer pattern and a plating pattern that are laminated, where the plating pattern is closer to the solar cell body than the seed layer pattern is, and the plating pattern wraps the seed layer pattern. For the descriptions herein, reference may be correspondingly made to the related descriptions in Embodiment 1, and the same or similar beneficial effects can be achieved. To avoid repetition, details are not described herein again.

Embodiment 6 further provides a method for preparing a solar cell, which can be used to prepare the solar cell in Embodiment 6. FIG. 59 is a flowchart of steps of a sixth method for preparing a solar cell according to an exemplary embodiment of the present invention. Referring to FIG. 59, the method for preparing a solar cell includes the following steps.

Step E1: Form a second conductive pattern on an imprint template.

For Step E1, reference may be made to the related descriptions in Embodiment 5, and the same or similar beneficial effects can be achieved. To avoid repetition, details are not described herein again.

Step E2: Align the second conductive pattern with a region on which an electrode is to be formed in a solar cell body, form a third conductive pattern between the second conductive pattern and the region on which the electrode is to be formed in the solar cell body through electroplating or chemical plating, and connect the second conductive pattern and the region on which the electrode is to be formed in the solar cell body together through the third conductive pattern.

For the aligning in Step E2, reference may also be made to the related descriptions in Embodiment 5. To avoid repetition, details are not described herein again. In Step E2, the second conductive pattern is transferred to the solar cell body.

Step E3: Remove the imprint template.

For Step E3, reference may be made to the related descriptions in Embodiment 5, and the same or similar beneficial effects can be achieved. To avoid repetition, details are not described herein again.

Optionally, before the electroplating or the chemical plating, the method may further include: annealing the imprint template on which the second conductive pattern has been formed, to cause the second conductive pattern to recrystallize, to eliminate a stress. For an annealing temperature, annealing time, an annealing manner, and the like, reference may be correspondingly made to the related descriptions in Embodiment 5, and the same or similar beneficial effects can be achieved. To avoid repetition, details are not described herein again.

Optionally, referring to FIG. 21, the imprint template includes a first groove 103. Referring to FIG. 11 and FIG. 12, Step E1 may include: forming a second conductive pattern 104 in the first groove 103 of the imprint template, where the second conductive pattern 104 is flush with a surface of a side of the imprint template provided with the first groove 103, or protrudes from the surface of the side of the imprint template provided with the first groove 103. For that the second conductive pattern is formed in the first groove 103 of the imprint template, reference may be made to the related descriptions in Embodiment 5, and the same or similar beneficial effects can be achieved. To avoid repetition, details are not described herein again.

Optionally, referring to FIG. 21, the imprint template further includes a substrate 101, the first groove 103 is arranged on the substrate 101, and the imprint template may further include a first boss 102 arranged on the substrate 101 and located on an edge of the first groove 103. Step E1 may include: forming the second conductive pattern 104 in the first groove 103 and in a region defined by the first boss 102, where the second conductive pattern 104 is flush with a surface of the first boss 102 away from the substrate 101, or protrudes from the surface of the first boss 102 away from the substrate 101. For the descriptions herein, reference may also be made to the related descriptions in Embodiment 5, and the same or similar beneficial effects can be achieved. To avoid repetition, details are not described herein again.

Optionally, referring to FIG. 21, in a direction from a notch of the first groove 103 to a groove bottom of the first groove 103, an area of a cross section of the first groove 103 gradually decreases, where the cross section of the first groove 103 is perpendicular to a lamination direction of the second conductive pattern and a conductive adhesive film layer 313 or a conductive adhesive pattern 313. Further, in the direction from the notch of the first groove 103 to the groove bottom of the first groove 103, an area of a cross section of the formed second conductive pattern also gradually decreases, to facilitate reducing shading and reflection. For the descriptions herein, reference may also be made to the related descriptions in Embodiment 5, and the same or similar beneficial effects can be achieved. To avoid repetition, details are not described herein again.

Optionally, referring to FIG. 22 to FIG. 24, the imprint template includes a substrate 101 and a second boss 202 located on the substrate 101. A quantity of second bosses 202 on the substrate 101 is not specifically limited. Referring to FIG. 12 and FIG. 13, Step E1 may include: forming the second conductive pattern on a side of the imprint template on which the second boss 202 is formed. For a manner of forming the second conductive pattern, the quantity of second bosses, and the like, reference may be correspondingly made to the related descriptions in Embodiment 1, and the same or similar beneficial effects can be achieved. To avoid repetition, details are not described herein again.

Optionally, a surface of the second boss 202 away from the substrate 101 is a plane; or optionally, a side of the second boss 202 away from the substrate 101 includes a second groove 2021, where the second conductive pattern 104 is flush with a notch of the second groove 2021, or protrudes from the second groove 2021. For the descriptions herein, reference may be correspondingly made to the related descriptions in Embodiment 5, and the same or similar beneficial effects can be achieved. To avoid repetition, details are not described herein again.

Optionally, referring to FIG. 26 to FIG. 28, Step E1 may include: forming a seed pattern 1047 on the imprint template; and forming a plating pattern 1048 on the seed pattern 1047 through electroplating or chemical plating, where the plating pattern 1048 and the seed pattern 1047 together form a second conductive pattern 104. A function of the imprint template herein is mainly to provide a carrying table for forming the seed pattern. For the descriptions herein, reference may be correspondingly made to the related descriptions in Embodiment 1, and the same or similar beneficial effects can be achieved. To avoid repetition, details are not described herein again.

Optionally, the imprint template includes a substrate 101, and Step E1 may include: laying a metal foil on the substrate, and patterning the metal foil, to form the second conductive pattern. For the descriptions herein, reference may be correspondingly made to the related descriptions in Embodiment 5, and the same or similar beneficial effects can be achieved. To avoid repetition, details are not described herein again.

Optionally, before Step E1, the method may further include: providing a plurality of metal foil patterns; the imprint template may include a plurality of adsorption regions; and Step E1 may include: at least aligning one of the adsorption regions with one of the metal foil patterns, and adsorbing the metal foil pattern on the adsorption region, to form the second conductive pattern on the imprint template. For the descriptions herein, reference may be correspondingly made to the related descriptions in Embodiment 5, and the same or similar beneficial effects can be achieved. To avoid repetition, details are not described herein again.

The present invention is further described below with reference to a more detailed embodiment.

As shown in FIG. 33, a second conductive pattern 104 includes a second conductive sub-pattern 1041, a second conductive sub-pattern 1042, and a second conductive sub-pattern 1043, where the second conductive sub-pattern 1041 is a tin conductive sub-pattern with a thickness of 1 µm, the second conductive sub-pattern 1042 is a copper conductive sub-pattern with a thickness of 12 µm, and the second conductive sub-pattern 1043 is a tin conductive sub-pattern with a thickness of 0.5 µm. The second conductive sub-pattern 1041, the second conductive sub-pattern 1042, and the second conductive sub-pattern 1043 are all prepared through deposition and patterning.

**In** FIG. 33, a first conductive pattern 321 is a copper conductive pattern with a thickness of 20 nm, and the first conductive pattern 321 is obtained through deposition and patterning. The first conductive pattern 321 and the second conductive pattern 104 are connected together through a third conductive pattern 313 formed through electroplating or chemical plating. The third conductive pattern 313 may be copper of 3 nm.

### Embodiment 7

Embodiment 7 provides a solar cell. Referring to FIG. 2, FIG. 3, FIG. 4, and FIG. 5, the solar cell includes a solar cell body, and a positive electrode and a negative electrode arranged on the solar cell body, where a structure of the positive electrode and a structure of the negative electrode may be the same or may be different. An electrode (where the electrode may be the positive electrode or the negative electrode) of the solar cell includes a first conductive pattern 321 and a second conductive pattern 104 laminated on the solar cell body, where the first conductive pattern 321 and the second conductive pattern 104 are connected together through eutectic bonding. The eutectic bonding herein means that at a specific temperature and pressure, the first conductive pattern 321 and the second conductive pattern 104 mutually diffuse and are connected through alloying at an interface on which the first conductive pattern 321 is in contact with the second conductive pattern 104. The temperature required for the eutectic bonding generally needs to match metal materials of the first conductive pattern 321 and the second conductive pattern 104. Generally, temperatures required for eutectic bonding between different metal materials may be different. This is not specifically limited in the present invention. Optionally, the pressure of the eutectic bonding may range from 100 N to 1000 N (Newton). The pressure can achieve good and firm bonding between the first conductive pattern 321 or a first conductive film layer 321 and the second conductive pattern 104. In addition, a stress conducted by the pressure to the solar cell body is small, thereby having little effect on the solar cell body. For example, the pressure of the eutectic bonding may be 100 N, 200 N, 500 N, 600 N, 800 N, or 1000 N.

For a position of the electrode, the solar cell body, and the like, reference may be made to the related descriptions in Embodiment 1, and the same or similar beneficial effects can be achieved. To avoid repetition, details are not described herein again.

The first conductive pattern 321 and the second conductive pattern 104 are eutectically bonded together. The eutectic bonding process is simple and mature, and mass production is easy to be implemented. In addition, the eutectic bonding features a low bonding temperature and high bonding strength. The low bonding temperature can reduce a heat effect on the solar cell body, thereby having little effect on photoelectric conversion efficiency of the solar cell. The high bonding strength can make the electrode of the solar cell have good reliability. In addition, during the eutectic bonding, materials of the second conductive pattern 104 and the first conductive pattern 321 can be eutectically bonded, are not limited to a silver paste, and have more material selections; and compared with the silver paste, selecting copper, tin, or the like can appropriately reduce costs. In addition, the silver paste is granular, resulting in little contact between silver particles; and the silver paste includes an organic component, and the organic component also affects the contact between the silver particles. In this way, an electrode made of a silver paste has high resistivity and poor conductivity performance. However, in this embodiment of the present invention, a material of the electrode may not be granular (for example, a silver paste), and the material of the electrode may be, for example, silver, copper, tin, or an alloy thereof, so that the electrode has good conductivity performance. In addition, because the second conductive pattern 104 may not be prepared on the solar cell body, a process of preparing the second conductive pattern has little or substantially no effect on the solar cell body, and mass production is easy to be implemented. Therefore, preparation costs can be reduced.

It should be noted that, the materials of the first conductive pattern 321 and the second conductive pattern 104 may be materials that can be eutectically bonded, and the materials of the first conductive pattern 321 or the first conductive film layer 321 and the second conductive pattern 104 are not specifically limited. For example, the materials of the first conductive pattern 321 or the first conductive film layer 321 and the second conductive pattern 104 may be selected from materials whose temperatures during the eutectic bonding are less than or equal to 400°C, so that the heat effect of the eutectic bonding on the solar cell body can be reduced. For example, the materials of the first conductive pattern 321 or the first conductive film layer 321 and the second conductive pattern 104 may be selected from materials whose temperatures during the eutectic bonding are less than or equal to 200°C.

Optionally, the first conductive pattern 321 and the second conductive pattern 104 each may be made of a low-temperature conductive material, so that the heat effect of the eutectic bonding on the solar cell body can be reduced. For the materials of the first conductive pattern 321 and the second conductive pattern 104, reference may be made to the related descriptions in Embodiment 1, and the same or similar beneficial effects can be achieved. To avoid repetition, details are not described herein again.

Optionally, the materials of the first conductive pattern 321 or the first conductive film layer 321 and the second conductive pattern 104 may be selected from one of the following material pairs. If the first conductive pattern 321 or the first conductive film layer 321 is selected from one material in one of the following material pairs, the second conductive pattern 104 is selected from the other material in the one of the following material pairs. The material pairs may include: a material pair of copper (Cu) and copper (Cu), a material pair of copper (Cu) and tin (Sn), a material pair of gold (Au) and indium (In), and a material pair of gold (Au) and germanium (Ge). The material pairs are prone to eutectic bonding at a temperature less than or equal to 400°C, and in this case, the eutectic bonding is stronger. For example, the material pair of copper (Cu) and copper (Cu) can achieve good eutectic bonding at a temperature of 150°C to 200°C. The material pair of copper (Cu) and tin (Sn) can achieve good eutectic bonding at a temperature of 231°C. The material pair of gold (Au) and indium (In) can achieve good eutectic bonding at a temperature of 156°C. The material pair of gold (Au) and germanium (Ge) can achieve good eutectic bonding at a temperature of 361°C.

Optionally, referring to FIG. 2 to FIG. 5, the first conductive pattern 321 is closer to the solar cell body than the second conductive pattern 104 is. In FIG. 2, a direction shown by a dashed arrow L1 is a direction away from the solar cell body. In the direction away from the solar cell body, an area of a cross section of a partial region of the second conductive pattern 104 away from the solar cell body gradually decreases, where the cross section is perpendicular to a lamination direction of the first conductive pattern 321 and the second conductive pattern 104. In other words, the farther away from the first conductive pattern 321, the smaller the area of the cross section of the partial region of the second conductive pattern 104 away from the solar cell body. This design helps reduce reflection and shading, so that the photoelectric conversion efficiency of the solar cell can be increased.

Optionally, a shape of a longitudinal section of the second conductive pattern 104 or a partial region of the second conductive pattern 104 away from the solar cell body is a triangle, a trapezoid, or a shape formed by an arc and a line segment connecting two endpoints of the arc, where a length of the line segment is less than or equal to a diameter of a circle corresponding to the arc; and the longitudinal section is parallel to a lamination direction of the first conductive pattern 321 and the second conductive pattern 104. For the longitudinal section herein, reference may be correspondingly made to the related descriptions in Embodiment 1, and the same or similar beneficial effects can be achieved. To avoid repetition, details are not described herein again.

Optionally, referring to FIG. 2 to FIG. 4, the electrode of the solar cell further includes a bonding pattern 311 located between the first conductive pattern 321 and the solar cell body, where the bonding pattern 311 is used for improving bonding force between the first conductive pattern 321 and the solar cell body. For a material, a thickness, and the like of the bonding pattern 311, reference may be correspondingly made to the related descriptions in Embodiment 1, and the same or similar beneficial effects can be achieved. To avoid repetition, details are not described herein again.

Optionally, the solar cell may further include a diffusion control pattern (not shown in the figure) located between the first conductive pattern 321 and the second conductive pattern 104, where the diffusion control pattern is used for controlling a thickness of an alloy formed in the eutectic bonding of the second conductive pattern 104 and the first conductive pattern 321, to obtain an ideal interface alloy region. Specifically, the diffusion control pattern located between the first conductive pattern 321 and the second conductive pattern 104 can slow down atomic diffusion speeds of both the first conductive pattern 321 and the second conductive pattern 104 during the eutectic bonding, so that a thickness of the alloy formed at various positions of a eutectic bonding interface is relatively uniform, and the thickness of the alloy formed during the eutectic bonding is not excessively thick, so that bonding force between the first conductive pattern 321 and the second conductive pattern 104 can be improved. In addition, the diffusion control pattern located between the first conductive pattern 321 and the second conductive pattern 104 can also improve infiltration of the first conductive pattern 321 and infiltration of the second conductive pattern 104, so that fewer bubbles are formed during bonding of the first conductive pattern 321 and the second conductive pattern 104, and the first conductive pattern 321 and the second conductive pattern 104 are bonded more tightly, thereby further improving the bonding force between the first conductive pattern 321 and the second conductive pattern 104. In addition, the diffusion control pattern located between the first conductive pattern 321 and the second conductive pattern 104 can also prevent the atomic diffusion speeds of both the first conductive pattern 321 and the second conductive pattern 104 to a certain extent when the solar cell is heated or cooled after the eutectic bonding, to prevent the alloy from continuously thickening. A material of the diffusion control pattern is not specifically limited. For example, the material of the diffusion control pattern may be graphene, and may be single-layer graphene or multi-layer graphene. A shape of the diffusion control pattern may be the same as or similar to the shapes of the first conductive pattern 321 and the second conductive pattern 104.

Optionally, for the materials, shapes, thicknesses, structures, and the like of the first conductive pattern 321 and the second conductive pattern in Embodiment 7, reference may be correspondingly made to the related descriptions in Embodiment 1, and the same or similar beneficial effects can be achieved. To avoid repetition, details are not described herein again.

Optionally, referring to FIG. 1 to FIG. 5, the second conductive pattern 104 is formed by at least two second conductive sub-patterns laminated in a direction parallel to the lamination direction of the first conductive pattern 321 and the second conductive pattern 104. For the arranged at least two second conductive sub-patterns, reference may be correspondingly made to the related descriptions in Embodiment 1, and the same or similar beneficial effects can be achieved. To avoid repetition, details are not described herein again.

Optionally, a material of the second conductive sub-pattern 1041 farthest away from the first conductive pattern 321 in the second conductive pattern 104 may include tin. For an advantage, a component, and the like of tin herein, reference may be correspondingly made to the related descriptions in Embodiment 1, and the same or similar beneficial effects can be achieved. To avoid repetition, details are not described herein again.

Optionally, in a direction parallel to a lamination direction of the solar cell body and a first conductive pattern 321, the second conductive pattern 104 includes a seed layer pattern and a plating pattern that are laminated, where the plating pattern is closer to the solar cell body than the seed layer pattern is, and the plating pattern wraps the seed layer pattern. For the descriptions herein, reference may be correspondingly made to the related descriptions in Embodiment 1, and the same or similar beneficial effects can be achieved. To avoid repetition, details are not described herein again.

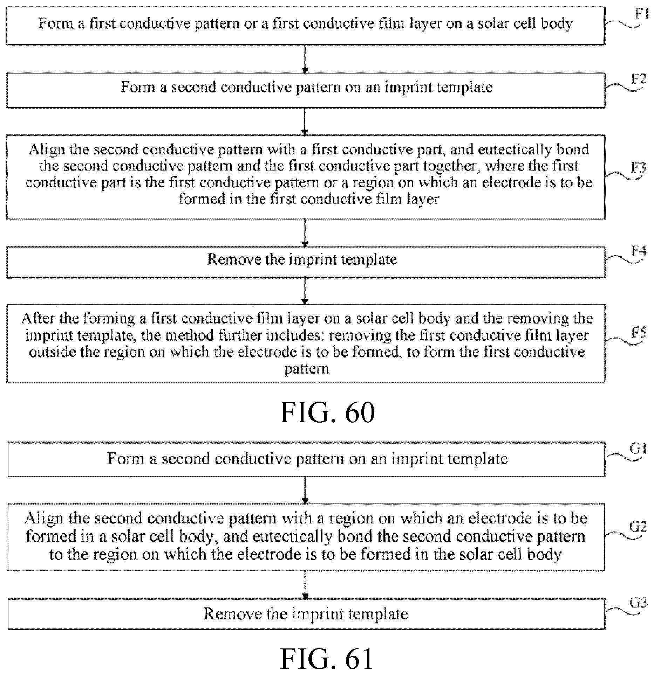

Embodiment 7 further provides a method for preparing a solar cell, which can be used to prepare the solar cell in Embodiment 7. FIG. 60 is a flowchart of steps of a seventh method for preparing a solar cell according to an exemplary embodiment of the present invention. Referring to FIG. 60, the method for preparing a solar cell includes the following steps.

Step F1: Form a first conductive pattern or a first conductive film layer on a solar cell body.

For Step F1, reference may be correspondingly made to the related descriptions in Embodiment 1, and the same or similar beneficial effects can be achieved. To avoid repetition, details are not described herein again.

Optionally, the forming a first conductive pattern or a first conductive film layer on a solar cell body may include: laying a metal foil on the solar cell body, to form the first conductive film layer. For the part, reference may be correspondingly made to the related descriptions in Embodiment 1, and the same or similar beneficial effects can be achieved. To avoid repetition, details are not described herein again.

Optionally, after the laying a metal foil on the solar cell body, the method may include: pressing the metal foil, to bond the metal foil to the solar cell body. For the part, reference may be correspondingly made to the related descriptions in Embodiment 1, and the same or similar beneficial effects can be achieved. To avoid repetition, details are not described herein again.

Step F2: Form a second conductive pattern on an imprint template.

For Step F2, reference may be correspondingly made to the related descriptions in Embodiment 1, and the same or similar beneficial effects can be achieved. To avoid repetition, details are not described herein again.

Step F3: Align the second conductive pattern with a first conductive part, and eutectically bond the second conductive pattern and the first conductive part together, where the first conductive part is the first conductive pattern or a region on which an electrode is to be formed in the first conductive film layer.

For that a second conductive pattern 104 is aligned with the first conductive part, reference may be correspondingly made to the related descriptions in Embodiment 1, and the same or similar beneficial effects can be achieved. To avoid repetition, details are not described herein again.

After the first conductive pattern 321 is aligned with the second conductive pattern 104, the second conductive pattern 104 and the first conductive pattern 321 are eutectically bonded together, so that eutectic bonding transfer of the second conductive pattern 104 located on the imprint template to the first conductive film layer 321 or the first conductive pattern 321 on the solar cell body is implemented. The eutectic bonding features a low bonding temperature and high bonding strength. The low bonding temperature can reduce a heat effect on the solar cell body, thereby having little effect on photoelectric conversion efficiency of the solar cell. The high bonding strength can make the electrode of the solar cell have good reliability. Compared with screen printing, in the present invention, materials of the second conductive pattern and the first conductive film layer or the first conductive pattern can be eutectically bonded, and are not limited to a silver paste. Therefore, costs can be appropriately reduced. Compared with laser transfer printing, in the present invention, the second conductive pattern and the first conductive pattern can be eutectically bonded together, or the second conductive pattern and the region on which the electrode is to be formed in the first conductive film layer can be eutectically bonded together. The eutectic bonding process is mature, and process difficulty is relatively low, so that production efficiency can be appropriately improved. Compared with electroplating, in the present invention, the second conductive pattern and the first conductive pattern can be eutectically bonded together, or the second conductive pattern and the region on which the electrode is to be formed in the first conductive film layer can be eutectically bonded together. In this way, there is no process problem such as winding plating for the solar cell body, the yield and the reliability are good, and mass production is easy to be implemented.

Referring to FIG. 16, FIG. 17, and FIG. 18, the second conductive pattern 104 is aligned with the region on which the electrode is to be formed in the first conductive film layer 321, and the second conductive pattern 104 and the region on which the electrode is to be formed in the first conductive film layer 321 are eutectically bonded together.

Step F4: Remove the imprint template.

For Step F4, reference may be correspondingly made to the related descriptions in Embodiment 1, and the same or similar beneficial effects can be achieved. To avoid repetition, details are not described herein again.

The eutectic bonding transfer of the second conductive pattern 104 located on the imprint template to the first conductive film layer 321 or the first conductive pattern 321 on the solar cell body is implemented, so that the electrode of the solar cell is substantially formed. Then, the imprint template is removed. The imprint template may be removed by using mechanical external force or the like. The manner of removing the imprint template is not specifically limited in the embodiments of the present invention. Removing the imprint template mainly relies on that bonding force between the second conductive pattern 104 and the imprint template is less than eutectic bonding force between the second conductive pattern 104 and the first conductive film layer 321 or the first conductive pattern 321, to remove the imprint template. Optionally, a coating or the like for making the second conductive pattern 104 easy to be separated from the imprint template may be coated between the imprint template and the second conductive pattern 104, thereby further facilitating removing the imprint template. For example, tin or a tin alloy is provided between the imprint template and the second conductive pattern 104. Tin or the tin alloy has a low melting point, so that the imprint template can be easily removed.

FIG. 19 and FIG. 20 are schematic diagrams of the solar cell with the imprint template being removed.

It should be noted that, after the imprint template is removed, second conductive pattern residues on the imprint template may be further cleaned by using an acid solution or an alkali solution, so that the imprint template can be reused. For the descriptions herein, reference may be correspondingly made to the related descriptions in Embodiment 1, and the same or similar beneficial effects can be achieved. To avoid repetition, details are not described herein again.

Step F5: After the forming a first conductive film layer on a solar cell body and the removing the imprint template, the method further includes: removing the first conductive film layer outside the region on which the electrode is to be formed, to form the first conductive pattern.

For Step F5, reference may be correspondingly made to the related descriptions in Embodiment 1, and the same or similar beneficial effects can be achieved. To avoid repetition, details are not described herein again.

Optionally, before Step F3, the method may further include: annealing the imprint template on which the second conductive pattern 104 has been formed. For an annealing manner, an annealing temperature, and the like in Embodiment 7, reference may be correspondingly made to the related descriptions in Embodiment 1, and the same or similar beneficial effects can be achieved. To avoid repetition, details are not described herein again.

Optionally, before the eutectic bonding, the method may further include: forming a diffusion control pattern on the first conductive pattern or the region on which the electrode is to be formed in the first conductive film layer; and/or forming a diffusion control pattern on the second conductive pattern, where the diffusion control pattern is used for controlling a thickness of an alloy formed in the eutectic bonding of the second conductive pattern and the first conductive pattern, to obtain an ideal eutectically-bonded alloy region. For a material, a structure, and the like of the diffusion control pattern, reference may be made to the foregoing descriptions, and the same or similar beneficial effects can be achieved. To avoid repetition, details are not described herein again. A manner of forming the diffusion control pattern may be deposition, coating, or the like.

Optionally, before the forming a first conductive pattern or a first conductive film layer on the solar cell body, the method may further include: forming a bonding pattern or a bonding film layer on the solar cell body. For a function, a material, a forming manner, and the like of the bonding pattern or the bonding film layer, reference may be correspondingly made to the related descriptions in Embodiment 1, and the same or similar beneficial effects can be achieved. To avoid repetition, details are not described herein again.

Optionally, referring to FIG. 21, the imprint template includes a first groove 103. Referring to FIG. 11 and FIG. 12, Step F2 may include: forming the second conductive pattern 104 in the first groove 103 of the imprint template, where the second conductive pattern 104 is flush with a surface of a side of the imprint template provided with the first groove 103, or protrudes from the surface of the side of the imprint template provided with the first groove 103. In this way, in a process of eutectically bonding the second conductive pattern 104 to the first conductive pattern 321 or the region on which the electrode is to be formed in the first conductive film layer 321, the second conductive pattern 104 can come into contact with the first conductive pattern 321 or the region on which the electrode is to be formed in the first conductive film layer 321. The first groove 103 is used as a gate line plate corresponding to the second conductive pattern 104, to form the second conductive pattern 104 with a precise shape. The second conductive pattern may be formed in the first groove 103 of the imprint template through electroplating, deposition, or the like. This is not specifically limited in the embodiments. It should be noted that, if the deposition manner is selected, after the deposition is completed, the second conductive film layer outside the first groove 103 further needs to be etched away.

Optionally, referring to FIG. 21, the imprint template further includes a substrate 101, the first groove 103 is arranged on the substrate 101, and the imprint template further includes a first boss 102 arranged on the substrate 101 and located on an edge of the first groove 103. Referring to FIG. 11 and FIG. 12, the forming the second conductive pattern 104 in the first groove 103 of the imprint template includes: forming the second conductive pattern 104 in the first groove 103 of the imprint template and in a region defined by the first boss 102, where the second conductive pattern 104 is flush with a surface of the first boss 102 away from the substrate 101, or protrudes from the surface of the first boss 102 away from the substrate 101. Referring to FIG. 17, the first boss 102 protrudes from the substrate 101. Therefore, during aligning and eutectic bonding between the region on which the electrode is to be arranged in the first conductive film layer 321 and the second conductive pattern 104, only a part of the second conductive pattern 104 protruding from the surface of the first boss 102 away from the substrate 101 or only a part of the second conductive pattern 104 flush with the surface of the first boss 102 away from the substrate 101 is in contact with the region on which the electrode is to be arranged in the first conductive film layer 321, and a remaining part of the imprint template is not in contact with the first conductive film layer 321. In this way, the first conductive film layer 321 or the solar cell body cannot be polluted, and the imprint template cannot press against the first conductive film layer 321 or the solar cell body.

It should be noted that, the second conductive pattern is not formed on the surface of the first boss 102 away from the substrate 101, so that a waste can be reduced, and a current loss can be reduced. More specifically, if the second conductive pattern is formed on the surface of the first boss 102 away from the substrate 101, a projection of the part of the second conductive pattern on a surface of the substrate 101 close to the first boss 102 does not coincide with a projection of the second conductive pattern located in the first groove 103 and in the region defined by the first boss 102 on the surface of the substrate 101 close to the first boss 102, and carriers collected on the part need to be transported in a direction parallel to the width of the notch of the first groove 103 to be exported. A transport path of the carriers is long, resulting in a specific current loss. Therefore, in some examples, the second conductive pattern is not formed on the surface of the first boss 102 away from the substrate 101. **In** this way, a current loss can be reduced, and a waste of the material of the second conductive pattern can be reduced. An implementation in which the second conductive pattern is not formed on the surface of the first boss 102 away from the substrate 101 may be as follows: **In** a process of depositing the second conductive pattern, the second conductive pattern is also deposited on the surface of the first boss 102 away from the substrate 101, then a mask is arranged, the mask is patterned, and the second conductive pattern formed on the surface of the first boss 102 away from the substrate 101 is removed through wet etching. Alternatively, in a process of depositing the second conductive pattern, the second conductive pattern is also deposited on the surface of the first boss 102 away from the substrate 101, and the second conductive pattern formed on the surface of the first boss 102 away from the substrate 101 is removed through laser etching. Alternatively, the region defined by two sides of the first boss 102 is configured as a conductive surface, and the surface of the first boss 102 away from the substrate 101 is configured as a non-conductive surface. **In** a specific implementation, a conductive substance may be selected as a part of the first boss 102 close to the substrate 101. Then, a non-conductive substance is arranged on the part of the first boss 102 close to the substrate 101 through deposition, coating, or the like. Then, the non-conductive substance in the region defined by the two sides of the first boss 102 is etched, so that the region defined by the two sides of the first boss 102 is a conductive surface, and the surface of the first boss 102 away from the substrate 101 is a non-conductive surface. During electroplating, the second conductive pattern can be electroplated on the region defined by the two sides of the first boss 102, which is a conductive surface and serves as a cathode, and the second conductive pattern cannot be electroplated on the surface of the first boss 102 away from the substrate 101.

It should be noted that, the first boss 102 and the substrate 101 may be integrally formed, or the first boss 102 and the substrate 101 are separately manufactured; and then the first boss 102 and the substrate 101 are fixedly connected together by using an adhesive layer or the like. This is not specifically limited in the embodiments.

Optionally, referring to FIG. 21, in a direction from the notch of the first groove 103 to a groove bottom of the first groove 103, an area of a cross section of the first groove 103 gradually decreases, where the cross section of the first groove 103 is perpendicular to a lamination direction of the first conductive pattern 321 and the second conductive pattern 104. For the cross section of the first groove 103, reference may be made to the related descriptions in Embodiment 1, and the same or similar beneficial effects can be achieved. To avoid repetition, details are not described herein again.

Optionally, referring to FIG. 22 to FIG. 24, the imprint template includes a substrate 101 and a second boss 202 located on the substrate 101. A quantity of second bosses 202 on the substrate 101 is not specifically limited. For the quantity of second bosses 202, and forming manners of the second boss 202 and the substrate 101, reference may be made to the related descriptions in Embodiment 1, and the same or similar beneficial effects can be achieved. To avoid repetition, details are not described herein again. Referring to FIG. 13 and FIG. 14, Step F2 may include: forming a second conductive film layer 104 on a side of the imprint template on which the second boss 202 is formed, where a part of the second conductive film layer 104 located on the second boss 202 is the second conductive pattern. For the descriptions herein, reference may also be made to the related descriptions in Embodiment 1, and the same or similar beneficial effects can be achieved. To avoid repetition, details are not described herein again.

Optionally, referring to FIG. 26 to FIG. 28, Step F2 may include: forming a seed pattern 1047 on the imprint template; and forming a plating pattern 1048 on the seed pattern 1047 through electroplating or chemical plating, where the plating pattern 1048 and the seed pattern 1047 together form the second conductive pattern 104. A function of the imprint template herein is mainly to provide a carrying table for forming the seed pattern. For the descriptions herein, reference may be correspondingly made to the related descriptions in Embodiment 1, and the same or similar beneficial effects can be achieved. To avoid repetition, details are not described herein again.

The second conductive film layer 104 herein may be a metal foil, and Step F2 may include: laying the metal foil on the side of the imprint template on which the second boss 202 is formed, where a part of the metal foil located on the second boss 202 is the second conductive pattern 104. A part of the metal foil located outside the second boss 202 may be adsorbed on the substrate 101 through lamination, or the like, to avoid displacement of the metal foil. For the descriptions herein, reference may also be made to the related descriptions in Embodiment 1, and the same or similar beneficial effects can be achieved. To avoid repetition, details are not described herein again.

For fixing between the second boss 202 and the metal foil, and the like, reference may be made to the related descriptions in Embodiment 1, and the same or similar beneficial effects can be achieved. To avoid repetition, details are not described herein again.

Optionally, referring to FIG. 22 or FIG. 24, the surface of the second boss 202 away from the substrate 101 is a plane, so that a surface of the formed second conductive pattern 104 close to the second boss 202 is also a plane. Alternatively, optionally, a side of the second boss 202 away from the substrate 101 includes a second groove 2021. The forming a second conductive pattern on an imprint template includes: forming the second conductive pattern in the second groove 2021. A surface of the second groove 2021 on the first boss 202 herein is used as a gate line plate. For the descriptions herein, reference may also be made to the related descriptions in Embodiment 1, and the same or similar beneficial effects can be achieved. To avoid repetition, details are not described herein again.

Optionally, the imprint template may include a substrate, and Step F2 may include: laying a metal foil on the substrate, and patterning the metal foil, to form the second conductive pattern. For the descriptions herein, reference may also be made to the related descriptions in Embodiment 1, and the same or similar beneficial effects can be achieved. To avoid repetition, details are not described herein again.

Optionally, before Step F2, the method may further include: providing a plurality of metal foil patterns; the imprint template may include a plurality of adsorption regions; and Step F2 may include: at least aligning one of the adsorption regions with one of the metal foil patterns, and adsorbing the metal foil pattern on the adsorption region, to form the second conductive pattern on the imprint template. For the descriptions herein, reference may also be made to the related descriptions in Embodiment 1, and the same or similar beneficial effects can be achieved. To avoid repetition, details are not described herein again.

Optionally, the second conductive pattern 104 may also be a metal wire. Optionally, a surface of the metal wire may be further coated with a coating 1045. For the descriptions herein, reference may also be made to the related descriptions in Embodiment 1, and the same or similar beneficial effects can be achieved. To avoid repetition, details are not described herein again.

It should be noted that, if an entire metal foil is laid on the solar cell body, due to a high eutectic bonding temperature during eutectic bonding, the metal foil may be partially damaged at a eutectic bonding boundary, and the like. Therefore, after the eutectic bonding, a manner of removing the metal foil outside the region of the electrode may include: blowing the part away by airflow, sticking the part away by using a viscous material, or the like. This is not specifically limited in the embodiments.

### Embodiment 8

Embodiment 8 provides another solar cell. The solar cell includes a solar cell body, and a positive electrode and a negative electrode arranged on the solar cell body, where a structure of the positive electrode and a structure of the negative electrode may be the same or may be different. An electrode (where the electrode may be the positive electrode or the negative electrode) of the solar cell includes a second conductive pattern laminated on the solar cell body, where the second conductive pattern is eutectically bonded to the solar cell body.

For the solar cell body, reference is made to the related descriptions in Embodiment 1. To avoid repetition, details are not described herein again. For example, the solar cell body herein may be a silicon substrate. If a passivation layer or the like is further arranged on the solar cell body, the passivation layer may be grooved, so that the silicon substrate is exposed.

The second conductive pattern is eutectically bonded to the solar cell body. The eutectic bonding process is simple and mature, and mass production is easy to be implemented. In addition, the eutectic bonding features a low bonding temperature and high bonding strength. The low bonding temperature can reduce a heat effect on the solar cell body, thereby having little effect on photoelectric conversion efficiency of the solar cell. The high bonding strength can make the electrode of the solar cell have good reliability. In addition, during the eutectic bonding, a material of the second conductive pattern can be eutectically bonded to the solar cell body, is not limited to a silver paste, and has more material selections; and compared with the silver paste, selecting copper, tin, or the like can appropriately reduce costs. In addition, the silver paste is granular, resulting in little contact between silver particles; and the silver paste includes an organic component, and the organic component also affects the contact between the silver particles. In this way, an electrode made of a silver paste has high resistivity and poor conductivity performance. However, in this embodiment of the present invention, a material of the electrode may not be granular (for example, a silver paste), and the material of the electrode may be, for example, silver, copper, tin, or an alloy thereof, so that the electrode has good conductivity performance. In addition, because a second conductive pattern 104 may not be prepared on the solar cell body, a process of preparing the second conductive pattern has little or substantially no effect on the solar cell body, and mass production is easy to be implemented. Therefore, preparation costs can be reduced.

It should be noted that, the material of the second conductive pattern may be a material that can be eutectically bonded to the solar cell body. The material of the second conductive pattern is not specifically limited. For example, the material of the second conductive pattern may include nickel, aluminum, or gold. For example, the material of the second conductive pattern may be singular nickel or a nickel alloy, or the material of the second conductive pattern may be aluminum, or the material of the second conductive pattern may be gold. The material of the second conductive pattern can be eutectically bonded to the solar cell body at a temperature of about 800°C to 900°C or lower. The eutectic bonding process is simple and mature, and mass production is easy to be implemented. In addition, the bonding temperature of about 800°C to 900°C or lower can reduce the heat effect on the solar cell body. The high bonding strength of the eutectic bonding can make the electrode of the solar cell have good reliability. For example, the material of the second conductive pattern may be gold, and good eutectic bonding can be achieved between gold and silicon in the solar cell body at a temperature of 370°C.

In addition, compared with screen printing, the second conductive pattern can be eutectically bonded to the solar cell body, and is not limited to a silver paste. Therefore, costs can be appropriately reduced. In addition, compared with laser transfer printing, in the present invention, the second conductive pattern and the solar cell body are eutectically bonded together. The eutectic bonding process is mature, and process difficulty is relatively low, so that production efficiency can be appropriately improved. Compared with electroplating, in the present invention, the second conductive pattern and the solar cell body can be eutectically bonded together. In this way, there is no process problem such as winding plating for the solar cell body, the yield and the reliability are good, and mass production is easy to be implemented.

Optionally, for a shape, a thickness, the structure, and the like of the second conductive pattern in Embodiment 8, reference may be correspondingly made to the related descriptions in Embodiment 1, and the same or similar beneficial effects can be achieved. To avoid repetition, details are not described herein again.

Optionally, the solar cell may further include a diffusion control pattern located between the second conductive pattern and the solar cell body, where the diffusion control pattern is used for controlling a thickness of an alloy formed in the eutectic bonding of the second conductive pattern and the solar cell body, to obtain an ideal interface alloy region, and avoid a possible effect on the solar cell body during the eutectic bonding. For a material, a structure, and the like of the diffusion control pattern, reference may be made to the related descriptions in Embodiment 7, and the same or similar beneficial effects can be achieved. To avoid repetition, details are not described herein again.

Optionally, in a direction parallel to a lamination direction of the solar cell body and a first conductive pattern 321, the second conductive pattern 104 includes a seed layer pattern and a plating pattern that are laminated, where the plating pattern is closer to the solar cell body than the seed layer pattern is, and the plating pattern wraps the seed layer pattern. For the descriptions herein, reference may be correspondingly made to the related descriptions in Embodiment 1, and the same or similar beneficial effects can be achieved. To avoid repetition, details are not described herein again.

Embodiment 8 further provides a method for preparing a solar cell, which can be used to prepare the solar cell in Embodiment 8. FIG. 61 is a flowchart of steps of an eighth method for preparing a solar cell according to an exemplary embodiment of the present invention. Referring to FIG. 61, the method for preparing a solar cell includes the following steps.

Step G1: Form a second conductive pattern on an imprint template.

For Step G1, reference may be made to the related descriptions in Embodiment 7, and the same or similar beneficial effects can be achieved. To avoid repetition, details are not described herein again.

Step G2: Align the second conductive pattern with a region on which an electrode is to be formed in a solar cell body, and eutectically bond the second conductive pattern to the region on which the electrode is to be formed in the solar cell body.

For the aligning in Step G2, reference may also be made to the related descriptions in Embodiment 7. To avoid repetition, details are not described herein again. In Step G2, the second conductive pattern is transferred to the solar cell body.

Step G3: Remove the imprint template.

For Step G3, reference may be made to the related descriptions in Embodiment 7, and the same or similar beneficial effects can be achieved. To avoid repetition, details are not described herein again.

Optionally, before the eutectic bonding, the method may further include: annealing the imprint template on which the second conductive pattern has been formed, to cause the second conductive pattern to recrystallize, to eliminate a stress. For an annealing temperature, annealing time, an annealing manner, and the like, reference may be correspondingly made to the related descriptions in Embodiment 7, and the same or similar beneficial effects can be achieved. To avoid repetition, details are not described herein again.

Optionally, before the eutectic bonding, the method may further include: forming a diffusion control pattern on the second conductive pattern; and/or forming a diffusion control pattern on the region on which the electrode is to be formed in the solar cell body, where the diffusion control pattern is used for controlling a thickness of an alloy formed in the eutectic bonding of the second conductive pattern and the region on which the electrode is to be formed in the solar cell body, to obtain an ideal eutectically-bonded alloy region. For a material, a structure, a forming manner, and the like of the diffusion control pattern, reference may be correspondingly made to the related descriptions in Embodiment 7, and the same or similar beneficial effects can be achieved. To avoid repetition, details are not described herein again.

Optionally, referring to FIG. 21, the imprint template includes a first groove 103. Referring to FIG. 11 and FIG. 12, Step G1 may include: forming a second conductive pattern 104 in the first groove 103 of the imprint template, where the second conductive pattern 104 is flush with a surface of a side of the imprint template provided with the first groove 103, or protrudes from the surface of the side of the imprint template provided with the first groove 103. For the descriptions herein, reference may be correspondingly made to the related descriptions in Embodiment 7, and the same or similar beneficial effects can be achieved. To avoid repetition, details are not described herein again.

Optionally, referring to FIG. 21, the imprint template further includes a substrate 101, the first groove 103 is arranged on the substrate 101, and the imprint template may further include a first boss 102 arranged on the substrate 101 and located on an edge of the first groove 103. Step G1 may include: forming the second conductive pattern 104 in the first groove 103 and in a region defined by the first boss 102, where the second conductive pattern 104 is flush with a surface of the first boss 102 away from the substrate 101, or protrudes from the surface of the first boss 102 away from the substrate 101. For the descriptions herein, reference may also be made to the related descriptions in Embodiment 7, and the same or similar beneficial effects can be achieved. To avoid repetition, details are not described herein again.

Optionally, referring to FIG. 21, in a direction from a notch of the first groove 103 to a groove bottom of the first groove 103, an area of a cross section of the first groove 103 gradually decreases, where the cross section of the first groove 103 is perpendicular to a lamination direction of the second conductive pattern and the solar cell body. Further, in the direction from the notch of the first groove 103 to the groove bottom of the first groove 103, an area of a cross section of the formed second conductive pattern also gradually decreases, to facilitate reducing shading and reflection. For the descriptions herein, reference may also be made to the related descriptions in Embodiment 7, and the same or similar beneficial effects can be achieved. To avoid repetition, details are not described herein again.

Optionally, referring to FIG. 22 to FIG. 24, the imprint template includes a substrate 101 and a second boss 202 located on the substrate 101. A quantity of second bosses 202 on the substrate 101 is not specifically limited. Referring to FIG. 13 and FIG. 14, Step G1 may include: forming the second conductive pattern on a side of the imprint template on which the second boss 202 is formed. For a manner of forming the second conductive pattern, the quantity of second bosses, and the like, reference may be correspondingly made to the related descriptions in Embodiment 7, and the same or similar beneficial effects can be achieved. To avoid repetition, details are not described herein again.

Optionally, a surface of the second boss 202 away from the substrate 101 is a plane; or optionally, a side of the second boss 202 away from the substrate 101 includes a second groove 2021, where the second conductive pattern 104 is flush with a notch of the second groove 2021, or protrudes from the second groove 2021. For the descriptions herein, reference may be correspondingly made to the related descriptions in Embodiment 7, and the same or similar beneficial effects can be achieved. To avoid repetition, details are not described herein again.

Optionally, referring to FIG. 26 to FIG. 28, Step G1 may include: forming a seed pattern 1047 on the imprint template; and forming a plating pattern 1048 on the seed pattern 1047 through electroplating or chemical plating, where the plating pattern 1048 and the seed pattern 1047 together form a second conductive pattern 104. A function of the imprint template herein is mainly to provide a carrying table for forming the seed pattern. For the descriptions herein, reference may be correspondingly made to the related descriptions in Embodiment 1, and the same or similar beneficial effects can be achieved. To avoid repetition, details are not described herein again.

Optionally, the imprint template includes a substrate 101, and Step G1 may include: laying a metal foil on the substrate, and patterning the metal foil, to form the second conductive pattern. For the descriptions herein, reference may be correspondingly made to the related descriptions in Embodiment 7, and the same or similar beneficial effects can be achieved. To avoid repetition, details are not described herein again.

Optionally, before Step G1, the method may further include: providing a plurality of metal foil patterns; the imprint template may include a plurality of adsorption regions; and Step G1 may include: at least aligning one of the adsorption regions with one of the metal foil patterns, and adsorbing the metal foil pattern on the adsorption region, to form the second conductive pattern on the imprint template. For the descriptions herein, reference may be correspondingly made to the related descriptions in Embodiment 7, and the same or similar beneficial effects can be achieved. To avoid repetition, details are not described herein again.

Optionally, referring to FIG. 27, a material of the second conductive pattern 104 is aluminum, and the second conductive pattern 104 is in contact with a silicon substrate 305 of the solar cell body. Step G2 may include that in a process of eutectically bonding the second conductive pattern 104 to the region on which the electrode is to be formed in the solar cell body, a part of aluminum in the second conductive pattern 104 diffuses into a region on which the electrode is to be formed in the silicon substrate 305, to dope the region on which the electrode is to be formed in the silicon substrate 305 to form a P-type doped region 3051, and use a remaining part of the second conductive pattern 104 as the electrode. In other words, based on the shape of the second conductive pattern 104 made of aluminum, a distribution position of the second conductive pattern 104 made of aluminum on the solar cell body, and a temperature during the eutectic bonding, in a process of transferring the second conductive pattern 104 made of aluminum to the solar cell body, local P-type doping of the silicon substrate 305 is also implemented, so that a step of specially performing the local P-type doping is not required, and production efficiency can be improved. The part of aluminum in the second conductive pattern 104 diffuses into the region on which the electrode is to be formed in the silicon substrate 305 by using a contact position between the second conductive pattern and the silicon substrate 305 as a center. It should be noted that, when the part of aluminum in the second conductive pattern 104 diffuses into the region on which the electrode is to be formed in the silicon substrate 305, a formed P-type doping concentration is not specifically limited.

Optionally, referring to FIG. 27, the second conductive pattern 104 made of aluminum may also be an aluminum metal wire 1044. A shape, a size, and the like of the aluminum metal wire 1044 are also not specifically limited.

Optionally, Step G1 may include: forming at least two aluminum conductive sub-patterns laminated on the imprint template. In the process of aligning the second conductive pattern 104 with the region on which the electrode is to be formed in the solar cell body, an aluminum conductive sub-pattern located on a side of the second conductive pattern 104 away from the imprint template is in direct contact with the silicon substrate 305. Therefore, in the process in which the part of aluminum in the second conductive pattern 104 made of aluminum diffuses into the silicon substrate 305, the aluminum conductive sub-pattern located on the side of the second conductive pattern 104 away from the imprint template preferentially diffuses into the silicon substrate 305. Under a specific eutectic bonding heat, a remaining aluminum conductive sub-pattern may partially diffuse into the silicon substrate 305 or may not diffuse into the silicon substrate 305. In other words, during the diffusion, the aluminum conductive sub-pattern located on the side of the second conductive pattern 104 away from the imprint template is equivalent to appropriately protecting the remaining aluminum conductive sub-pattern, so that the remaining aluminum conductive sub-pattern has little diffusion, so that a shape of the remaining aluminum conductive sub-pattern has little deformation. The remaining aluminum conductive sub-pattern is used as the electrode, which can ensure precision of the formed electrode.

For example, referring to FIG. 27, the second conductive pattern 104 includes at least two aluminum conductive sub-patterns. An aluminum conductive sub-pattern farthest away from the silicon substrate in the at least two aluminum conductive sub-patterns may be an aluminum metal wire 1044. A shape, a size, and the like of the aluminum metal wire 1044 are also not specifically limited. An aluminum conductive sub-pattern farthest away from the imprint template in the at least two aluminum conductive sub-patterns may be an aluminum paste sub-pattern 1046. During the eutectic bonding, the aluminum paste sub-pattern 1046 located on a side of the aluminum metal wire 1044 away from the imprint template is in direct contact with the silicon substrate 305. Therefore, in the process in which the part of aluminum in the second conductive pattern 104 made of aluminum diffuses into the silicon substrate 305, the aluminum paste sub-pattern 1046 preferentially diffuses into the silicon substrate 305. Under a specific eutectic bonding heat, the aluminum metal wire 1044 may partially diffuse into the silicon substrate 305 or may not diffuse into the silicon substrate 305. In other words, during the diffusion, the aluminum paste sub-pattern 1046 located on the side of the aluminum metal wire 1044 away from the imprint template is equivalent to appropriately protecting the aluminum metal wire 1044, so that the aluminum metal wire 1044 has little diffusion, so that the shape of the aluminum metal wire 1044 has little deformation. Subsequently, the aluminum metal wire 1044 is used as the electrode, which can ensure precision of the formed electrode.

The present invention is further described below with reference to a more detailed embodiment.

As shown in FIG. 4, a second conductive sub-pattern 1041 is a tin conductive sub-pattern with a thickness of 1 µm, a second conductive sub-pattern 1042 is a copper conductive sub-pattern with a thickness of 12 µm, and a second conductive sub-pattern 1043 is a tin conductive sub-pattern with a thickness of 0.5 µm. The second conductive sub-pattern 1041, the second conductive sub-pattern 1042, and the second conductive sub-pattern 1043 are all prepared through deposition and patterning.

In FIG. 4, a first conductive pattern 321 is a copper conductive pattern with a thickness of 20 nm, and the first conductive pattern 321 is obtained through deposition. A bonding pattern 311 is a titanium pattern with a thickness of 10 nm, and the bonding pattern 311 is also obtained through deposition. The first conductive pattern 321 and a second conductive pattern 104 are eutectically bonded together.

It should be noted that, in Embodiment 1 to Embodiment 8, for a solar cell, a method for preparing a solar cell, and a solar cell module in a same embodiment and between embodiments, reference may be made to each other, and the same or similar beneficial effects can be achieved.

It should be noted that, for ease of description, the method embodiments are stated as a combination of a series of actions. However, a person skilled in the art is to know that the embodiments of this application are not limited to the described action sequence, because according to this embodiment of this application, some steps may be performed in another sequence or simultaneously. In addition, a person skilled in the art is also to learn that the embodiments described in this specification are all exemplary embodiments, and the actions involved are not necessarily required by the embodiments of this application.

It should be noted that, the term "include", "comprise", or any other variation thereof in this specification is intended to cover a non-exclusive inclusion, which specifies the presence of stated processes, methods, objects, or apparatuses, but does not preclude the presence or addition of one or more other processes, methods, objects, or apparatuses. Without more limitations, elements defined by the sentence "including one ..." does not exclude that there are still other same elements in the processes, methods, objects, or apparatuses.

The embodiments of the present invention are described above with reference to the accompanying drawings. However, the present invention is not limited to the foregoing specific implementations. The foregoing specific implementations are illustrative instead of limitative. Enlightened by the present invention, a person of ordinary skill in the art can make many forms without departing from the idea of the present invention and the scope of protection of the claims. All of the forms fall within the protection of the present invention.

The foregoing described apparatus embodiments are merely examples. The units described as separate parts may or may not be physically separate, and the parts displayed as units may or may not be physical units, may be located in one position, or may be distributed on a plurality of network units. Some or all of the modules may be selected according to actual needs to achieve the objectives of the solutions of the embodiments. A person of ordinary skill in the art may understand and implement the method without any creative effort.

"One embodiment", "Embodiment", or "one or more embodiments" mentioned in this specification mean that particular features, structures, or characteristics described with reference to the embodiments may be included in at least one embodiment of this application. In addition, the word example of "in an embodiment" herein does not necessarily all refer to a same embodiment.

In this specification provided herein, numerous specific details are described. However, it may be understood that, the embodiments of this application may be practiced without these specific details. In some instances, well-known methods, structures, and technologies are not shown in detail, so that understanding of this specification is not obscured.

Finally, it should be noted that, the foregoing embodiments are merely used for describing the technical solutions of this application, but are not intended to limit this application. Although this application is described in detail with reference to the foregoing embodiments, it should be understood that a person of ordinary skill in the art may still make modifications to the technical solutions described in the foregoing embodiments or make equivalent replacements to some technical features thereof, without departing from the spirit and scope of the technical solutions of the embodiments of this application.

## Claims

1. A method for preparing a solar cell, comprising:
forming a first conductive pattern 321 or a first conductive film layer 321 on a solar cell body;
forming a second conductive pattern 104 on an imprint template;
aligning the second conductive pattern 104 with a first conductive part, and electrically connecting the second conductive pattern 104 to the first conductive part, wherein the first conductive part is the first conductive pattern 321 or a region on which an electrode is to be formed in the first conductive film layer 321; and the electrical connection comprises any one of the following four manners: in a first manner, the second conductive pattern 104 and the first conductive part are bonded together through a bonding part, wherein a material of the bonding part comprises a conductive material and an adhesive; in a second manner, the second conductive pattern 104 and the first conductive part are welded together; in a third manner, a third conductive pattern 313 is formed between the second conductive pattern 104 and the first conductive part through electroplating or chemical plating, and the second conductive pattern 104 and the first conductive part are connected together through the third conductive pattern 313; or in a fourth manner, the second conductive pattern 104 and the first conductive part are eutectically bonded together; and
removing the imprint template; and
after the forming a first conductive film layer 321 on a solar cell body and the removing the imprint template, the method further comprising: removing the first conductive film layer 321 outside the region on which the electrode is to be formed, to form the first conductive pattern 321.

2. The method for preparing a solar cell according to claim 1, wherein before the electrical connection, the method further comprises:
annealing the imprint template on which the second conductive pattern 104 has been formed, to cause the second conductive pattern 104 to recrystallize.

3. The method for preparing a solar cell according to claim 1 or 2, wherein the bonding part comprises a conductive adhesive film layer 313 or a conductive adhesive pattern 313; and after the first conductive part and the second conductive pattern 104 are bonded together through the conductive adhesive film layer 313, and after the removing the imprint template, the method further comprises: removing the conductive adhesive film layer 313 outside a region on which the electrode is to be formed, to form the conductive adhesive pattern 313.

4. The method for preparing a solar cell according to claim 3, wherein before the bonding, the method further comprises:
forming the bonding part on the second conductive pattern 104; and
the aligning the second conductive pattern 104 with a first conductive part comprises:
aligning the first conductive part with the conductive adhesive pattern 313 or the region on which the electrode is to be formed in the conductive adhesive film layer 313.

5. The method for preparing a solar cell according to claim 3, wherein before the bonding, the method further comprises:
forming the bonding part on one of the first conductive pattern 321, the region on which the electrode is to be formed in the first conductive film layer 313, or the first conductive film layer 313; and
the aligning the second conductive pattern 104 with a first conductive part comprises:
aligning the second conductive pattern 104 with the conductive adhesive pattern 313 or the region on which the electrode is to be formed in the conductive adhesive film layer 313.

6. The method for preparing a solar cell according to claim 1 or 2, wherein before the welding, the method further comprises:
forming a flux pattern on the second conductive pattern 104; and/or
forming a flux pattern on the first conductive part.

7. The method for preparing a solar cell according to claim 1 or 2, wherein before the welding or the eutectic bonding, the method further comprises:
forming a diffusion control pattern on the first conductive part; and/or forming a diffusion control pattern on the second conductive pattern 104, wherein
the diffusion control pattern is used for controlling a thickness of an alloy formed in the welding or the eutectic bonding of a material of the first conductive part and a material of the second conductive pattern 104.

8. The method for preparing a solar cell according to any one of claims 1 to 7, wherein before the forming a first conductive pattern 321 or a first conductive film layer 321 on a solar cell body, the method further comprises:
forming a bonding pattern 311 or a bonding film layer 311 on the solar cell body, wherein the bonding pattern 311 or the bonding film layer 311 is used for improving bonding force between the first conductive pattern 321 or the first conductive film layer 321 and the solar cell body;
the forming a first conductive pattern 321 or a first conductive film layer 321 on a solar cell body comprises:
forming the first conductive pattern 321 or the first conductive film layer 321 on the bonding pattern 311 or the bonding film layer 311; and
after the forming a bonding film layer 311 on the solar cell body and the removing the imprint template, the method further comprises: removing the bonding film layer 311 outside a region on which the electrode is to be formed, to form the bonding pattern 311.

9. The method for preparing a solar cell according to any one of claims 1 to 8, wherein the imprint template comprises a first groove 103; and the forming a second conductive pattern 104 on an imprint template comprises:
forming the second conductive pattern 104 in the first groove 103 of the imprint template, wherein
the second conductive pattern 104 is flush with a surface of a side of the imprint template provided with the first groove 103, or protrudes from the surface of the side of the imprint template provided with the first groove 103.

10. The method for preparing a solar cell according to claim 9, wherein the imprint template comprises a substrate 101, the first groove 103 is arranged on the substrate 101, and the imprint template further comprises a first boss 102 arranged on the substrate 101 and located at an edge of the first groove 103; and the forming the second conductive pattern 104 in the first groove 103 of the imprint template comprises:
forming the second conductive pattern 104 in the first groove 103 and in a region defined by the first boss 102, wherein
the second conductive pattern 104 is flush with a surface of the first boss 102 away from the substrate 101, or protrudes from the surface of the first boss 102 away from the substrate 101.

11. The method for preparing a solar cell according to claim 9, wherein in a direction from a notch of the first groove 103 to a groove bottom of the first groove 103, an area of a cross section of the first groove 103 gradually decreases, wherein the cross section is perpendicular to a lamination direction of the first conductive part and the second conductive pattern 104.

12. The method for preparing a solar cell according to any one of claims 1 to 8, wherein the imprint template comprises a substrate 101 and a second boss 202 arranged on the substrate 101; and
the forming a second conductive pattern 104 on an imprint template comprises:
forming a second conductive film layer 104 on a side of the imprint template on which the second boss 202 is formed, wherein the second conductive pattern 104 is a part of the second conductive film layer 104 located on the second boss 202.

13. The method for preparing a solar cell according to claim 12, wherein
a surface of the second boss 202 away from the substrate 101 is a plane; or
a side of the second boss 202 away from the substrate 101 comprises a second groove 2021, wherein the second conductive pattern 104 is flush with a notch of the second groove 2021, or protrudes from the second groove 2021.

14. The method for preparing a solar cell according to claim 1 or 2, wherein the bonding part comprises a conductive adhesive pattern 313; the imprint template comprises a third groove 105; the forming a second conductive pattern 104 on an imprint template comprises:
forming the second conductive pattern 104 in the third groove 105 of the imprint template, and forming the conductive adhesive pattern 313 on the second conductive pattern 104, wherein the conductive adhesive pattern 313 is flush with a surface of a side of the imprint template provided with the third groove 105, or protrudes from the surface of the side of the imprint template provided with the third groove 105; and
the aligning the second conductive pattern 104 with a first conductive part, and electrically connecting the second conductive pattern 104 to the first conductive part comprises:
aligning the conductive adhesive pattern 313 with the first conductive part, wherein the second conductive pattern 104 and the first conductive part are bonded together through the conductive adhesive pattern 313.

15. The method for preparing a solar cell according to any one of claims 1 to 8, wherein the forming a second conductive pattern 104 on an imprint template comprises:
forming a seed pattern 1047 on the imprint template; and
forming a plating pattern 1048 on the seed pattern 1047 through electroplating or chemical plating, wherein the plating pattern 1048 and the seed pattern 1047 together form the second conductive pattern 104.

16. The method for preparing a solar cell according to any one of claims 1 to 8, wherein the imprint template comprises a substrate 101, and the forming a second conductive pattern 104 on an imprint template comprises:
laying a metal foil on the substrate 101, and patterning the metal foil, to form the second conductive pattern 104.

17. The method for preparing a solar cell according to any one of claims 1 to 8, wherein before the forming a second conductive pattern 104 on an imprint template, the method further comprises:
providing a plurality of metal foil patterns;
the imprint template comprises a plurality of adsorption regions; and the forming a second conductive pattern 104 on an imprint template comprises: at least aligning one of the adsorption regions with one of the metal foil patterns, and adsorbing the metal foil pattern on the adsorption region, to form the second conductive pattern 104.

18. A solar cell, comprising:
a solar cell body; and
a first conductive pattern 321 and a second conductive pattern 104 sequentially laminated on the solar cell body, wherein the first conductive pattern 321 and the second conductive pattern 104 are electrically connected together through one of welding, eutectic bonding, a conductive adhesive pattern 313 located between the first conductive pattern 321 and the second conductive pattern 104, or a third conductive pattern 313 located between the first conductive pattern 321 and the second conductive pattern 104, wherein
a material of the conductive adhesive pattern 313 comprises a conductive material and an adhesive; and a grain size of the third conductive pattern 313 increases from a part close to the first conductive pattern 321 to a middle region, and increases from a part close to the second conductive pattern 104 to the middle region.

19. The solar cell according to claim 18, wherein the first conductive pattern 321 is closer to the solar cell body than the second conductive pattern 104 is; and
in a direction away from the solar cell body, an area of a cross section of the second conductive pattern 104 or a partial region of the second conductive pattern 104 away from the solar cell body gradually decreases, wherein the cross section is perpendicular to a lamination direction of the solar cell body and the first conductive pattern 321.

20. The solar cell according to claim 19, wherein a shape of a longitudinal section of the second conductive pattern 104 or a partial region of the second conductive pattern 104 away from the solar cell body is a triangle, a trapezoid, or a shape formed by an arc and a line segment connecting two endpoints of the arc, wherein a length of the line segment is less than or equal to a diameter of a circle corresponding to the arc; and the longitudinal section is parallel to a lamination direction of the solar cell body and the first conductive pattern 321.

21. The solar cell according to any one of claims 18 to 20, wherein the solar cell further comprises a bonding pattern 313 arranged between the first conductive pattern 321 and the solar cell body, wherein the bonding pattern 313 is used for improving bonding force between the first conductive pattern 321 and the solar cell body.

22. The solar cell according to any one of claims 18 to 20, wherein in the lamination direction of the solar cell body and the first conductive pattern 321, the second conductive pattern 104 comprises a seed layer pattern and a plating pattern 1048 that are laminated, wherein the plating pattern 1048 is closer to the solar cell body than the seed layer pattern is, and the plating pattern 1048 wraps the seed layer pattern.

23. The solar cell according to any one of claims 18 to 20, wherein the second conductive pattern 104 and the first conductive pattern 321 are eutectically bonded or welded together; and
the solar cell further comprises a diffusion control pattern arranged between the first conductive pattern 321 and the second conductive pattern 104, wherein the diffusion control pattern is used for controlling a thickness of an alloy formed in the welding or the eutectic bonding of the second conductive pattern 104 and the first conductive pattern 321.

24. The solar cell according to any one of claims 18 to 20, wherein the second conductive pattern 104 and the first conductive pattern 321 are welded together; and
the solar cell further comprises a flux pattern arranged between the first conductive pattern 321 and the second conductive pattern 104.

25. A method for preparing a solar cell, comprising:
forming a second conductive pattern 104 on an imprint template;
aligning the second conductive pattern 104 with a region on which an electrode is to be formed in a solar cell body, and electrically connecting the second conductive pattern 104 to the region on which the electrode is to be formed in the solar cell body, wherein the electrical connection between the second conductive pattern 104 and the region on which the electrode is to be formed in the solar cell body comprises any one of the following four manners: in a first manner, the second conductive pattern 104 is bonded to the region on which the electrode is to be formed in the solar cell body through a bonding part, wherein a material of the bonding part comprises a conductive material and an adhesive; in a second manner, the second conductive pattern 104 is welded to the region on which the electrode is to be formed in the solar cell body; in a third manner, a third conductive pattern 313 is formed between the second conductive pattern 104 and the region on which the electrode is to be formed in the solar cell body through electroplating or chemical plating, and the second conductive pattern 104 and the region on which the electrode is to be formed in the solar cell body are connected together through the third conductive pattern 313; or in a fourth manner, the second conductive pattern 104 is eutectically bonded to the region on which the electrode is to be formed in the solar cell body; and
removing the imprint template.

26. The method for preparing a solar cell according to claim 25, wherein before the aligning the second conductive pattern 104 with a region on which an electrode is to be formed in a solar cell body, and electrically connecting the second conductive pattern 104 to the region on which the electrode is to be formed in the solar cell body, the method further comprises:
annealing the imprint template on which the second conductive pattern 104 has been formed, to cause the second conductive pattern 104 to recrystallize.

27. The method for preparing a solar cell according to claim 25 or 26, wherein the bonding part comprises a conductive adhesive film layer 313 or a conductive adhesive pattern 313; after the second conductive pattern 104 is bonded to the region on which the electrode is to be formed in the solar cell body through the conductive adhesive film layer 313, and after the removing the imprint template, the method further comprises: removing the conductive adhesive film layer 313 outside a region on which the electrode is to be formed, to form the conductive adhesive pattern 313.

28. The method for preparing a solar cell according to claim 27, wherein before the bonding, the method further comprises:
forming the bonding part on the second conductive pattern 104; and the aligning the second conductive pattern 104 with a region on which an electrode is to be formed in a solar cell body comprises: aligning the region on which the electrode is to be formed in the solar cell body with the conductive adhesive pattern 313 or the region on which the electrode is to be formed in the conductive adhesive film layer 313; or
forming the bonding part on one of the region on which the electrode is to be formed in the solar cell body or the solar cell body; and the aligning the second conductive pattern 104 with a region on which an electrode is to be formed in a solar cell body comprises: aligning the second conductive pattern 104 with the conductive adhesive pattern 313 or the region on which the electrode is to be formed in the conductive adhesive film layer 313.

29. The method for preparing a solar cell according to claim 27 or 28, wherein a material of the conductive adhesive pattern 313 is an aluminum paste, and the conductive adhesive pattern 313 is in contact with a silicon substrate 305 of the solar cell body; and
that the second conductive pattern 104 is bonded to the region on which the electrode is to be formed in the solar cell body through a bonding part comprises that
the second conductive pattern 104 is bonded to a region on which the electrode is to be formed in the silicon substrate 305 of the solar cell body through the conductive adhesive pattern 313, and sintering is performed, wherein during the sintering, a part of the aluminum paste in the conductive adhesive pattern 313 diffuses into the region on which the electrode is to be formed in the silicon substrate 305, to dope the region on which the electrode is to be formed in the silicon substrate 305 to form a P-type doped region 3051.

30. The method for preparing a solar cell according to claim 25 or 26, wherein a material of the second conductive pattern 104 is aluminum, and the second conductive pattern 104 is in contact with a silicon substrate 305 of the solar cell body; and
the aligning the second conductive pattern 104 with a region on which an electrode is to be formed in a solar cell body, and electrically connecting the second conductive pattern 104 to the region on which the electrode is to be formed in the solar cell body, the method further comprises that
in a process of welding or eutectically bonding the second conductive pattern 104 to the region on which the electrode is to be formed in the solar cell body, a part of aluminum in the second conductive pattern 104 diffuses into a region on which the electrode is to be formed in the silicon substrate 305, to dope the region on which the electrode is to be formed in the silicon substrate 305 to form a P-type doped region 3051, and use a remaining part of the second conductive pattern 104 as the electrode.

31. The method for preparing a solar cell according to claim 25 or 26, wherein before the welding or the eutectic bonding, the method further comprises: forming a diffusion control pattern on the second conductive pattern 104; and/or forming a diffusion control pattern on the region on which the electrode is to be formed in the solar cell body, wherein the diffusion control pattern is used for controlling a thickness of an alloy formed in the welding or the eutectic bonding of the second conductive pattern 104 and the region on which the electrode is to be formed in the solar cell body.

32. The method for preparing a solar cell according to any one of claims 25 to 31, wherein the imprint template comprises a first groove 103; and the forming a second conductive pattern 104 on an imprint template comprises:
forming the second conductive pattern 104 in the first groove 103 of the imprint template, wherein
the second conductive pattern 104 is flush with a surface of a side of the imprint template provided with the first groove 103, or protrudes from the surface of the side of the imprint template provided with the first groove 103.

33. The method for preparing a solar cell according to claim 32, wherein the imprint template comprises a substrate 101, the first groove 103 is arranged on the substrate 101, and the imprint template further comprises a first boss 102 arranged on the substrate 101 and located at an edge of the first groove 103; and the forming the second conductive pattern 104 in the first groove 103 of the imprint template comprises:
forming the second conductive pattern 104 in the first groove 103 and in a region defined by the first boss 102, wherein
the second conductive pattern 104 is flush with a surface of the first boss 102 away from the substrate 101, or protrudes from the surface of the first boss 102 away from the substrate 101.

34. The method for preparing a solar cell according to claim 32, wherein in a direction from a notch of the first groove 103 to a groove bottom of the first groove 103, an area of a cross section of the first groove 103 gradually decreases, wherein the cross section is perpendicular to a lamination direction of the second conductive pattern 104 and the solar cell body.

35. The method for preparing a solar cell according to any one of claims 25 to 31, wherein the imprint template comprises a substrate 101 and a second boss 202 arranged on the substrate 101; and
the forming a second conductive pattern 104 on an imprint template comprises:
forming a second conductive film layer 104 on a side of the imprint template on which the second boss 202 is formed, wherein the second conductive pattern 104 is a part of the second conductive film layer 104 located on the second boss 202.

36. The method for preparing a solar cell according to claim 35, wherein a surface of the second boss 202 away from the substrate 101 is a plane; or a side of the second boss 202 away from the substrate 101 comprises a second groove 2021, wherein the second conductive pattern 104 is flush with a notch of the second groove 2021, or protrudes from the second groove 2021.

37. The method for preparing a solar cell according to any one of claims 25 to 31, wherein the bonding part comprises a conductive adhesive pattern 313; the imprint template comprises a third groove 105; the forming a second conductive pattern 104 on an imprint template comprises:
forming the second conductive pattern 104 in the third groove 105 of the imprint template, and forming the conductive adhesive pattern 313 on the second conductive pattern 104, wherein the conductive adhesive pattern 313 is flush with a surface of a side of the imprint template provided with the third groove 105, or protrudes from the surface of the side of the imprint template provided with the third groove 105; and
the aligning the second conductive pattern 104 with a region on which an electrode is to be formed in a solar cell body, and electrically connecting the second conductive pattern 104 to the region on which the electrode is to be formed in the solar cell body comprises:
aligning the conductive adhesive pattern 313 with the region on which the electrode is to be formed in the solar cell body, and bonding the second conductive pattern 104 to the region on which the electrode is to be formed in the solar cell body through the conductive adhesive pattern 313.

38. The method for preparing a solar cell according to any one of claims 25 to 31, wherein the forming a second conductive pattern 104 on an imprint template comprises:
forming a seed pattern 1047 on the imprint template; and
forming a plating pattern 1048 on the seed pattern 1047 through electroplating or chemical plating, wherein the plating pattern 1048 and the seed pattern 1047 together form the second conductive pattern 104.

39. The method for preparing a solar cell according to any one of claims 25 to 31, wherein the imprint template comprises a substrate 101, and the forming a second conductive pattern 104 on an imprint template comprises:
laying a metal foil on the substrate 101, and patterning the metal foil, to form the second conductive pattern 104.

40. The method for preparing a solar cell according to any one of claims 25 to 27, wherein before the forming a second conductive pattern 104 on an imprint template, the method further comprises:
providing a plurality of metal foil patterns;
the imprint template comprises a plurality of adsorption regions; and the forming a second conductive pattern 104 on an imprint template comprises: at least aligning one of the adsorption regions with one of the metal foil patterns, and adsorbing the metal foil pattern on the adsorption region, to form the second conductive pattern 104.

41. A solar cell, comprising:
a solar cell body; and
a second conductive pattern 104 arranged on the solar cell body, wherein the second conductive pattern 104 and the solar cell body are electrically connected together through one of welding, eutectic bonding, a conductive adhesive pattern 313 located between the second conductive pattern 104 and the solar cell body, or a third conductive pattern 313 located between the second conductive pattern 104 and the solar cell body, wherein
a material of the conductive adhesive pattern comprises a conductive material and an adhesive; and a grain size of the third conductive pattern 313 increases from a part close to the solar cell body to a middle region, and increases from a part close to the second conductive pattern 104 to the middle region.

42. The solar cell according to claim 41, wherein in a direction away from the solar cell body, an area of a cross section of the second conductive pattern 104 or a partial region of the second conductive pattern 104 away from the solar cell body gradually decreases, wherein the cross section is perpendicular to a lamination direction of the solar cell body and the second conductive pattern 104.

43. The solar cell according to claim 41, wherein a shape of a longitudinal section of the second conductive pattern 104 or a partial region of the second conductive pattern 104 away from the solar cell body is a triangle, a trapezoid, or a shape formed by an arc and a line segment connecting two endpoints of the arc, wherein a length of the line segment is less than or equal to a diameter of a circle corresponding to the arc; and the longitudinal section is parallel to a lamination direction of the solar cell body and the second conductive pattern 104.

44. The solar cell according to any one of claims 41 to 43, wherein the second conductive pattern 104 is welded or eutectically bonded to the solar cell body; and
the solar cell further comprises a diffusion control pattern arranged between the second conductive pattern 104 and the solar cell body, wherein the diffusion control pattern is used for controlling a thickness of an alloy formed in the welding or the eutectic bonding of the second conductive pattern 104 and the solar cell body.

45. The solar cell according to any one of claims 41 to 43, wherein in the lamination direction of the solar cell body and the second conductive pattern 104, the second conductive pattern 104 comprises a seed layer pattern and a plating pattern 1048 that are laminated, wherein the plating pattern 1048 is closer to the solar cell body than the seed layer pattern is, and the plating pattern wraps the seed layer pattern.

46. A solar cell module, comprising a first encapsulation adhesive film 2, a solar cell string 1, and a second encapsulation adhesive film 3 that are sequentially laminated, wherein the solar cell string 1 is formed by a plurality of solar cells sequentially connected in series; and
each of the solar cells is a solar cell according to any one of claims 18 to 24 and 41 to 45.
